# EUROPEAN PATENT SPECIFICATION

(11) **EP 1 970 572 B1**
(45) Date of publication and mention of the grant of the patent: **06.03.2013**
(21) Application number: 06843463.8
(22) Date of filing: 27.12.2006
(51) Int. Cl.: F15B 15/14, F16C 32/06, G12B 5/00, H01L 21/68

(54) **GAS PRESSURE CONTROL ACTUATOR**
GASDRUCKSTEUERSTELLGLIED
ACTIONNEUR DE REGULATION DE PRESSION DE GAZ

(30) Priority: 27.12.2005 JP 2005374358; 08.08.2006 JP 2006215216; 11.08.2006 JP 2006219999; 26.09.2006 JP 2006261300
(43) Date of publication of application: 17.09.2008
(73) Proprietor: Pneumatic Servo Controls Ltd., Nogoya-shi 463-0003 (JP)
(72) Inventor: SASAKI, Katsumi, Nagoya-shi Aichi 463-0003 (JP); HIRAYAMA, Tomoko, Kyoto 610-0101 (JP)
(74) Representative: Staudt, Hans-Peter
(86) International application number: PCT/JP2006/326081
(87) International publication number: WO 2007/077878

(56) References cited:
- WO-A2-99/43959
- JP-A- 01 051 241
- JP-A- 11 108 059
- JP-A- 51 064 145
- JP-A- 2005 351 312
- US-A- 3 122 045

## Description

### [TECHNICAL FIELD]

The present invention relates to a gas pressure control actuator More specifically, the invention relates to a gas pressure control actuator capable of minute movements.

### [BACKGROUND ART]

Actuators using fluid pressure are well known, as typified by piston and cylinder mechanisms. A fluid pressure control actuator, as shown in JP 57-51002 A, is capable of driving a mover by controlling fluid pressure by means of a fluid pressure servo mechanism. In particular, gas pressure control actuators using gas such as air are expected to serve as easy-to-handle positioning devices, by virtue of their being less likely to involve contamination problems as compared with those using oil pressure.

In recent years, positioning devices have been confronted with markedly increasing demands for improvement in their precision; i.e., resolution. For example, in exposure devices for semiconductor equipment, a minimum line width of semiconductor devices is less than 100 nm. Accordingly, the demand for dimensional accuracy of semiconductor devices is 10 nm or less, so that the positioning accuracy desired for positioning actuators therefor is 1 nm or less; i.e., on the subnanometer order. Further, these actuators are also demanded to exhibit high-speed response.

Provided that a gas pressure control actuator can be used in such positioning devices, as mentioned above, less contamination would be involved, and, moreover, occurrence of electromagnetic noise could be suppressed while temperature variation effects, vibrations, and buzz could be lessened. However, putting a gas pressure control actuator into such use as is would involve some problems in terms of performance, such as high-speed response and high accuracy.

First, gas pressure control actuators currently in common use do not exhibit good response. This is because the spring constant of the gas pressure control actuator decreases to smaller with increasing volume of the gas chamber as well as with increasing compressibility of the gas in use, whereas there are limitations in reducing the volume of the air chamber in the cylinder. Because of characteristics attributable to such gas properties, there is a need for applying advanced, complex control to achieve desired high accuracy and high-speed responses with gas pressure control actuators.

Secondly, even if high accuracy and high-speed response are achieved by advanced, complex control, their applied moving range generally has limitations. That is, even if high accuracy can be achieved within only a short operating range, it is difficult, in many cases, to achieve high accuracy and high-speed response over a wide operating range.

Thirdly, for driving movement of a mover such as a table by a fore end of the actuator, changes in their contact state would make it difficult to achieve control of minute movements. For example, with the use of an actuator having a flat-shaped fore end, driving the table into rotation would cause the table and the actuator fore end to come into skewed contact with each other, making it difficult to achieve control of minute angles. This problem is not limited only to gas pressure control actuators, but is an issue inherent to minute moving mechanisms in general. A method for solving this issue is, for example, to provide a spherical seat mechanism at a contact portion between the table and the actuator fore end. This method, however, involves a gas-pressure-driven spherical seat mechanism in the case of a gas pressure control actuator, thereby rendering the mechanism more complex.

Also, as the gas pressure control actuator involves giving a movement driving force to a moving object by the actuator fore end, a thrust bearing mechanism is used as a mechanism therefor. Generally known thrust bearing mechanisms include those in which a load in the thrust direction of the rotating shaft is supported by a rolling bearing mechanism, as well as those in which a support fluid such as oil is supplied to a clearance between the shaft and a shaft-supporting base so that the shaft is levitated from and supported against the base by static pressure or dynamic pressure of the support fluid. The latter are called fluid thrust bearing mechanisms, for which oil, magnetic fluid, gas, and the like are used as the fluid.

An example structure of a fluid thrust bearing mechanism is such that a columnar shaft, and a cylindrical support member including a bottom portion having an inner diameter corresponding to the external shape of the shaft are combined together, where a fluid is jetted out through a fluid supply port provided at a central portion of the bottom-face portion of the shaft facing the bottom portion of the support member so that the bottom-face portion of the shaft is levitated from the bottom portion of the support member. In this case, the bottom portion of the support member serves as a fluid-receiving wall, while the bottom-face portion of the shaft serves as a fluid-receiving surface. Both the fluid-receiving wall and the fluid-receiving surface may have flat surfaces.

As is also known, for such purposes as noise suppression in relation to the control of intervals of so-called bearing clearances, which are clearances between the fluid-receiving wall and the fluid-receiving surface, and improvement of control stability, radial slit type throttles or restrictors which restrict gas flow (hereinafter refer to as restrictor) are provided at the bearing clearances. The radial slit restrictors are implemented by providing a plurality of slits which extend radially from the fluid supply port located at the central portion of the shaft; i.e., toward the outer circumference along radial directions, and each slit restrictor is shallow in groove depth with a terminal end portion. The radial slit restrictors are intended, for example, to improve the controllability of clearance intervals of the bearing clearances by making use of a fluid-throttling effect that is produced when the fluid following through the shallow groove flows out into the bearing clearances between the fluid-receiving wall and the fluid-receiving surface.

As shown above, one practice is to make use of the thrust fluid bearing having radial slit restrictors at bearing clearances between the fluid-receiving wall and the fluid-receiving surface. The radial slit restrictor, which is used for such purposes as improvement of the controllability of clearance intervals of the bearing clearances as described above, may exhibit different characteristics depending on the fluid type. For example, in the case of high-accuracy control of clearance intervals of the bearing clearances, because inflow of the fluid into narrow clearances through the fluid supply port causes the fluid resistance to abruptly change to thereby cause occurrence of a vena contracta, use of gas, rather than oil, as the fluid tends to cause slight vibration of the clearance intervals, because of differences in fluid viscosity.

Thus, in conventional thrust gas bearing mechanisms having radial slit restrictors, there is a fear that the clearance intervals of the bearing clearances may vibrate, thereby imposing limitations in enhancement toward higher axial-positioning accuracies.

In this connection, as compared with other mechanisms, a moving mechanism using a gas pressure control actuator as described above tends to exhibit less contamination, no occurrence of electromagnetic noise, smaller effects of temperature variations, less vibrations, and less buzz. Therefore, such moving mechanisms are expected to find application not only to positioning actuators for semiconductor devices or the like but also to actuators for canceling out vibrations in vibration isolators or other applications. As a result, there has been proposed formation of a minute moving mechanism of good response using such a gas pressure control actuator.

JP 2005-268293 A discloses that, by virtue of a high spring constant of the gas bearing mechanism, clearances of the gas bearing are changed by controlling the gas pressure supplied to those clearances, the resulting changes in clearances being exploited for minute movement of the object to thereby implement a minute moving mechanism of good response. In this case, with provision of a guide portion for guiding a mover, to which proper pushing force is imparted, toward a moving direction, a gas having a controlled gas pressure is supplied through an opening provided in the gas-receiving wall, which is the bottom face of the guide portion, toward the gas-receiving surface of the mover, so that the mover is levitated from the gas-receiving wall to form a clearance while balancing with the pushing force. Then, the resulting clearance amount is controlled by the supply gas pressure, by which the mover is minutely moved. It is also described that with a plurality of movers disposed along the axial direction, controlled gas pressures are supplied to clearances between adjacent movers, respectively, thereby enlarging the range of minute movement in correspondence to the number of the clearances.

The constitution disclosed in JP 2005-268293 A can be developed in such a manner that, with a plurality of thin-in-plate-thickness movers disposed along the axial direction, controlled gas pressures are supplied to clearances between adjacent movers, respectively, thereby enabling formation of a gas-pressure minute moving mechanism which is small in overall size and wide in moving range for minute movement.

The minute moving mechanisms described above are designed so that the clearances are adjusted in such a way that gas-bearing like levitating force generated by the flow of controlled gas through the clearances is balanced with pushing force given from the outside, thus giving rise to a need for a pushing force generation mechanism. In general, load power such as dead weight of a target object, which is to be moved by the minute moving mechanism, can be used as the source of pushing force for the mechanism.

In incorporating the minute moving mechanism into an actual device, it is effective to use such load power of a target object as the pushing force source as shown above. However, when no load power of a target object is present, such as in the case of evaluation of characteristics of the minute moving mechanism, or when the load power of a target object is insufficient, absence of any pushing force generation mechanism is inconvenient. Accordingly, a structure that a pushing force generation mechanism is internally included allows a user to evaluate characteristics of the minute moving mechanism in itself. Also, the minute moving mechanism can be applied as is to an object targeted by the user to thereby carry out the evaluation, which is convenient.

### [DISCLOSURE OF THE INVENTION]

### [PROBLEMS TO BE SOLVED BY THE INVENTION]

An advantage of the present invention is to provide a gas pressure control actuator capable of improving high-speed response and achieving minute movement. Another advantage of the invention is to provide a gas pressure control actuator that allows minute movement to be implemented over wide operating ranges. A further advantage of the invention is to provide a gas pressure control actuator capable of achieving minute movement without requiring any spherical seat mechanism.

The following means contribute to at least one of these advantages of the invention.

### [MEANS FOR SOLVING THE PROBLEMS]

According to the present invention, there is provided a gas pressure control actuator comprising: a plurality of flat-plate movers which are placed in an array along an axial direction of a support shaft, each of the plurality of flat-plate movers being supported, with a flat-plate surface thereof vertical to the support shaft, by the support shaft via a support member which has an aperture that allows gas to flow therethrough and which is lower in displacement rigidity in the axial direction of the support shaft than in its radial direction; a cylindrical guide portion to a bottom face of which the support shaft is attached and which is opened on one side closer to a fore-end side of the support shaft, the guide portion serving for guiding the plurality of flat-plate movers; and gas supply means which is provided on a bottom face side of the guide portion and which supplies and guides gas to a clearance between a one-side flat-plate surface of a flat-plate mover confronting the bottom face of the guide portion and the bottom face of the guide portion, to clearances between adjacent flat-plate movers, and to a clearance between the other-side flat-plate surface of a fore-end side flat-plate mover confronting a drive object and a gas-receiving surface of the drive object confronting the flat-plate surface, wherein the fore-end side flat-plate mover exerts driving force on the drive object via a gas layer.

Preferably, in the gas pressure control actuator according to the invention, the support member is a thin-plate spring having cloud-like-curved-shaped flexible arms for connecting an inner-diameter side portion of the flat-plate mover and the support shaft to each other.

Preferably, in the gas pressure control actuator according to the invention, a support portion between the flat-plate mover and the support shaft is slidable in the axial direction.

Preferably, in the gas pressure control actuator according to the invention, the gas supply means has a gas supply port which is opened toward the flat-plate mover, and a gas restrictor portion which is provided at the gas supply port and which rectifies the flow of supplied gas.

Preferably, the gas pressure control actuator according to the invention further comprises spacers which are provided between adjacent flat-plate movers to restrict clearances against the adjacent flat-plate movers.

### [Effects of the Invention]

With at least one of the structures described above, in the gas pressure control actuator, the flat-plate mover is supported by the support shaft that is attached to the fore end of the piston-type mover guided by the guide portion and driven by gas pressure. Then, the flat-plate mover exerts driving force on a drive object via an air layer. In this case, the flat-plate mover is supported, with a flat-plate surface thereof vertical to the support shaft, by the support shaft via a support member which has an aperture that allows gas to flow therethrough and which is lower in displacement rigidity in the axial direction of the support shaft than in its radial direction. Thus, the flat-plate mover, having a characteristic of being large in degree of freedom in the thrust direction and largely restrained in the radial direction, follows inclinations of the drive object to change its inclination. That is, the flat-plate mover is enabled to transfer the driving force to the drive object while following inclinations of the drive object without requiring any spherical seat mechanism.

Also, the gas supply means supplies and guides gas to a clearance between a one-side flat-plate surface of the flat-plate mover and a fore-end surface of the piston-type mover, and to a clearance between the other-side flat-plate surface of the flat-plate mover and a gas-receiving surface of the drive object confronting the flat-plate surface. Since the gas flowing through these clearances exerts the so-called gas bearing action, clearance amounts can be controlled by the gas pressure of the supplied gas, so that minute movement can be realized.

Also, with at least one of the above-described structures, in the gas pressure control actuator, the flat-plate mover is supported by the support shaft attached to the bottom face of the cylindrical guide portion. Then, the gas is supplied and guided to a clearance between the bottom face of the guide portion and a one-side flat-plate surface of the flat-plate mover, and to a clearance between the other-side flat-plate surface of the flat-plate mover and a gas-receiving surface of a drive object confronting the flat-plate surface, wherein the flat-plate mover exerts driving force on a drive object via a gas layer. In this case, the flat-plate mover is supported, with a flat-plate surface thereof vertical to the support shaft, by the support shaft via a support member which has an aperture that allows gas to flow therethrough and which is lower in displacement rigidity in the axial direction of the support shaft than in its radial direction. Thus, the flat-plate mover, having a characteristic of being large in degree of freedom in the thrust direction and largely restrained in the radial direction, follows inclinations of the drive object to change its inclination. That is, the flat-plate mover is enabled to transfer the driving force to the drive object while following inclinations of the drive object without requiring any spherical seat mechanism.

Also, with at least one of the above-described structures, in the gas pressure control actuator, a plurality of flat-plate movers are supported by the support shaft that is attached to the fore end of the piston-type mover guided by the guide portion and driven by gas pressure. Then, as the gas is supplied to clearances between adjacent flat-plate movers or the like, the flat-plate movers exert driving force on a drive object via an air layer. In this case, the flat-plate movers are supported, with flat-plate surfaces thereof vertical to the support shaft, by the support shaft via a support member which has an aperture that allows gas to flow therethrough and which is lower in displacement rigidity in the axial direction of the support shaft than in its radial direction.

Also, with at least one of the above-described structures, in the gas pressure control actuator, a plurality of flat-plate movers are supported by the support shaft that is attached to the bottom face of the cylindrical guide portion. Then, as the gas is supplied to clearances between adjacent flat-plate movers or the like, the flat-plate movers exert driving force on a drive object via an air layer. In this case, the flat-plate movers are supported, with flat-plate surfaces thereof vertical to the support shaft, by the support shaft via a support member which has an aperture that allows gas to flow therethrough and which is lower in displacement rigidity in the axial direction of the support shaft than in its radial direction.

Since the gas flowing through the clearances between adjacent flat-plate movers or the like exert the so-called gas bearing action, clearance amounts can be controlled by the gas pressure of the supplied gas, so that minute movement can be realized. Then, increasing the number of clearances by placing the flat-plate movers in an array in plurality along the axial direction makes it possible to enlarge the range of high-accuracy minute movement in correspondence to the number of the clearances. Further, the flat-plate movers, having a characteristic of being large in degree of freedom in the thrust direction and largely restrained in the radial direction, follow inclinations of the drive object to change their inclinations. That is, the flat-plate movers are enabled to transfer the driving force to the drive object while following inclinations of the drive object without requiring any spherical seat mechanism.

Also, the flat-plate mover may be one which has an aperture that allows gas to flow therethrough and which is supported by the support shaft with the flat-plate surface of the flat-plate mover vertical to the support shaft. In this case, the flat plate having an aperture that allows gas to flow therethrough is supported by the support shaft without interposition of a support member which is lower in displacement rigidity in the axial direction of the support shaft than in its radial direction. Thus, the structure can be more simplified.

Also, the support member is a thin-plate spring having cloud-like-curved-shaped flexible arms for connecting an inner-diameter side portion of the flat-plate mover and the support shaft to each other. Therefore, a support member which has an aperture that allows gas to flow therethrough and which is lower in displacement rigidity in the axial direction of the support shaft than in its radial direction can be obtained with a simple structure.

Also, the support portion between a flat-plate mover and the support member is slidable in the axial direction. Therefore, when a plurality of flat-plate movers are moved in the axial direction to a large extent, the flat-plate movers themselves can be slidably moved in the axial direction independent of axial deformation of the support member. Thus, drive for wide-range movement can be achieved.

Also, the flat-plate mover has, in an inner-diameter side portion thereof, a restrictor portion which is thinner in plate thickness than in an outer-diameter side portion so as to form a surface restrictor clearance against a flat-plate surface of an adjacent flat-plate mover. Therefore, the flow of the gas flowing through the clearance between adjacent flat-plate movers can be stabilized. It is noted here that the term, surface restrictor clearance, refers to a clearance that produces a surface throttling effect that the flow is stabilized as the clearance between confronting surfaces is restricted from wider to narrower.

Also, the gas supply means has a gas restrictor portion which rectifies a flow of supplied gas. Therefore, noise due to the gas flow can be suppressed, so that the controllability of the gas pressure control actuator can be improved.

Also, spacers are provided between adjacent flat-plate movers. Therefore, the clearances between adjacent flat-plate movers can be accurately restricted.

Also, with at least one of the above-described structures, in the gas pressure control actuator, the thin-plate mover is supported by the support shaft that is attached to the fore end of the piston-type mover guided by the guide portion and driven by gas pressure. In this case, the thin-plate mover is supported, with a flat-plate surface thereof vertical to the support shaft, by the support shaft via a support member which is lower in displacement rigidity in the axial direction of the support shaft than in its radial direction. Thus, the thin-plate mover, having a characteristic of being large in degree of freedom in the thrust direction and largely restrained in the radial direction, follows inclinations of the drive object to change its inclination. That is, the thin-plate mover is enabled to transfer the driving force to the drive object while following inclinations of the drive object without requiring any spherical seat mechanism.

Also, the thin-plate mover has an aperture which is provided in an inner circumferential side so as to allow gas to flow therethrough, as well as a plurality of ended grooves which extend radially from the aperture toward an outer circumferential side to an arbitrary length. In this case, the ended grooves are those running through the thin plate in its plate thickness direction. The ended grooves are not merely opened, but are flow passages having proper flow resistance to gas while the gas flows therethrough. Then, the gas is supplied in such a symmetrical manner that clearances between the thin-plate mover and flat-plate movers confronting the thin-plate mover on both front and rear sides of the thin-plate mover become substantially equal to each other over a range from the aperture through each of the ended grooves, thereby guiding flows of the gas through the clearance between the thin-plate mover and the piston-type mover and the clearance between the thin-plate mover and a drive object, respectively. That is, the thin-plate mover is interposed before the drive object and after the piston-type mover, where the gas flows through a narrow clearance therebetween, so that driving force is given to the drive object via the gas. The driving force is in two modes, one being a gas pressure driving force by the so-called piston and cylinder mechanism derived from the piston mover and the other being a driving force by the gas which passes from the aperture of the thin-plate mover through the ended grooves and flows through a narrow clearance between the thin-plate mover and piston mover as well as through a narrow clearance between the thin-plate mover and the drive object. The gas flowing through the latter clearance has a function as a so-called gas bearing. As is well known, gas flowing through a narrow clearance between two walls causes gas bearing action to occur, such as an instance of fluid bearing. Whereas common fluid bearings are intended to produce a proper levitation clearance, the above structure differs therefrom in that the supplied gas pressure is controlled to control the clearance amount with high accuracy so that the drive object is mainly moved.

Furthermore, the structure differs from generally known fluid-bearing like structures as follows. That is, assuming that the front side of the thin-plate mover confronts the drive object, the structure is such that the gas is passed not through a clearance between the front-side surface of the thin-plate mover and the drive object, and not through a clearance between the rear-side surface of the thin-plate mover and the piston-type mover, but through the ended grooves running from top to bottom of the thin-plate mover. That is, while the gas flows so as to be led from the aperture to the ended grooves, the front side of each ended groove faces a wall of the drive object and its rear side faces a wall of the piston-type mover. Accordingly, the gas flows through within the ended grooves in the clearance between the wall of the drive object and the wall of the piston-type mover. Even with such a structure, the gas bearing action is realized on the principle described below.

In this structure, the gas flowing within the ended grooves also flows with a proper resistance to gas flow similarly against both the wall of the drive object and the wall of the piston-type mover. In more detail, given a virtual boundary at an intermediate position in the depthwise direction of each ended groove, gases flow on both the front side and the rear side respectively and symmetrically with the virtual boundary interposed therebetween. The wording "gas flows symmetrically" means that the gas flows in such a manner that clearances against confronting flat-plate movers become substantially equal to each other. On one side; i.e. the front side, of the virtual boundary, the gas flows through the clearance between the virtual boundary and the drive object; i.e., through a narrow clearance having a thickness corresponding to 1/2 of the plate thickness of the thin-plate mover. Similarly, on one side; i.e., the rear side, of the virtual boundary, the gas flows through the clearance between the virtual boundary and the piston-type mover; i.e., through a narrow clearance having a thickness corresponding to 1/2 of the plate thickness of the thin-plate mover. In other words, with the virtual boundary taken as a mirror image plane, two flows flow symmetrically. Since the virtual boundary does not change from a fluidic point of view, gas bearing actions are exerted on the clearance between the virtual boundary and the drive object as well as on the clearance between the virtual boundary and the piston-type mover, respectively.

As described above, the gas bearing action makes it possible to control the clearance amount by gas pressure of the supplied gas and to achieve minute movement. However, for better controllability of the clearance amount adjustment by the gas bearing action, ended shallow grooves are preferably provided from the inner circumferential to the outer circumferential side of the movers so as to allow the gas to flow therethrough, thereby exerting a throttling effect. A preferable depth of these shallow grooves is several micrometers to several tens of micrometers or so under the condition of gas pressure levels of 0.1 MPa to 1 MPa. Making these shallow grooves by manifacture processing involves quite high precision machining. In the above structure, the gas bearing action effected by the symmetrical flow of the gas on the front and rear is utilized on the virtual boundary principle, where not shallow grooves that require precision management of the depth but ended grooves that run from top to bottom of the thin plate; i.e. ended grooves that run through in the plate thickness direction, are used. These running-through grooves are not mere openings but pass-through grooves serving as flow passages having proper resistance to gas flow. Accordingly, these pass-through grooves are extremely easy to machine, as compared with shallow grooves requiring precision depth management.

In this way, by using the thin-plate mover having ended grooves that run through from top to bottom of the thin plate so as to have resistance to gas flow when the gas flows therethrough, the gas pressure of the gas flowing therethrough is controlled, so that the drive object can be minutely moved. Also, with combined use of driving force by the piston-type mover, precision movement of the drive object can be realized over a wider range of movement.

Also, with at least one of the above-described structures, in the gas pressure control actuator, the thin-plate mover is supported by the support shaft that is attached to the bottom face of the cylindrical guide portion. In this case, the thin-plate mover is supported, with a flat-plate surface thereof vertical to the support shaft, by the support shaft via a support member which is lower in displacement rigidity in the axial direction of the support shaft than in its radial direction. Therefore, the thin-plate mover follows inclinations of the drive object to change its inclination. That is, the thin-plate mover is enabled to transfer the driving force to the drive object while following inclinations of the drive object without requiring any spherical seat mechanism. Further, the thin-plate mover has an aperture which is provided in an inner circumferential side so as to allow gas to flow therethrough, as well as a plurality of ended grooves which extend radially from the aperture toward an outer circumferential side to an arbitrary length. In this case, the ended grooves run through from top to bottom of the thin plate so as to have resistance to gas flow when the gas flows therethrough. Then, the gas is supplied in such a symmetrical manner that clearances between the thin-plate mover and flat-plate movers confronting the thin-plate mover on both front and rear sides of the thin-plate mover become substantially equal to each other over a range from the aperture through each of the ended grooves, thereby guiding flows of the gas through the clearance between the thin-plate mover and the bottom portion of the guide portion and the clearance between the thin-plate mover and a drive object, respectively. Accordingly, the drive object can be minutely moved by controlling the supply gas pressure with the exploitation of the gas bearing action effected by the symmetrical flow of the gas on the front and rear while the virtual boundary placed at a depthwise intermediate position of the ended grooves is interposed therebetween.

Also, with at least one of the above-described structures, in the gas pressure control actuator, a flat-plate mover is provided on at least one of a front face side and a rear face side of the thin-plate mover. The flat-plate mover is supported, with a flat-plate surface thereof vertical to the support shaft, by the support shaft via a support member which is lower in displacement rigidity in the axial direction of the support shaft than in its radial direction, the flat-plate mover having an aperture that is provided on the inner circumferential side and that allows gas to flow therethrough. Use of this structure makes it possible to place a plurality of the thin-plate movers in the axial direction of the support shaft so that the adjustment width of minute clearances can be enlarged in correspondence to the number of the thin-plate movers. That is, the clearance adjustment is achieved by using the ended grooves in the thin-plate mover involves wall surfaces; i.e. gas-receiving surfaces, for formation of clearances on both front and rear side of the thin-plate mover. According to this structure, a flat-plate mover is provided on a necessary side of the thin-plate mover. In the flat-plate mover having a flat-plate surface, combining this flat-plate surface and the thin-plate mover allows the placement of gas-receiving surfaces for formation of clearances on both front and rear sides of the thin-plate mover. As a result, minute clearance amounts that can be controlled by gas pressure can be set for each of the thin-plate movers, so that the overall movement amount can be increased in correspondence to the number of thin-plate movers placed in array on the support shaft.

With at least one of the above-described structures, in the gas pressure control actuator, flat-plate movers, when used in combination with the piston-type mover, are placed along the axial direction of the support shaft so as to be alternated with the thin-plate movers. Then, the gas is supplied so that clearances between each of the thin-plate movers and flat-plate movers confronting the thin-plate mover on both front and rear sides of the thin-plate mover become substantially equal to each other over a range from the apertures of the thin-plate movers and the flat-plate movers through the ended grooves of the thin-plate movers, thereby guiding flows of the gas through the clearance between one thin-plate mover or flat-plate mover and the piston mover and the clearance between one flat-plate mover or thin-plate mover and a drive object, respectively. Also, with at least one of the above-described structures, in the gas pressure control actuator, when a cylindrical guide portion to a bottom face of which the support shaft is attached and which is opened on one side closer to a fore-end side of the support shaft is used, flat-plate movers are placed along the axial direction of the support shaft so as to be alternated with the thin-plate movers. Then, the gas is supplied so that clearances between each of the thin-plate movers and flat-plate movers confronting the thin-plate mover on both front and rear sides of the thin-plate mover become substantially equal to each other over a range from the apertures of the thin-plate movers and the flat-plate movers through the ended grooves of the thin-plate movers, thereby guiding flows of the gas through the clearance between one thin-plate mover or flat-plate mover and the bottom face of the guide portion, through clearances between adjacent thin-plate movers and flat-plate movers, and through the clearance between one flat-plate mover or thin-plate mover, and a drive object, respectively.

As a result, the number of clearances can be increased, so that the range of high-accuracy minute movement can be enlarged in correspondence to the number of the clearances. Also, the flat-plate movers, having a characteristic of being large in degree of freedom in the thrust direction and largely restrained in the radial direction, follow inclinations of the drive object to change their inclinations. That is, the flat-plate movers are enabled to transfer the driving force to the drive object while following inclinations of the drive object without requiring any spherical seat mechanism.

Also, the support member provided on the thin-plate mover is a thin-plate spring having a plurality of flexible arms for connecting an inner-diameter side portion of the thin-plate mover and the support shaft to each other. Also, the support member provided on the flat-plate mover is a thin-plate spring having a plurality of flexible arms for connecting an inner-diameter side portion of the flat-plate mover and the support shaft to each other. Therefore, a support member which has an aperture that allows gas to flow therethrough and which is lower in displacement rigidity in the axial direction of the support shaft than in its radial direction can be obtained with a simple structure.

Also, the support member is slidable along the support shaft. Therefore, when the thin-plate mover or the flat-plate is moved in the axial direction to a large extent, the thin-plate mover itself or the flat-plate mover itself can be slidably moved in the axial direction independent of axial deformation of the support member. Thus, drive for wide-range movement can be achieved.

Also, the flat-plate mover has, in an outer-diameter side portion of the aperture, a stepped gas-introducing portion having a plate thickness thinner than an outer circumferential portion, or a tapered gas-introducing portion whose plate thickness increases from an inlet portion leading from the aperture toward the outer circumferential portion. Since the gas-introducing portion having such a configuration forms a surface-throttling clearance, the flow of the gas flowing through clearances between adjacent thin-plate movers can be stabilized. It is noted here that the term, surface restrictor clearance, refers to a clearance that produces a so-called surface throttling effect that the flow is stabilized as the clearance between confronting surfaces is restricted from wider to narrower.

Also, the gas supply means has a gas supply port which is opened toward the aperture, and a gas restrictor portion which rectifies a flow of supplied gas. Therefore, noise due to the gas flow can be suppressed, so that the controllability of the gas pressure control actuator can be improved.

Also, spacers are provided between adjacent thin-plate movers and flat-plate movers. Therefore, standard clearances between the adjacent thin-plate movers and flat-plate movers can be accurately restricted.

As described above, with the gas pressure control actuator according to the present invention, its high responsivity can be improved, and minute movement is enabled. Also, minute movement over a wide working range is enabled. Furthermore, movement can be realized without requiring any complicated machining of a spherical seat mechanism or the like.

With at least one of the above-described structures, the gas bearing mechanism for gas pressure control actuators has a gas supply port provided in the gas-receiving wall or the gas-receiving surface, a decelerating depression provided in the gas-receiving wall or the gas-receiving surface to surround the gas supply port, and gas-passage shallow grooves, each of which extends beyond the decelerating depression toward an outer circumference of the bearing clearance and each of which has a terminal end portion. While a so-called radial slit restrictor is formed by the gas flowing out from the gas-passage shallow grooves, the gas flowing out from the gas supply port flows into the decelerating depression that spreads around the gas supply port before entering into the gas-passage shallow grooves. That is, the gas does not flow immediately through the gas supply port into the narrow gas-passage shallow grooves, but once spreads over the decelerating depression and thereafter flows into the gas-passage shallow grooves. Therefore, the degree of vena contracta can be relaxed by this deceleration, so that vibrations upon the flow into the gas-passage shallow grooves can be suppressed.

In addition, both the gas supply port and the decelerating depression may be provided on the gas-receiving wall, or one may be provided on the gas-receiving wall and the other on the gas-receiving surface. The gas-passage shallow grooves are provided on the side on which the decelerating depression is provided.

Also, a decelerating depression is provided so as to have a diameter larger than the circular-opening gas supply port and concentric therewith, and a plurality of gas-passage shallow grooves are provided so as to extend radially toward the outer circumference around the gas supply port, a terminal end portion of each gas-passage shallow groove being shaped so as to be broadened circumferentially over the width of the shallow grooves. Therefore, the decelerating depression can be easily obtained by depression working with a diameter concentric with the gas supply port and larger than the gas supply port.

Also, the decelerating depression and the gas-passage shallow grooves are set equal in depth to each other. Therefore, the decelerating depression and the gas-passage shallow grooves can be obtained by similar manufacture processing.

Also, the decelerating depression is set shallower than the depth of the gas-passage shallow grooves. In this case, the gas flowing out from the gas supply port enters the gas-passage shallow grooves, passes through the decelerating depression, and flows out to the bearing clearance. That is, the gas does not flow out immediately from the gas-passage shallow grooves into the narrow bearing clearance, but once spreads over the decelerating depression and thereafter flows into the bearing clearance. Therefore, the degree of vena contracta can be relaxed by this deceleration, so that vibrations upon the flow into the gas-passage shallow grooves can be suppressed.

Also, the decelerating depression is in the form of a tapered depression which is shallower in depth around the gas supply port than the gas-passage shallow grooves and becomes increasingly shallower toward the outer circumference. The tapered depression allows the gas to flow more smoothly than the stepped depression.

Also, in addition to the decelerating depression, there is further included a tapered depression which is provided in the gas-receiving wall or the gas-receiving surface to surround the gas supply port and which has an outer diameter shorter than a radial length of the gas-passage shallow grooves and becomes increasingly shallower from the gas supply port side toward the outer circumferential side. As a result, the degree of vena contracta can be further relaxed, so that vibrations upon the flow into the bearing clearance can be suppressed.

As described above, with the gas bearing mechanism for gas pressure control actuators variations of clearance amounts among the bearing clearances can be suppressed.

With at least one of the above-described structures, the minute displacement output device using the gas pressure control actuator, which uses a plurality of flat-plate movers which are placed in an array along an axial direction of a support shaft, includes an output mover confronting a most fore-end side mover, a cylindrical casing portion to a bottom face of which the support shaft is attached, a cover portion which has an elastic member being integrable with the casing portion to give a pushing force to the output mover and which further has a transfer portion for transferring an output of the output mover to the outside, and gas supply means for guiding gas to clearances before and after each flat-plate mover and the like. Then, with a controlled gas pressure supplied from the gas supply means, the individual clearance amounts are adjusted while being balanced with the pushing force, so that a minute displacement is outputted from the transfer portion. Thus, the minute displacement output device is enabled to fulfill its characteristic evaluation by the device itself alone.

Also, with at least one of the above-described structures, the minute displacement output device using the gas pressure control actuator, which uses a plurality of thin-plate movers and flat-plate movers placed in an array along the axial direction of the support shaft so as to be thereby supported, includes an output mover confronting a most fore-end side mover, a cylindrical casing portion to a bottom face of which the support shaft is attached, a cover portion which has an elastic member being integrable with the casing portion to give a pushing force to the output mover and which further has a transfer portion for transferring an output of the output mover to the outside, and gas supply means for guiding gas to clearances before and after each thin-plate mover and the like.

In this case, each of the thin-plate movers has an aperture that allows gas to flow therethrough, as well as a plurality of ended grooves which extend radially from the aperture and which run through from top to bottom of the thin plate so as to have resistance to gas flow while the gas flows therethrough, and therefore are easy to machine. Then, with a controlled gas pressure supplied from the gas supply means, the individual clearance amounts are adjusted while being balanced with the pushing force, so that a minute displacement is output from the transfer portion. Thus, the minute displacement output device is enabled to fulfill its characteristic evaluation by the device itself alone.

Also, the aperture that allows gas to flow therethrough serves to supply the gas derived from the gas supply means toward the outer diameter side of the support shaft and to the individual clearances. As a result, by adjusting the controlled gas pressure from the gas supply means, the clearance amounts for the individual clearances can be adjusted over a range from the aperture toward the outer diameter side of the support shaft.

Also, in a case where a plurality of flat-plate movers are used, the aperture that allows gas to flow therethrough serves to supply the gas derived from the gas supply means toward inner-diameter and outer-diameter sides of the support shaft so that the individual clearances are supplied with the gas. As a result, by adjusting the controlled gas pressure from the gas supply means, the clearance amounts for the individual clearances can be adjusted over a range from the aperture toward the outer-diameter and inner-diameter sides.

Also, the elastic member is lower in displacement rigidity in the axial direction of the transfer portion than in its radial direction. Therefore, while the pushing force is given efficiently in the moving axis direction, displacements can be transferred efficiently in the axial direction. Also, in a case where a membrane-like elastic member is included so as to be integrated with the casing portion to form an air tightness structure, the gas can be kept from being exhausted from the vicinity of the elastic member. Thus, the evaluation of the minute displacement output device itself can be realized more conveniently.

Also, in a case where the cover portion has an elastic member to be integrated with the casing portion to form an air tightness structure, an exhaust-port exhaust valve for gas exhaust to the outside is provided so that the exhaust gas pressure of the exhaust gas is set to an arbitrary exhaust gas pressure that gives an initial displacement to the elastic member of the cover portion by a differential pressure between the exhaust gas pressure and an outside gas pressure. As a result of this, an initial displacement is preliminarily given to the transfer portion that receives any external load in the cover portion, so that the output mover can be prevented from being burdened with abrupt application of an external load.

As described above, the minute displacement output device using the gas pressure control actuator can fulfill characteristic evaluation by the device itself alone.

With at least one of the above-described structures, the gas pressure control actuator includes a cylindrical guide portion which is at least partially formed of magnetic material, an output mover which is at least partially formed of magnetic material, a plurality of flat-plate intermediate movers which are placed between the output mover and the bottom face of the guide portion, each of the plurality of flat-plate intermediate movers having an aperture that allows gas to flow therethrough and being formed of magnetic material, gas supply means for supplying and guiding gas to clearances between adjacent intermediate movers and the like, a pushing force generation section for pushing the intermediate movers and the output mover while compressing the gas toward the bottom face of the guide portion, and a magnetic-field generation coil which is provided in the guide portion and which generates a magnetic field flowing through a magnetic circuit made up of the guide portion, the output mover, and the plurality of intermediate movers so that the intermediate movers are arrayed along a center axis of the guide portion by restricting force of the magnetic field.

In this case, as a proper excitation current is supplied to the magnetic-field generation coil to generate a magnetic field so that a controlled gas pressure is supplied, the intermediate movers and the output mover are pushed against the bottom face by the pushing force while the gas is compressed at the individual clearances such as between adjacent intermediate movers. Then, controlling the level of the supply gas pressure allows the amounts of the individual clearances to be adjusted while being balanced with the pushing force, by which the output mover can be minutely moved. During this process, the intermediate movers remain levitated in a so-to-speak contactless state with any other member by virtue of the gas flowing through the individual clearances. Accordingly, whereas the intermediate movers, as they are, might slide in the radial direction so as to be shifted in position, the intermediate movers are automatically aligned to their center axis by the restricting force of the magnetic field generated by the magnetic-field generation coil. Thus, a plurality of intermediate movers can be arrayed and supported in a fluidic manner without using the support shaft.

Also, each of the intermediate movers is a radial-groove-added intermediate mover in which a plurality of ended grooves extending radially from the aperture toward the outer circumferential side are included in a flat-plate surface of the intermediate mover. Therefore, the throttling effect of the radial grooves allows a smooth gas flow to be obtained. Also, each of the intermediate movers is a slit-added intermediate mover including a plurality of ended grooves which extend radially from the aperture toward the outer circumferential side and which run from top to bottom of a flat plate so as to have resistance to gas flow while the gas flows therethrough. Therefore, the intermediate movers are easy to manufacture. Further, the slit-added intermediate movers are so placed as to be alternated with the flat-plate movers each having a flat-plate surface having evenness and no grooves. Therefore, by cooperation between the slit grooves and the flat-plate surface, a throttling effect is produced, allowing a smooth gas flow to be obtained.

Also, each of the intermediate movers has, on its outer periphery, a detent shape for suppressing axial rotation, and the guide portion has an inner wall shape corresponding to the detent shape of the intermediate movers. Therefore, by cooperation between the detent shape of each intermediate mover and the inner wall shape of its corresponding guide portion, axial rotations of the individual intermediate movers can be suppressed. Thus, a plurality of intermediate movers can be arrayed and supported in a fluidic manner without using the support shaft.

Also, an excitation circuit for exciting the magnetic-field generation coil is included so that the excitation current can be varied to adjust amounts of the individual clearances to which the gas is supplied. Thus, independent of changes in supply gas pressure, the clearance amounts can be adjusted also by electrical means.

Also, with at least one of the above-described structures, the minute displacement output device using the gas pressure control actuator includes a cylindrical casing portion which is at least partially formed of magnetic material, an output mover which is at least partially formed of magnetic material, a plurality of flat-plate intermediate movers which are placed between the output mover and the bottom face of the guide portion, each of the plurality of flat-plate intermediate movers having an aperture that allows gas to flow therethrough and being formed of magnetic material, gas supply means for supplying and guiding gas to clearances between adjacent intermediate movers and the like, a cover portion which covers the forward opening of the casing portion and which has a transfer portion for transferring an output of the output mover to the outside, and an elastic material for connecting a cylindrical outer peripheral portion of the casing portion and the transfer portion to each other, the cover portion being integrable with the casing portion to give a pushing force to the output mover, and a magnetic-field generation coil which is provided in the casing portion and which generates a magnetic field flowing through a magnetic circuit made up of the casing portion, the output mover, and the plurality of intermediate movers so that the intermediate movers are arrayed along a center axis of the casing portion by restricting force of the magnetic field. In this case, as a proper excitation circuit is supplied to the magnetic-field generation coil to generate a magnetic field so that a controlled gas pressure is supplied, the intermediate movers and the output mover are pushed against the bottom face by the pushing force while the gas is compressed at the individual clearances such as between adjacent intermediate movers. Then, controlling the level of the supply gas pressure allows the amounts of the individual clearances to be adjusted while being balanced with the pushing force, by which the output mover can be minutely moved. During this process, the intermediate movers remain levitated in a so-called contactless state with any other member by virtue of the gas flowing through the individual clearances. Accordingly, whereas the intermediate movers, as they are, might slide in the radial direction so as to be shifted in position, the intermediate movers are automatically aligned to their center axis by the restricting force of the magnetic field generated by the magnetic-field generation coil. Thus, a plurality of intermediate movers can be arrayed and supported in a fluidic manner without using the support shaft.

### [BRIEF DESCRIPTION OF THE DRAWINGS]

Fig. 1 is a view showing a structure of a gas pressure control actuator including a piston-type mover in an embodiment;
Fig. 2 is a perspective view of an annular flat-plate mover in a gas pressure control actuator of an embodiment;
Fig. 3 includes a front view and a side view of an annular flat-plate mover in a gas pressure control actuator of an embodiment;
Fig. 4 is an enlarged sectional view of an inner-diameter side portion of the annular flat plate in a gas pressure control actuator of an embodiment;
Fig. 5 is a view for explaining action of the gas pressure control actuator of the structure of Fig. 1;
Fig. 6 is a view showing a structure of a gas pressure control actuator using an annular flat-plate mover only as the mover in an embodiment;
Fig. 7 is a view showing a preferred example of the restrictor portion in an embodiment;
Fig. 8 is a view showing another preferred example of the restrictor portion;
Fig. 9 is a view showing a structure of a gas pressure control actuator including a piston-type mover, with a plurality of annular flat-plate movers disposed therein, in an embodiment;
Fig. 10 is a view showing a structure of a gas pressure control actuator in which a plurality of annular flat-plate movers are placed on a support shaft attached to a bottom face of a guide portion in an embodiment according to the invention;
Fig. 11 is a view showing a gas pressure control actuator in which a plurality of annular flat-plate movers are provided, with an output mover also provided, in an embodiment;
Fig. 12 is a view for explaining a connection method between curved springs and annular flat-plate movers as well as a connection method between curved springs having cloud like shapes and the support shaft in a gas pressure control actuator in an embodiment;
Fig. 13 is a view showing a structure in which spacers are provided between a plurality of annular flat-plate movers in a gas pressure control actuator of an embodiment;
Fig. 14 is a view showing a structure in which the annular flat-plate movers are simple flat plates in a gas pressure control actuator of an embodiment;
Fig. 15 is a view showing a structure in which curved springs having cloud like shapes are omitted in a gas pressure control actuator of an embodiment;
Fig. 16 is a sectional view of an annular flat plate of Fig. 15;
Fig. 17 is a plan view of an XYθ moving mechanism to which a gas pressure control actuator of an embodiment is applied;
Fig. 18 is a view showing a six-degree-of-freedom parallel link mechanism to which a gas pressure control actuator of an embodiment is applied;
Fig. 19 is a view showing a structure of the gas pressure control actuator of Fig. 18, as well as its vicinity;
Fig. 20 is a view showing a structure of another gas pressure control actuator with the six-degree-of-freedom parallel link mechanism of Fig. 18, as well as its vicinity;
Fig. 21 is a view showing a structure of a gas pressure control actuator including a piston-type mover in an embodiment;
Fig. 22 is a perspective view of an annular thin-plate mover in a gas pressure control actuator of an embodiment;
Fig. 23 includes a front view and a side view of an annular thin-plate mover in a gas pressure control actuator of an embodiment;
Fig. 24 is a sectional view for explaining a flow of gas associated with an annular thin-plate mover in a gas pressure control actuator of an embodiment ;
Fig. 25 is a view for explaining action of the gas pressure control actuator of the structure of Fig. 21;
Fig. 26 is a view showing a structure of another gas pressure control actuator using an annular thin-plate mover only as the mover in an embodiment;
Fig. 27 is a view showing a preferred example as the restrictor portion in an embodiment;
Fig. 28 is a view showing another preferred example of the restrictor portion;
Fig. 29 is a view showing a structure of a gas pressure control actuator including a piston-type mover, with a plurality of annular thin-plate movers and a plurality of annular flat-plate movers disposed therein, in an embodiment;
Fig. 30 is a view showing a structure of a gas pressure control actuator in which a plurality of annular thin-plate movers and a plurality of annular flat-plate movers are placed on a support shaft attached to a bottom face of a guide portion in an embodiment;
Fig. 31 is a view showing a gas pressure control actuator in which a plurality of annular thin-plate movers and a plurality of annular flat-plate movers are disposed, with an output mover also provided, in an embodiment;
Fig. 32 includes a front view and a side view of an annular flat-plate mover in a gas pressure control actuator of an embodiment;
Fig. 33 is a view for explaining a connection method between a flexible arm and a support shaft in a gas pressure control actuator of an embodiment;
Fig. 34 is a view showing a structure in which a spacer is provided between an annular thin-plate mover and an annular flat-plate mover in a gas pressure control actuator of an embodiment;
Fig. 35 is a plan view of an XYθ moving mechanism to which a gas pressure control actuator of an embodiment is applied;
Fig. 36 is a view showing a six-degree-of-freedom parallel link mechanism to which a gas pressure control actuator of an embodiment is applied;
Fig. 37 is a view showing a structure of the gas pressure control actuator of Fig. 36, as well as its vicinity;
Fig. 38 is a view showing a structure of another gas pressure control actuator in the six-degree-of-freedom parallel link mechanism of Fig. 36, as well as its vicinity;
Fig. 39 is a view for explaining a structure of a gas bearing mechanism for the gas pressure control actuator in an embodiment;
Fig. 40 is an enlarged view of a portion in the vicinity of a gas-passage shallow groove in a gas bearing mechanism for the gas pressure control actuator in an embodiment;
Fig. 41 is a view for explaining a structure of a gas bearing mechanism for the gas pressure control actuator in Embodiment 2;
Fig. 42 is a partially enlarged view of Fig. 41;
Fig. 43 is a view for explaining a structure of an intermediate bearing member in a gas bearing mechanism for the gas pressure control actuator in Embodiment 4;
Fig. 44 is a view for explaining a structure of an intermediate bearing member in a gas bearing mechanism for the gas pressure control actuator in Embodiment 5;
Fig. 45 is a view for explaining an example of combination of a stepped decelerating depression and a tapered decelerating depression in a gas bearing mechanism for the gas pressure control actuator in Embodiment 5;
Fig. 46 is a view showing a minute displacement output device using the gas pressure control actuator, in which a plurality of flat-plate movers are employed, in an embodiment ;
Fig. 47 is an enlarged sectional view of the minute displacement output device using the gas pressure control actuator in Fig. 46;
Fig. 48 is a perspective view of a flat-plate mover in a minute displacement output device using the gas pressure control actuator of an embodiment ;
Fig. 49 includes a front view and a side view of a flat-plate mover in a minute displacement output device using a gas pressure control actuator of an embodiment ;
Fig. 50 is an enlarged view of an inner-diameter side portion of an annular flat plate in a minute displacement output device using a gas pressure control actuator of an embodiment ;
Fig. 51 includes a front view and a side view of a flat-plate mover in a minute displacement output device using the gas pressure control actuator of Embodiment 6;
Fig. 52 is an enlarged view of an inner-diameter side portion of a flat-plate mover in a minute displacement output device using the gas pressure control actuator of Embodiment 6;
Fig. 53 is a front view of a flat-plate mover of another structure in a minute displacement output device using the gas pressure control actuator of Embodiment 6;
Fig. 54 is a front view of a flat-plate mover of yet another structure in a minute displacement output device using the gas pressure control actuator of Embodiment 6;
Fig. 55 is an enlarged sectional view of a minute displacement output device using a gas pressure control actuator in which thin-plate movers and flat-plate movers are alternately placed in Embodiment 7;
Fig. 56 is a perspective view of a thin-plate mover in a minute displacement output device using the gas pressure control actuator of Embodiment 7;
Fig. 57 includes a front view and a side view of a thin-plate mover in a minute displacement output device using the gas pressure control actuator of Embodiment 7;
Fig. 58 includes a plan view and a side view of a flat-plate mover in a minute displacement output device using the gas pressure control actuator of Embodiment 7;
Fig. 59 is a view for explaining a flow of gas associated with a thin-plate mover in a minute displacement output device using the gas pressure control actuator of Embodiment 7;
Fig. 60 is a view showing a state of a minute displacement output device with an exhaust valve provided at an exhaust port, the minute displacement output device using the gas pressure control actuator of Embodiment 8;
Fig. 61 is a view showing a cover portion in a minute displacement output device using the gas pressure control actuator of Embodiment 9;
Fig. 62 is a view showing a structure of a gas pressure control actuator using a magnetic-field generation coil in an embodiment;
Fig. 63 is a view showing an example of the intermediate mover of Fig. 62;
Fig. 64 is a view showing another example of the intermediate mover of Fig. 62;
Fig. 65 is a view showing yet another example of the intermediate mover of Fig. 62;
Fig. 66 is a view showing a structure of a gas pressure control actuator using a magnetic-field generation coil in another embodiment;
Fig. 67 is a view showing a structure of a gas pressure control actuator using a magnetic-field generation coil in yet another embodiment;
Fig. 68 is a view showing another example of placement of a magnetic-field generation coil in a gas pressure control actuator of an embodiment;
Fig. 69 is a view showing a structure of a minute displacement output device using a gas pressure control actuator with a magnetic-field generation coil included therein in an embodiment;
Fig. 70 is a view showing another example of placement of a magnetic-field generation coil in a minute displacement output device using a gas pressure control actuator of an embodiment; and
Fig. 71 is a view showing a structure of a minute displacement output device using a gas pressure control actuator with a magnetic-field generation coil included therein in yet another embodiment.

### [BEST MODE FOR CARRYING OUT THE INVENTION]

### 1. Gas pressure control actuator using flat-plate mover

Embodiments according to the present invention will be described in detail below with reference to the accompanying drawings. First described is a basic case which uses a flat-plate mover, which is one of the cores of embodiments, and thereafter other structures will be described. Described below as the flat-plate mover is an annular flat-plate mover using an annular flat plate which has a circular external shape and in which a hole fitting to a support shaft is provided. However, the flat-plate mover has only to be a flat plate thinner in plate thickness in comparison to its planar size, and may be other than circular-shaped in its external shape. For example, the flat-plate mover may also be a flat plate having a polygonal external shape, an elliptical external shape, or a curved-surface external shape. Although the support structure between the flat-plate mover and the support shaft is explained below as a relation between a circular hole and a round bar, another support structure may be employed. It is possible, for example, that while the support shaft is a round bar, the external shape of the support shaft is formed into a polygonal shape and the support hole for the flat-plate mover is formed into a polygonal hole corresponding thereto as the support structure. Doing so facilitates suppressing the rotation about the support shaft. Of course, the axial cross-sectional shape of the support shaft may be formed into a shape other than polygonal shapes; e.g., an elliptical shape. Also, materials, dimensions, and the like described below are provided as examples for the sake of explanation, and any materials, dimensions, and the like complying with specifications of the gas pressure control actuator may be selected as required.

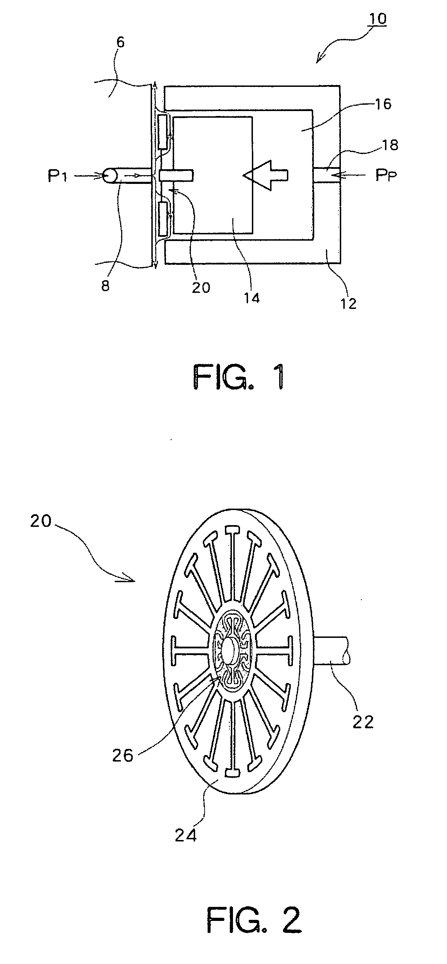

A gas pressure control actuator 10 shown in Fig. 1 uses a piston-type mover 14 which is guided by a guide portion 12 for drive of a moving object 6 into movement, and which is to be driven upon reception of a drive gas pressure P_{P} supplied from an unillustrated gas pressure control unit, with an annular flat-plate mover 20 provided at a fore end of the piston-type mover 14, so that driving force of the piston-type mover 14 is transferred to the moving object 6 via the annular flat-plate mover 20. The moving object 6, in this case, is a table or the like capable of making axial movements in XY directions or the like as well as rotations such as θ-rotation about the Z axis. The guide portion 12, which has a function of guiding the piston-type mover 14 while permitting the piston-type mover 14 to move in the axial direction, is a cylindrical member opened on one side and having, in its bottom face, a supply port 18 to which the drive gas pressure P_{P} is supplied, the guide portion 12 being equivalent to a so-called cylinder. It is noted that a space defined by the bottom face and inner side wall of the guide portion 12 and the bottom face of the piston-type mover 14 functions as a pressure chamber 16.

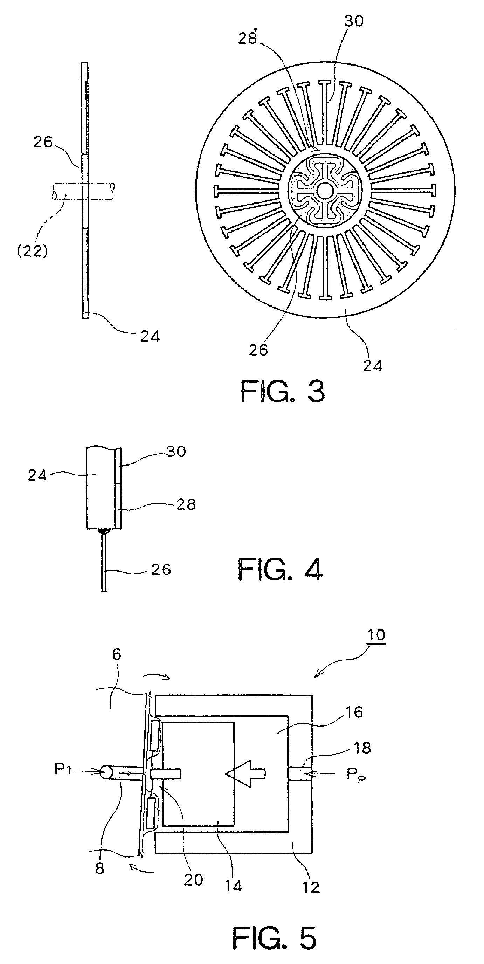

A detailed structure of the annular flat-plate mover 20 is shown in the perspective view of Fig. 2 and the front view and side view of Fig. 3. The annular flat-plate mover 20, being a mover to be supported by a support shaft 22, includes an annular flat plate 24 and a curved spring 26 having cloud like shapes formed of a thin plate having curved flexible arms. In this case, the annular flat plate 24 is supported with its flat plate surface vertical to the axial direction of the support shaft 22.
The annular flat plate 24 is a toroidal member having a concentric circular opening at a central portion of the circular thin plate. In the annular flat plate 24, a plurality of narrow grooves 30 are provided on one or both of the flat plate surfaces so as to extend radially from the center. The radially extending narrow grooves 30 converge integrally on the inner-diameter side of the annular flat plate 24 so as to form a depression. Fig. 4 is an enlarged sectional view of an inner-diameter side portion of the annular flat plate 24. The inner-diameter side portion of the annular flat plate 24 is so formed so that a portion within a specified radius from the center decreases in thickness to form a depression 28, the depression 28 serving as a start point of each narrow groove 30 that extends therefrom radially to a specified length. The radially extending narrow grooves 30 are each broadened circumferentially on both sides at their fore ends, although the broadened ends do not adjoin circumferential breadths of their neighboring narrow grooves 30. The configuration of this surface restrictor using the depression 28 and the narrow grooves 30 is given as an example only, and surface restrictors having other appropriate configurations may be adopted.

Such a depression 28 and narrow grooves 30 are provided so as to produce a throttling effect when the gas flows radially along the surface of the annular flat plate 24. That is, with the flat-plate surface of the annular flat plate 24 opposed to some other surface, when a gas flows through the clearance between the two surfaces to come into a state that the gas flowing through the depression 28 and narrow grooves 30 overflows at terminal ends of the narrow grooves 30 or the like onto the flat surface, the gas passageways are narrowed and restricted, resulting in so-called surface throttling. By an effect of this surface throttling, flows between the two surfaces are stabilized, so that the distance between the two surfaces is also stabilized.

In example dimensions of such an annular flat plate 24, the outer diameter is about 30 mm to about 40 mm, the inner diameter is about 10 mm to 15 mm, the plate thickness is about 0.1 mm to about 0.2 mm or the like, the depth of the depression 28 and the narrow grooves 30 is about 13 µm to about 17 µm, the radial width of the depression 28 is about 2 mm to 4 mm or the like, and the width of each narrow groove 30 is about 0.2 mm or the like. It is noted that the depths of the narrow grooves 30 and the like are exaggeratedly enlarged in Figs. 3 and 4. Such an annular flat plate 24 as shown above can be obtained by manifacture processing a metal disc of, for example, SUS or the like.

The curved spring 26 having cloud like shapes is a thin plate member interposed for connection between an inner-diameter side portion of the annular flat plate 24 and an outer profile of the support shaft 22, the curved spring 26 also serving as a support member for supporting the annular flat-plate mover 20 on the support shaft 22. The curved spring 26 has patterns of complicated, sinuately curved configurations to form aperture-like openings among the patterns, allowing the gas to flow through the opening apertures. Also, the curved spring 26 is so formed in its overall configuration such that its radially extending portions and its circumferentially extending portions are combined properly so that the rigidity against displacement in the axial direction of the support shaft 22 is lower than the rigidity against displacement in the radial direction. Such a curved spring 26 can be obtained by etching a metal plate into specified patterns. For example, the curved spring 26 can be obtained by subjecting an SUS plate of about 0.1 mm thickness to etching, electric discharge machining, or the like. In addition, the term 'curved spring' is only a designation derived from its configurational pattern being sinuately curved, similar to cloud shapes, and springs of other designations may be adopted if their rigidity in the axial direction is low while the rigidity in the radial direction is high.

More specifically, the annular flat-plate mover 20, having the structure such that the annular flat plate 24 is supported to the support shaft 22 via the curved spring 26, is relatively easily movable in the axial direction of the support shaft 22, but less easily movable in the radial direction of the flat plate; i.e., in moving in directions vertical to the axial direction of the support shaft 22, as a characteristic thereof. In other words, the annular flat-plate mover 20 has a characteristic that, with the axial direction of the support shaft 22 assumed as a thrust direction, the annular flat-plate mover 20 has a large degree of freedom in the thrust direction, its motions in the radial direction vertical thereto being restrained.

Returning again to Fig. 1, the annular flat-plate mover 20, in which the support shaft for supporting the annular flat-plate mover 20 is provided at a center in the axial direction of the piston-type mover 14, is so placed that its flat-plate surface faces an opposing surface of the moving object 6. Although the annular flat-plate mover 20 is sufficiently operable as is, the moving object 6 and the annular flat-plate mover 20 are desirably spaced from each other with a gas layer interposed therebetween, because direct contact between the moving object 6 and the flat-plate surface incurs large friction or the like therebetween. Accordingly, in the gas pressure control actuator 10 of Fig. 1, a gas supply port 8 is provided on the moving object 6 side as well so that a gas having a control gas pressure P₁ is supplied from an unillustrated gas pressure control unit toward the annular flat-plate mover 20. The supplied gas flows through a clearance between the annular flat-plate mover 20 and the gas-receiving surface that is the surface of the moving object 6 opposed thereto, as well as through a clearance between the annular flat-plate mover 20 and the fore end surface of the piston-type mover 14. This flow is stabilized by the throttling effect of the depression 28 and the narrow grooves 30 provided on the surface of the annular flat plate 24 as described above.

Fig. 5 is a view for explaining action of the gas pressure control actuator 10 described above. When the drive gas pressure P_{P} is supplied to the pressure chamber 16 through the supply port 18 of the guide portion 12, by which the piston-type mover 14 is guided, a driving force resulting from multiplying the bottom face area of the piston-type mover 14 by P_{P} is imparted to the piston-type mover 14 and transferred from the annular flat-plate mover 20 via the air layer to the moving object 6. Controlling the drive gas pressure R_{P} in this way enables control of the drive of the moving object. The action of the annular flat-plate mover 20 appears most remarkably when the moving object 6 is inclined with respect to the drive axis direction of the gas pressure control actuator 10. In this case, the annular flat-plate mover 20, having a characteristic of being large in degree of freedom in the thrust direction and largely restrained in the radial direction, follows inclinations of the moving object 6 to change its inclination. That is, the curved spring in this case has a function of lowering the inclination-angle rigidity of the flat plate with respect to the axial direction. In other words, the curved spring is able to transfer the driving force to the moving object 6 while following the inclination of the moving object 6 as if a spherical seat mechanism were provided between the piston-type mover 14 and the moving object 6.

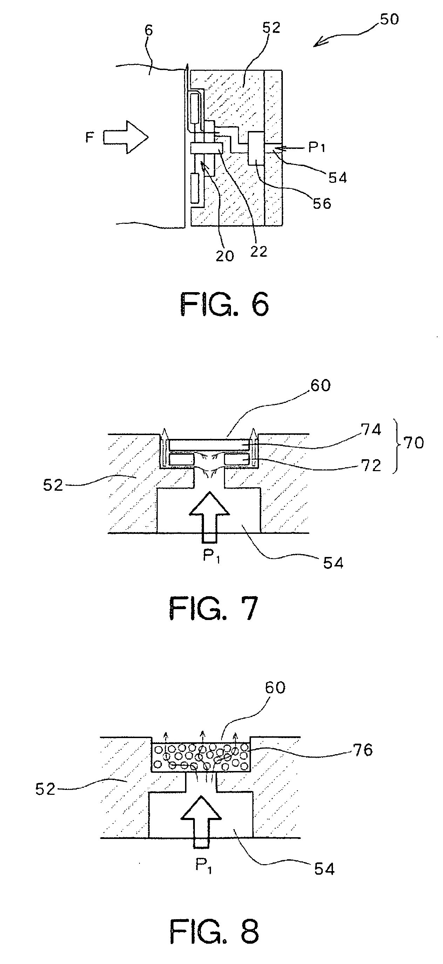

With the gas pressure control actuator 10 using the piston-type mover 14 as described above, a relatively large amount of movement can be imparted to the moving object 6. For relatively small amounts of movement and more precise control, it is appropriately adoptable to control of the pressure of gas that flows through the clearance between the annular flat-plate mover 20 and the gas-receiving surface of the moving object 6. Fig. 6 is a view showing a structure of a gas pressure control actuator 50 using the annular flat-plate mover 20 only as the mover.

In the gas pressure control actuator 50 shown in Fig. 6, the support shaft 22 is attached directly to the bottom face of a cylindrical guide portion 52, and the annular flat-plate mover 20 is so supported that its annular flat plate is attached to the support shaft 22 via the curved spring. The guide portion 52 is provided with a supply port 54 through which the control gas pressure P₁ is supplied, and the gas having the control gas pressure P₁ passes through a restrictor portion 56 so as to be supplied from the bottom face of the guide portion 52 to the annular flat-plate mover 20.

The restrictor portion 56 is a device or structure which is provided at some point along a gas passage between the supply port 54 for supplying the control gas pressure P₁ and a gas outlet in the bottom face of the guide portion 52 for supplying the gas to the annular flat-plate mover 20, and which functions to increase the fluid resistance to rectify the flow of the gas.

Figs. 7 and 8 are views showing two preferred examples as the restrictor portion. Fig. 7 shows a parallel clearance restrictor 70 provided in a pocket opening 60 of the guide portion 52. The parallel clearance restrictor 70 is so made up that an annular plate 72 having a central hole of toroidal shape and a circular plate 74 equal in external shape to the annular plate 72 are placed parallel to each other with a narrow parallel clearance therebetween so that the gas, while flowing through the parallel clearance, is rectified to form a flow without turbulence. The parallel clearance is set preferably to 50 µm, for example, given that the gas pressure supplied to the supply port 54 is 0.5 MPa, with its flow velocity of 30 m/sec, which is to be changed into a laminar flow having a flow velocity of 300 m/sec by the throttling. In that case, the length of the parallel clearance between the annular plate 72 and the circular plate 74 is desirably sufficiently longer than 50 µm, and may be set to about 5 - 10 mm as an example.

As a turbulence-free flow of the gas flowing through the restrictor portion is formed by the rectification effect of the parallel clearance restrictor as shown above, it becomes possible to suppress turbulent flows, whirlpools, and the like which would occur when the gas is restricted by orifice restrictors or the like that are commonly used as restrictors. In particular, shock waves generated from the edge of an orifice or the like can also be suppressed when high-pressure, high-speed gas is involved. Thus, in the gas pressure control, effects of such noise can be reduced, so that the controllability of the gas pressure control actuator 50 can be improved.

Fig. 8 is a view showing another preferred example of the restrictor portion, in which a porous material 76 is placed in the pocket opening 60. In this case also, a turbulence-free flow of the gas flowing through the restrictor portion can be formed by the rectification effect of porous minute holes. Needless to say, ordinary orifices or the like may be used for cases in which the requirement for controllability is less stringent.

Returning again to Fig. 6, the gas supplied from the bottom face of the guide portion 52 via the restrictor portion 56 to the annular flat-plate mover 20 flows through the clearance between the annular flat-plate mover 20 and the gas-receiving surface of the moving object 6 as well as through the clearance between the annular flat-plate mover 20 and the bottom face of the guide portion 52, thereby being released to outside air. In this case, when a pushing force F acts from the moving object 6 toward the gas pressure control actuator 50, flows of the gas flowing through these clearances exhibit a function as a so-called gas bearing. That is, amounts of these clearances can be adjusted by controlling the control gas pressure P₁ while balancing with the pushing force F, so that the annular flat-plate mover 20 can be minutely moved axially; i.e., in the axial direction of the support shaft 22.

In this case also, as in the case explained in Fig. 5, the annular flat-plate mover 20, having a characteristic of being high in degree of freedom in the thrust direction and largely restrained in the radial direction, can be changed in its inclination by following an inclination of the moving object 6. That is, while following minute angle changes of the moving object 6, the annular flat-plate mover 20 can transfer to the moving object 6 the driving force necessary for its minute movement.

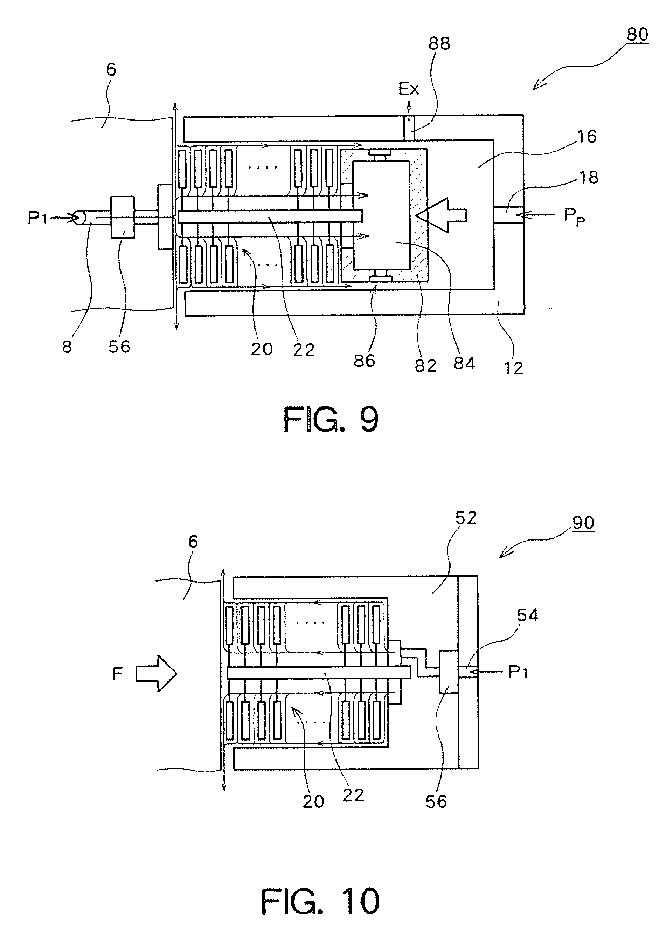

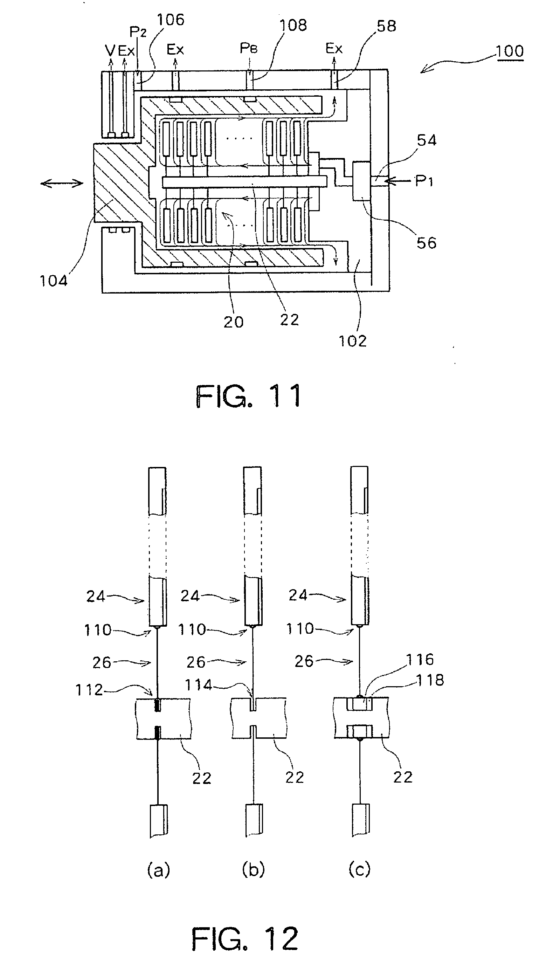

Next described are structures of gas pressure control actuators in which a plurality of annular flat-plate movers 20 are placed in an array in the axial direction of the support shaft 22. Fig. 9 shows a gas pressure control actuator 80 in which a plurality of the annular flat-plate movers 20 are placed at the fore end of the piston-type mover. Fig. 10 shows a gas pressure control actuator 90 in which a plurality of annular flat-plate movers 20 are placed on a support shaft attached to the bottom face of the guide portion. These correspond to the gas pressure control actuators 10, 50, respectively, explained by reference to Figs. 1 and 6, in which the number of annular flat-plate movers 20 are changed from one to a plurality. Fig. 11 shows a gas pressure control actuator 100 in which an output mover 104 is provided as a member for transferring driving force for the annular flat-plate movers 20, independent of the moving object 6, in the structure of Fig. 10. These structures are explained below in detail. In the following description, component members corresponding to those in Figs. 1 to 6 are designated by the same reference numerals, and their detailed description is omitted.

The gas pressure control actuator 80 shown in Fig. 9 corresponds to the gas pressure control actuator 10 explained by reference to Fig. 1 in which the annular flat-plate mover 20 is provided in a plural number as described above. In this case, a gas having the drive gas pressure P_{P} is supplied from the supply port 18 in the bottom face of the guide portion 12 to the pressure chamber 16 to drive a piston-type mover 82. Meanwhile, a gas having a control gas pressure P₁ is supplied from the supply port 8 of the moving object 6 toward the plurality of annular flat-plate movers 20. Preferably, a restrictor portion 56 such as described in Fig. 6 is provided between the supply port 8 and the gas outlet of the gas-receiving surface of the moving object 6; i.e., the gas outlet of the surface facing the annular flat-plate movers 20.

The piston-type mover 82 is a so-called mover having a built-in tank; i.e., a mover having a gas chamber 84 in its interior. The gas having the control gas pressure P₁ passes from the gas-receiving surface of the moving object 6 through gas-passing-through apertures of the individual curved springs of the plurality of annular flat-plate movers 20, then flows through the clearances between adjacent annular flat-plate movers 20 so as to be released to the atmospheric air. A portion of the gas flows into the gas chamber 84 inside the piston-type mover 82, being once stored there and then flowing out through a bearing-use opening 86 into clearances between the outer circumference of the piston-type mover 82 and the inner wall of the guide portion 12. The gas that has flowed out acts to levitate the piston-type mover 82 relative to the inner wall of the guide portion 12 by a so-called gas bearing action. Thus, friction due to the axial movement of the piston-type mover 82 can be reduced.

The gas flowing through the clearances between adjacent annular flat-plate movers 20 exhibits an action of a so-called gas bearing. That is, the pushing force exerted by the drive gas pressure P_{P} acts from the piston-type mover 82 toward the moving object 6, so that the amounts of those clearances can be adjusted by controlling the control gas pressure P₁ while balancing with the pushing force. For example, changing the control gas pressure P₁ by +ΔP allows each clearance to be changed in amout by +Δs, where a factor of Δs/ΔP can be empirically determined by giving a configuration of the annular flat plates, a clearance between the adjacent annular flat plates, a control gas pressure P₁, a pushing force, and the like. In this case, the factor Δs/ΔP is determined for each clearance amount, and given a clearance count N, the amount of axial movement of the plurality of annular flat-plate movers 20 as a whole results in N×Δs so that the movement amount can be adjusted by increasing or decreasing the number of annular flat-plate movers 20.

Referring to one example, with the above-described size of the annular flat-plate movers 20, given a nominal standard value of about 10 µm for the clearance in adjacency and a value P₁ of about 0.2 MPa, there can be attained (clearance variation / gas pressure variation) = (5 µm / 0.1 MPa) or so. Since the thickness of each annular flat plate is about 0.1 mm to several millimeters as described above, it follows that even with N = 100, the entire length of 99 annular flat-plate movers 20 in the axial direction is about 10 mm to several hundreds of millimeters. Then, given a value of ΔP of 0.1 MPa, a movement amount of about 500 µm can be given to the moving object 6 by the 99 annular flat-plate movers 20.

Still, because the movement amount depends on Δs/ΔP and the controllability for gas pressure is quite high, the accuracy for the movement amount can be maintained quite high over the full stroke. It is noted that in the above description, a movement of the piston-type mover 82 due to the drive gas pressure P_{P} is excluded. In actuality, in the driving of the piston-type mover 82 for movement by the drive gas pressure P_{P}, a high-accuracy movement provided by the plurality of annular flat-plate movers 20 is added to the relatively large movement amount provided by the drive gas pressure P_{P}.

In this case also, as described with reference to Fig. 5, the annular flat-plate movers 20, each having a characteristic of being large in degree of freedom in the thrust direction and largely restrained in the radial direction, can be changed in their inclinations by following an inclination of the moving object 6. That is, while following angle changes of the moving object 6, the annular flat-plate movers 20 can transfer to the moving object 6 the driving force necessary for its high-precision minute movement.

The gas pressure control actuator 90 shown in Fig. 10 corresponds to the gas pressure control actuator 50 explained by reference to Fig. 6 in which the annular flat-plate mover 20 is provided in a plural number as described above. In this case, the gas having the control gas pressure P₁ passes from the bottom face of the guide portion 52 through gas-passing-through apertures of the individual curved springs of the plurality of annular flat-plate movers 20, then flows through the clearances between adjacent annular flat-plate movers 20 so as to be released to the atmospheric air. The gas flowing through the clearances between adjacent annular flat-plate movers 20 exhibits an action of a so-called gas bearing. Since the pushing force from the moving object 6 acts toward the plurality of annular flat-plate movers 20, the amounts of those clearances can be adjusted by controlling the control gas pressure P₁ while balancing with the pushing force.

Therefore, if 99 annular flat-plate movers 20 are used under the conditions including the above-mentioned size of the annular flat-plate movers 20 and the like as explained with reference to Fig. 9, a movement amount of about 500 µm can be given to the moving object 6 by the 99 annular flat-plate movers 20 having an overall length of about 10 mm to about several hundreds of millimeters.

Further, the accuracy for the movement amount can be maintained quite high over the full stroke, and the annular flat-plate movers 20 can be changed in their inclinations while following inclinations of the moving object 6, also as explained by reference to Fig. 9.

Whereas the structure of Fig. 10 involves the pushing force F from the moving object 6 as an assumption, the gas pressure control actuator 100 shown in Fig. 11 is so structured that the pushing force is produced inside the gas pressure control actuator. In this case, the output mover 104 is provided between a guide portion 102 and a plurality of the annular flat-plate movers 20. As the output mover 104 is a mover which receives driving force by the plurality of annular flat-plate movers 20, a gas pressure P₂ for pushing force is supplied thereto at its fore-end side shoulder portion through a supply port 106, by which the output mover 104 imparts the pushing force to the plurality of annular flat-plate movers 20.

Accordingly, the gas having the control gas pressure P₁ passes from the bottom face of the guide portion 102 through gas-passing-through apertures of the individual curved springs of the plurality of annular flat-plate movers 20, then flows through the clearances between adjacent annular flat-plate movers 20 so as to be released to the atmospheric air through an exhaust port 58 or the like. The gas flowing through the clearances between adjacent annular flat-plate movers 20 exhibits an action of a so-called gas bearing. Since the pushing force from the output mover 104 acts toward the plurality of annular flat-plate movers 20, amounts of those clearances can be adjusted by controlling the control gas pressure P₁ while balancing with the pushing force.

Therefore, if 99 annular flat-plate movers 20 are used under the conditions including the above-mentioned size of the annular flat-plate movers 20 and the like as explained by reference to Fig. 9, a movement amount of about 500 µm can be given to the moving object 6 by the 99 annular flat-plate movers 20 having an overall length of about 10 mm to about several hundreds of millimeters.

Further, the accuracy for the movement amount can be maintained quite high over the full stroke, and the annular flat-plate movers 20 can be changed in their inclinations while following inclinations of the moving object 6, also as explained in relation to Fig. 9.

In the structure of Fig. 11, the output mover 104 is guided by the inner wall of the guide portion 102, while a bearing gas pressure P_{B} flows through a clearance between the outer circumference of the output mover 104 and the inner wall of the guide portion 102. The gas flowing through this clearance acts to levitate the output mover 104 relative to the inner wall of the guide portion 102 by a so-called gas bearing action. Thus, friction due to the axial movement of the output mover 104 can be reduced. In Fig. 11, reference character 'Ex' indicates exhaust gas. Also, 'V' denotes evacuation, which means to expel unexhausted gas by the evacuation, where the gas pressure control actuator 100 can be made usable even under a reduced-pressure environment or under a vacuum.

Fig. 12 is a view for explaining a method for connection between curved springs 26 and annular flat plates 24 as well as a method for connection between the curved springs 26 and the support shaft 22. The connection between the curved springs 26 and inner-diameter side portions of the annular flat plate 24 can be achieved by adhesion, welding, caulking, or other fixing means 110. In Fig. 12, the curved springs 26 are depicted exaggeratedly thin in plate thickness in order to show that the curved springs 26 have flexibility in the thrust direction, whereas the annular flat plates 24 are considered rigid bodies. However, in actuality, the thickness of each annular flat plate 24 and the plate thickness of each curved spring 26 may be set so as to have little difference therebetween as described above. In such a case, the annular flat plate 24 and the curved spring 26 may also be formed by integral molding.

Connection between the curved spring 26 and the support shaft 22 can be achieved by adhesion, welding, caulking, or other fixing means 112 as shown in Fig. 12(a). Also, in the case where a plurality of annular flat-plate movers 20 are used as described above, the overall movement amount becomes considerably large, so that the annular flat-plate mover placed at an end portion of the support shaft 22 moves to a considerable extent in the axial direction relative to the support shaft 22. Thus, not fixed connection but sliding support is preferable for the connection. Fig. 12(b) is a view showing a structure in which the support shaft 22 is provided with a groove 114 having a groove width sufficiently larger than the plate thickness of the curved spring 26, where an end portion of the curved spring 26 is inserted into the groove 114 so that the curved spring 26 itself is slidingly movable in the axial direction. Fig. 12(c) is a view showing a structure in which a slide portion 116 is connected to an end portion of the curved spring 26, where the support shaft 22 is provided with a slide groove 118 having a groove width sufficiently larger than the width of the slide portion 116. The material of the slide portion 116 is preferably one which allows the sliding resistance to be reduced; e.g., Teflon (registered trademark) or the like. Also, with a previous setting that the curved springs 26 move to quite a large extent in the axial direction relative to the support shaft 22, it is appropriately allowed to preliminarily impart a bias movement amount or biasing force to the curved springs 26.

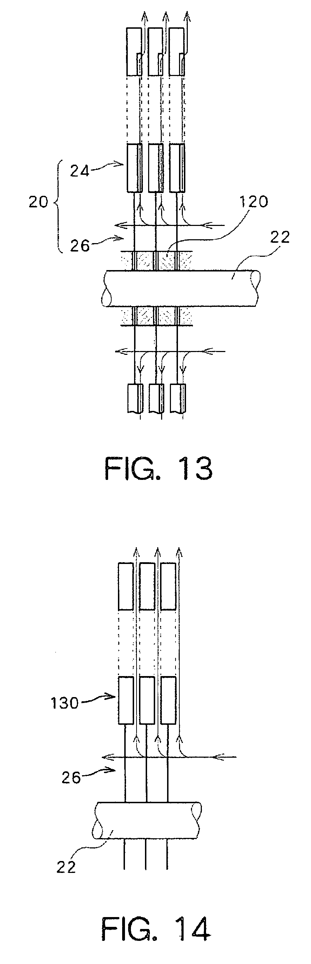

Fig. 13 is a view showing a structure in which spacers 120 or some other proper shims are provided so that the plurality of annular flat-plate movers 20 are placed in an array in the axial direction relative to the support shaft 22. The spacers 120 are preferably placed with proper clearances therebetween so that the curved springs 26 are allowed to slide in the axial direction as explained by reference to Fig. 12.

Fig. 14 is a view showing a structure in which the annular flat plates are simple flat plates 130 without providing any depression or radial narrow grooves. As described with reference to Figs. 3 and 4, providing the annular flat plate 24 with the depression 28 and the narrow grooves 30 that constitute the restrictor portions, flows through the clearances between adjacent annular flat plates are stabilized, thereby stabilizing the amounts of those clearances, so that the bearing rigidity influencing the power of resistance on action of external force is improved, with the so-called positionability improved. Meanwhile, the so-called force controllability for generating driving force by the gas pressure itself decreases. Use of the simple flat plates 130 as shown in Fig. 14, although decreasing bearing rigidity and in turn decreaseing positionability, improves the force controllability.

Thus, with the annular flat plates, it is possible to make either the positionability or the force controllability predominant over the other by means of adjusting the regional size of the depression 28 and the size of the region over which the narrow grooves 30 extend. Accordingly, the size of the region of the depression 28 and the size of the region over which the narrow grooves 30 extend in the annular flat plates can be set depending on the performance required of the gas pressure control actuator.

In the above-described case, the annular flat-plate movers 20 are given by a combination of an annular flat plate 24 and curved springs 26, and the curved springs 26 are shown as one example of a support member which has apertures that allow the gas to flow therethrough and which is lower in displacement rigidity in the axial direction of the support shaft 22 than in the radial direction. Supporting the annular flat plates 24 by the support shaft 22 via the curved springs 26 makes it possible to move the annular flat plates 24 with their flat plates to be moved in the axial direction almost without friction. For example, given a pressure of 4 atm of the gas flowing through the clearances and given that a pushing force appropriately matching this gas pressure is imparted so as to set the clearance amount to about 10 µm, the clearance amount can be made changeable to only about 1 nm at most against an external force of 10 mN under the conditions. Thus, as a result of eliminating effects of friction by using curved springs, it becomes possible to control movement of the flat-plate surfaces in the axial direction with high accuracy. When such high accuracy is unnecessary, simpler structures may be adopted with the curved springs omitted.

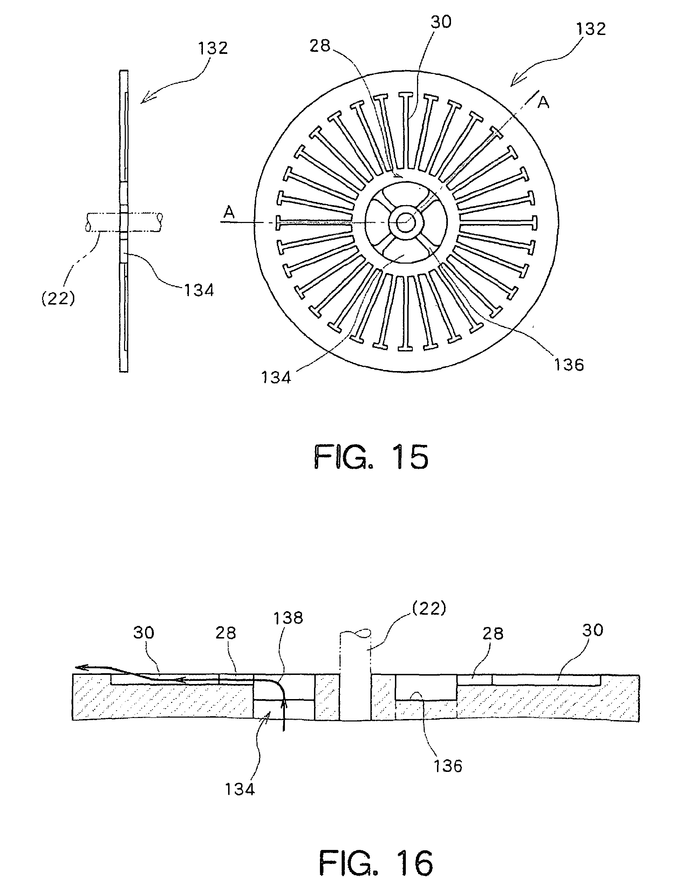

Figs. 15 and 16 are views showing a structure in which, with the curved springs omitted, an annular flat plate 132 having an aperture 134 that allows a gas flow therethrough is supported as an annular flat-plate mover by the support shaft 22. Fig. 15 includes a side view and a front view of the annular flat plate 132, and Fig. 16 is a sectional view taken along the line A - A, being an enlarged view in the thicknesswise direction. The annular flat plate 132 is an annular-shaped member having a concentric opening through which the support shaft 22 passes at a central portion of a circular thin plate. The annular flat plate 132 is provided with a plurality of narrow grooves 30 radially extending from the center of one surface or both surfaces of the flat plate, and these narrow grooves 30 converge integrally on the inner-diameter side of the annular flat plate 132 so as to form a depression 28, similar to the description given by reference to Fig. 3. The aperature 134 is provided at the depression 28 portion for letting the gas pass along the axial direction of the support shaft 22. The aperture 134 may be formed into such an appropriate size as not to impair the rigidity of the depression 28 portion.

Referring to Fig. 15, the aperture 134 is provided in a spatial region between a hole for the support shaft 22 and the depression 28, where four apertures 134 are shown symmetrically with respect to the support shaft 22 in this example. Between adjacent apertures 134 is a depression 136 which is deeper than the depression 28. That is, the depression 28 and the radial narrow grooves 30 are equal to each other in depth from the flat plate surface of the annular flat plate 132, and the regions between adjacent apertures 134 are formed into the depressions 136, which are further deeper than those. With this structure, as shown in Fig. 16, a gas 138 coming up through the aperture 134 along the axial direction flows from the aperture 134 to the further deeper depression 136 to the shallower-than-that depression 28 and narrow grooves 30, being restricted in its flow passage by the narrow grooves 30 so as to move onto the surface of the annular flat plate 132 from ends of the narrow grooves 30. In this way, the gas 138 flows through the clearances that become narrower and narrower in distance from the unillustrated, adjacent annular flat plate, so that the surface throttling effect acts properly.

In addition, actions of the depression 28 and the plurality of radially extending narrow grooves 30 are similar to that described in relation to Fig. 3. That is, the depression 28 and the narrow grooves 30 are provided so as to exhibit a throttling effect when the gas flows radially along the surface of the annular flat plate 24. Examples of dimensions of the depression 28 and the narrow grooves 30 may also be those described in relation to Fig. 3. Such an annular flat plate 132 as shown above can be obtained by manifacture processing a metal disc of, for example, SUS or the like. In addition, in cases in which less displacement rigidity is required, the annular flat plate 132 may also be an even flat plate with the radial narrow grooves 30 eliminated.

The method of support between the support shaft 22 and the annular flat plate 132 may be any one of the three methods explained in Fig. 12. However, a simpler structure can be provided by adopting the support method of the combination of a hole and the shaft slide. In this case, the structure may be a simple one in which the support shaft 22 is a simple round-bar shaft and the annular flat plate 132 has a round hole at its center. Support structures other than this may also be adopted. It is allowable that, for example, that the support portion between the support shaft and the hole is formed into a polygonal cross-sectional shape so as to suppress their axial rotation.

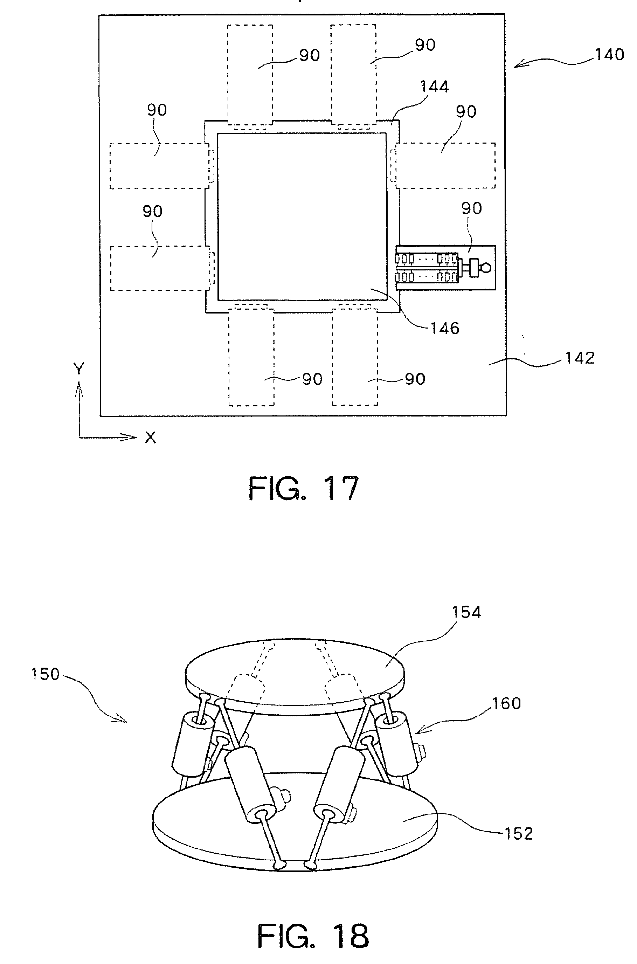

The gas pressure control actuator using the annular flat-plate movers can be utilized as an actuator for tables of XYθ moving mechanisms. Fig. 17 is a plan view of an XYθ moving mechanism, showing a structure in which a rectangular table 146 to be set in a rectangular guide hole 144 provided in a center of a casing 142 is moved within an XY plane and rotated about a Z axis vertical to the XY plane as shown in Fig. 17 by using eight gas pressure control actuators 90. In this case, the eight gas pressure control actuators 90 are of the structure described in Fig. 10. Of course, gas pressure control actuators including annular flat-plate movers of other structures may also be used. Among the eight gas pressure control actuators 90, four which are placed on the left and right sides of the rectangular table 146 as in the drawing sheet of Fig. 17 and whose moving axis directions are parallel to the X direction are X-axis actuators, while four which are placed on the upper and lower sides of the rectangular table 146 as in the drawing sheet and whose moving axis directions are parallel to the Y direction are Y-axis actuators. These plurality of gas pressure control actuators 90 are combined to achieve drive control so that, by their cooperation, the rectangular table 146 can be moved in XYθ directions.

As to operations in the X direction as an example, operations of only the four X actuators have to be discussed. For further simplification, it is sufficient to discuss a case in which with these four actuators are divided into two groups of left-two and right-two actuators, where the two left-half actuators operate in the same way while the two right-half actuators operate in the same way. In this case, the operation of movement in the X-axis direction can be controlled. Similarly, with regard to the four Y actuators, with the assumption that the two upper-half and the two lower-half actuators operate in the same way, respectively, movement in the Y-axis direction can be controlled. Thus, the rectangular table 146 can be moved to an arbitrary position within the X-Y plane.

Further, among the four X actuators, the right upper one and the left lower one are combined into one group, while the right lower one and the left upper one are combined into another group, where making those groups different in movement amount from each other allows the rectangular table 146 to be rotated about the Z axis. Four Y actuators may also be used. In this way, the rectangular table 146 can be rotated by θ about the Z axis. Besides, combining movements within the X-Y plane and 9 rotation allows any arbitrary XYθ movement to be performed.

In addition, these X actuators and Y actuators do not need to be four each in quantity, and may be provided in some number other than four for both or either as an example. Also, the actuators do not necessarily need to be provided in left-and-right symmetry, and may be in other proper placements suited to the configuration of the rectangular table 146, required performance, or the like. The actuators may be so provided as not to be two in number on both right and left with respect to the X-axis direction but to be different in number of placement between right and left; for example, one on one side and two on the other side. The actuators may be asymmetrical in the number of placement also with respect to the Y-axis direction. Furthermore, the total number of X actuators and the total number of Y actuators may be different from each other. For example, it is allowable to provide a total of four X actuators and a total of two Y actuators.

As shown above, for driving the rectangular table 146, using a gas pressure control actuator including an annular flat-plate mover allows high-accuracy minute movement to be ensured over wide ranges, and also allows driving force to be transferred to the rectangular table 146 while following inclinations of the rectangular table 146 without requiring any spherical seat mechanism.

The gas pressure control actuator using the annular flat-plate movers can be utilized as an actuator for six-degree-of-freedom parallel link mechanisms. Fig. 18 is a view showing an example of making up a six-degree-of-freedom parallel link mechanism 150 by using six gas pressure control actuators. The six-degree-of-freedom parallel link mechanism 150 is formed by fitting six gas pressure control actuators 160 in a specified angular placement between a base 152 and a movable stage 154. In this case, each of the six gas pressure control actuators 160 contains an annular flat-plate mover in its inside. This structure corresponds to a modification of a common structure for the six-degree-of-freedom parallel link mechanism in which its six actuators are replaced with the gas pressure control actuators 160. In this case, displacements of the six gas pressure control actuators 160 are controlled independently of one another by a known control method, so that the movable stage 154 can be moved relative to the base 152 with six degrees of freedom for X, Y, Z, ϕ, θ, and ψ.

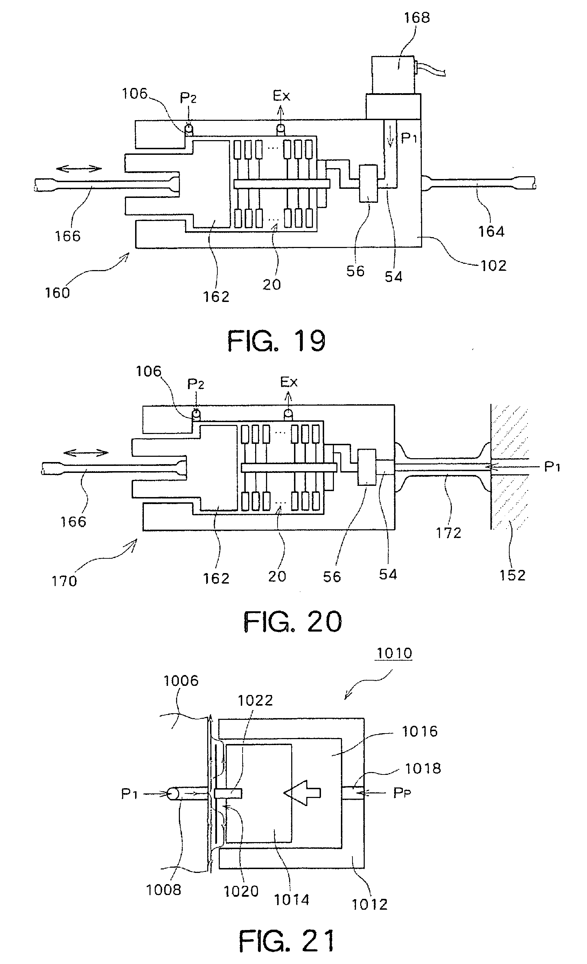

Fig. 19 is a view showing a structure of a gas pressure control actuator 160 to be used for the six-degree-of-freedom parallel link mechanism 150 of Fig. 18, as well as its viciniity. The gas pressure control actuator 160, although slightly different in shape of an output mover 162, may be given by a structure generally identical with that of the gas pressure control actuator 100 described by reference to Fig. 11 including a plurality of annular flat-plate movers 20, and therefore like component members are designated by the same reference numerals and their detailed description is omitted. Of course, other-structure gas pressure control actuators including annular flat-plate movers may also be used. One end of a base-side flexible joint 164 is attached to a guide portion 102 of the gas pressure control actuator 160, while the other end of the base-side flexible joint 164 is attached to a specified position in the base 152 of the six-degree-of-freedom parallel link mechanism 150 of Fig. 18. Also, one end of a movable-stage side flexible joint 166 is attached to the output mover 162, while the other end of the movable-stage side flexible joint 166 is attached to a specified position of the movable stage 154 of the six-degree-of-freedom parallel link mechanism 150 of Fig. 18. Each gas pressure control actuator 160 has a control section 168 attached to its guide portion 102.

Fig. 20 is a view showing another gas pressure control actuator 170 for use with the six-degree-of-freedom parallel link mechanism 150, where component members corresponding to those of Fig. 19 are designated by the same reference numerals and their detailed description is omitted. This case is characterized in that a base-side flexible joint 172 is implemented by a flexible pipe, through which the control gas pressure P₁ is supplied from the base 152 side. Thus, without the need for providing the control section 168 for each actuator, the gas pressure control actuator can be reduced in weight and size.

As shown above, in the six-degree-of-freedom parallel link mechanism 150 of Fig. 18, for driving the movable stage 154 relative to the base 152, using a gas pressure control actuator including annular flat-plate movers ensures high-accuracy minute movement over wide ranges, and also allows driving force to be transferred to the movable stage 154 while following relative inclinations of the movable stage 154 without requiring any spherical seat mechanism.

### 2. Gas pressure control actuator using thin-plate mover

Embodiments will be described in detail below with reference to the accompanying drawings. First described is a basic case with the use of a thin-plate mover, which is one of the cores of embodiments, and thereafter other structures will be described. Described below as the thin-plate mover is an annular thin-plate mover using an annular thin plate which has a circular external shape and in which a hole fitting to a support shaft is provided at its center. However, the thin-plate mover has only to be a thin plate having such a thickness as to allow narrow, elongate grooves to be machined through in the plate-thickness direction, and may be other than circular-shaped in its external shape. That is, the thin-plate mover has only to be a thin plate enough thinner in plate thickness than the groove width and may be a thin plate having, for example, a polygonal external shape or an elliptical external shape or a curved-surface external shape. The support structure between the thin-plate mover and the support shaft, although explained below as a relation between a circular hole and a round bar, yet may also be other than that. It is possible, for example, that while the support shaft is a round bar, the external shape of the support shaft is formed into a polygonal shape and the support hole for the thin-plate mover is formed into a polygonal hole corresponding thereto as the support structure. Doing so makes it easier to suppress the rotation around the support shaft. Of course, the axial cross-sectional shape of the support shaft may be formed into a shape other than polygonal shapes, e.g., an elliptical shape.

The same applies also to a flat-plate mover to be used in combination with the thin-plate mover. That is, described below as the flat-plate mover is an annular flat-plate mover using an annular flat plate which has a circular external shape and in which a hole fitting to a support shaft is provided at its center. However, the flat-plate mover has only to be similar in external shape to the thin-plate mover without being limited to circular external shapes. The flat-plate mover may be a flat plate having, for example, a polygonal external shape or an elliptical external shape or a curved-surface external shape. The support structure between the flat-plate mover and the support shaft, although explained below as a relation between a circular hole and a round bar, yet has only to be similar to the support structure between the thin-plate mover and the support shaft and so may be other than that. It is possible, for example, that while the support shaft is a round bar, the external shape of the support shaft is formed into a polygonal shape and the support hole for the flat-plate mover is formed into a polygonal hole corresponding thereto as the support structure. Doing so makes it easier to suppress the rotation around the support shaft. Of course, the axial cross-sectional shape of the support shaft may be formed into a shape other than polygonal shapes, e.g., an elliptical shape.

Also, materials, dimensions and the like described below are an example for explanation's sake, and any materials, dimensions and the like complying with specifications of the gas pressure control actuator may be selected as required.

A gas control actuator 1010 to be controlled by gas pressure, shown in Fig. 21, uses a piston-type mover 1014 which is guided by a guide portion 1012 for drive of a moving object 1006 into movement and which is to be driven on reception of a drive gas pressure P_{P} supplied from an unshown gas pressure control unit, with a support shaft 1022 provided at a fore end of the piston-type mover 1014 and with an annular thin-plate mover 1020 placed on the support shaft 1022 so as to have its thin-plate surface set along the vertical direction, driving force of the piston-type mover 1014 is transferred to the moving object 1006 via the annular thin-plate mover 1020. The moving object 1006, in this case, is a table or the like capable of making axial movements in XY directions or the like as well as rotations such as θ-rotation around the Z axis. The guide portion 1012, which has a function of guiding the piston-type mover 1014 while permitting the piston-type mover 1014 to move in the axial direction, is a cylindrical member opened on one side and having, in its bottom face, a supply port 1018 to which the drive gas pressure P_{P} is supplied, the guide portion 1012 being equivalent to a so-called cylinder. It is noted that a space defined by the bottom face and inner side wall of the guide portion 1012 and the bottom face of the piston-type mover 1014 is a pressure chamber 1016. Also, a gas supply port 1008 is provided on the moving object 1006 side as well so that a gas having the control gas pressure P₁ is supplied from an unshown gas pressure control unit toward the thin-plate mover 1020.

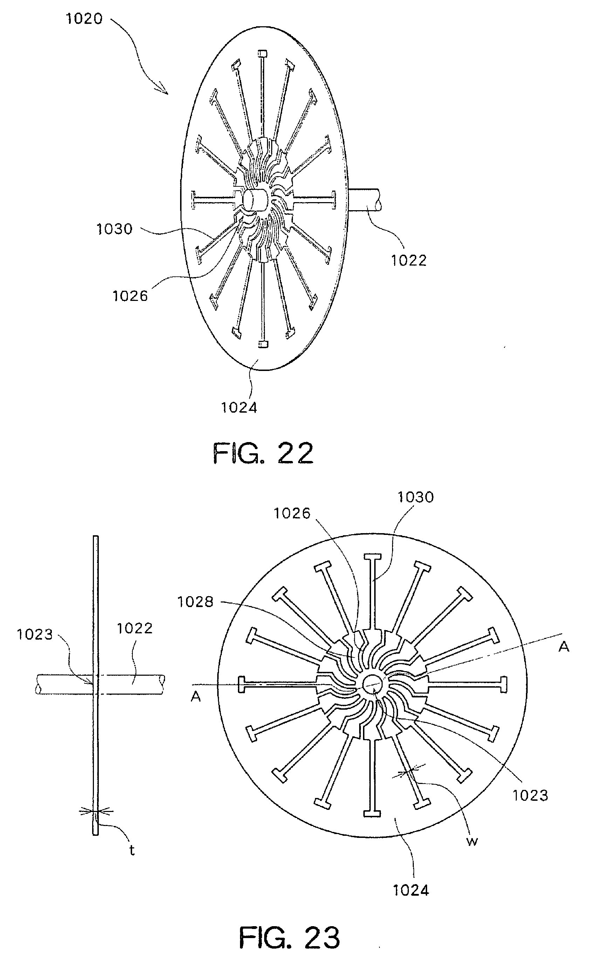

A detailed structure of the annular thin-plate mover 1020 is shown in the perspective view of Fig. 22 and the front view and side view of Fig. 23. The annular thin-plate mover 1020, being a mover to be supported by the support shaft 1022, includes an annular thin plate 1024 and a plurality of wavy- or curved-shaped flexible arms 1026. Apertures 1028 between adjacent flexible arms 1026 are spaces through which the gas flows up. Further, the annular thin plate 1024 is supported with its thin plate surface vertical to the axial direction of the support shaft 1022.

The annular thin plate 1024 is a toroidal member having a concentric circular opening 1023 at a central portion of the circular thin plate. The support shaft 1022 is fitted to the opening 1023 in the central portion. In the annular thin plate 1024, a plurality of narrow grooves 1030 are provided so as to extend radially from the center. The radially extending narrow grooves 1030 start from the apertures 1028, each extending therefrom in the radial direction to a specified length. The radially extending narrow grooves 1030 are each broadened circumferentially on both sides at their fore ends until those broadened ends do not adjoin circumferential breadths of their neighboring narrow grooves 1030. Thus, the narrow grooves 1030 are ended grooves formed through the annular thin plate 1024 in its plate-thickness direction, i.e., to pass through the thin plate from its top to bottom. These narrow grooves 1030 are not merely openings but flow passages having proper flow resistance to the gas while the gas flows therethrough.

In an example of dimensions of such an annular thin plate 1024, the outer diameter is about 30 mm to about 40 mm, the diameter of its boundary with the flexible arms 1026 is about 10 mm to 15 mm, the plate thickness t is about 0.01 mm to about 0.05 mm or so, and the width w of each narrow groove 1030 is about 0.01 mm to about 0.3 mm or so. In addition, the diameter of the support shaft 1022 may be set to several millimeters or so. Such an annular thin plate 1024 as shown above can be obtained by press working or etching on a metal disc of SUS or the like as an example. The plate thickness t of the annular thin plate 1024 can be determined depending on bearing characteristics such as clearances of surfaces to both sides of the annular thin plate 1024.

The plurality of flexible arms 1026 are thin plate members each interposed for connection between an inner-diameter side portion of the annular thin plate 1024 and an outer profile of the support shaft 1022, each of the flexible arms 1026 being also a thin-plate spring member for supporting the annular thin-plate mover 1020 to the support shaft 1022. The flexible arms 1026 have patterns of wavily curved configurations to form aperture-like openings among the patterns, allowing the gas to flow through the apertures 1028. Also, the flexible arms 1026 are so formed in their wavy-shaped width and configuration or the like that the rigidity against displacement in the axial direction of the support shaft 1022 is smaller than the rigidity against displacement in the radial direction. Such flexible arms 1026 can be obtained by etching process of a metal thin plate into specified patterns. For example, the flexible arms 1026 can be obtained by etching or electric discharge machining or the like on about 0.01 to 0.05 mm-thick SUS plate. In addition, the flexible arms 1026 may be formed into a shape other than wavy shapes, whatever shape it is, if the flexible arms have such a spring characteristic of being smaller in rigidity in the axial direction and larger in rigidity in the radial direction. For example, so-called curved-spring shapes may be used. The term 'curved spring' means a sinuately curved shape similar to cloud shapes, and contriving sinuately curved shapes can give a shape having a spring characteristic that the rigidity is small in the axial direction and large in the radial direction.

More specifically, the annular thin-plate mover 1020, having the structure that the annular thin plate 1024 is supported to the support shaft 1022 via a thin-plate spring that is the plurality of flexible arms 1026, is relatively easily movable in the axial direction of the support shaft 1022, but relatively less easily movable in moving in the radial direction of the thin plate, i.e., in moving in directions vertical to the axial direction of the support shaft 1022, as a characteristic thereof. In other words, the annular thin-plate mover 1020 has a characteristic that with the axial direction of the support shaft 1022 assumed as a thrust direction, the annular thin-plate mover 1020 has a large degree of freedom in the thrust direction, its motions in the radial direction vertical thereto being restrained.

Reverting again to Fig. 21, the annular thin-plate mover 1020, in which the support shaft for supporting the annular thin-plate mover 1020 is provided at a center in the axial direction of the piston-type mover 1014, is so placed that its flat-plate surface faces an opposing surface of the moving object 1006. Although the annular thin-plate mover 1020 is operable enough as it is, yet the moving object 1006 and the annular thin-plate mover 1020 are desirably spaced from each other with a gas layer interposed therebetween because direct contact between the moving object 1006 and the flat-plate surface incurs large friction or the like therebetween. Accordingly, in the gas pressure control actuator 1010 of Fig. 21, the gas supply port 1008 is provided on the moving object 1006 side as described before, so that a gas having the control gas pressure P₁ is supplied from an unshown gas pressure control unit toward the annular thin-plate mover 1020. The supplied gas, passing through the apertures and narrow grooves of the annular thin-plate mover 1020, flows through a clearance between the annular thin-plate mover 1020 and the gas-receiving surface that is the surface of the moving object 1006 opposed thereto, as well as through a clearance between the annular thin-plate mover 1020 and the fore end surface of the piston-type mover 1014.

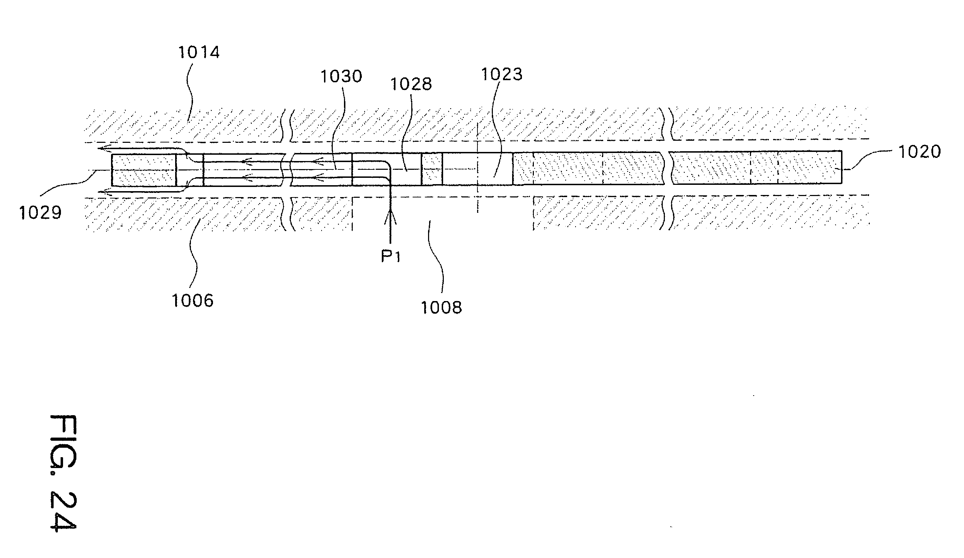

Fig. 24 is a view for explaining a flow of gas associated with the annular thin-plate mover 1020, being a sectional view taken along the line A - A of Fig. 23. In Fig. 24, the annular thin-plate mover 1020 is positioned lateral, while the moving object 1006, which is an object of drive, is depicted below, and the piston-type mover 1014 above, as viewed in the drawing sheet. The gas having the control gas pressure P₁ supplied from the gas supply port 1008 on the moving object 1006 side toward the annular thin-plate mover 1020 flows into the aperture 1028 of the annular thin-plate mover 1020, passing along the narrow groove 1030 therefrom, coming up against an outer-circumferential end portion, going out of the annular thin-plate mover 1020 thereat, and flowing outside through a clearance between the front side of the annular thin-plate mover 1020 and the moving object 1006 as well as a clearance between the rear side of the annular thin-plate mover 1020 and the piston-type mover 1014.

It is noted that the clearance between the annular thin-plate mover 1020 and the moving object 1006, as well as the clearance between the annular thin-plate mover 1020 and the piston-type mover 1014, although actually within a range of about several µm to several tens of µm, are shown exaggeratedly broadened. In the above example, since the plate thickness of the annular thin-plate mover 1020 is about 0.01 mm to about 0.05 mm or so, a surface throttling effect is produced between the narrow groove 1030 and the clearance, so that the annular thin-plate mover acts as a bearing.

In more detail for this function, assuming a virtual boundary 1029 at an intermediate position in the depthwise direction of the narrow groove 1030, gases flow on both the moving object 1006 side and the piston-type mover 1014 side respectively and symmetrically with the virtual boundary 1029 interposed therebetween. On the moving object 1006 side, which is on one side of the virtual boundary 1029, the gas flows through a clearance between the virtual boundary and the moving object 1006, i.e., through a narrow clearance that is actually a lower half of the narrow grooves 1030 having a thickness corresponding to 1/2 of the plate thickness of the annular thin-plate mover 1020. Similarly, the gas flows through a clearance on one side of the virtual boundary 1029 against the piston-type mover 1014, i.e., through a narrow clearance that is actually a upper half of the narrow groove 1030 having a thickness corresponding to 1/2 of the plate thickness of the annular thin-plate mover. In other words, with the virtual boundary 1029 taken as a mirror image plane, two flows flow symmetrically. Since the virtual boundary 1029 does not change from a fluidic point of view, gas bearing actions are fulfilled by the gas flowing through the clearance between the virtual boundary 1029 and the moving object 1006, which is the object of drive, as well as the gas flowing through the clearance between the virtual boundary 1029 and the piston-type mover 1014, respectively.

The gas bearing action allows the clearance amount to be controlled by the gas pressure of the supplied gas, so that minute movement can be fulfilled. Therefore, with the use of the annular thin-plate mover 1020 having the narrow grooves 1030 that run top to bottom through the thin plate, and by controlling the gas pressure P₁ of the gas flowing therethrough, the moving object 1006 that is the drive object can be minutely moved. Further, with combinational use of driving force by the piston-type mover 14, precision movement of the moving object 1006 that is the drive object can be fulfilled over a wide range of moving extent.

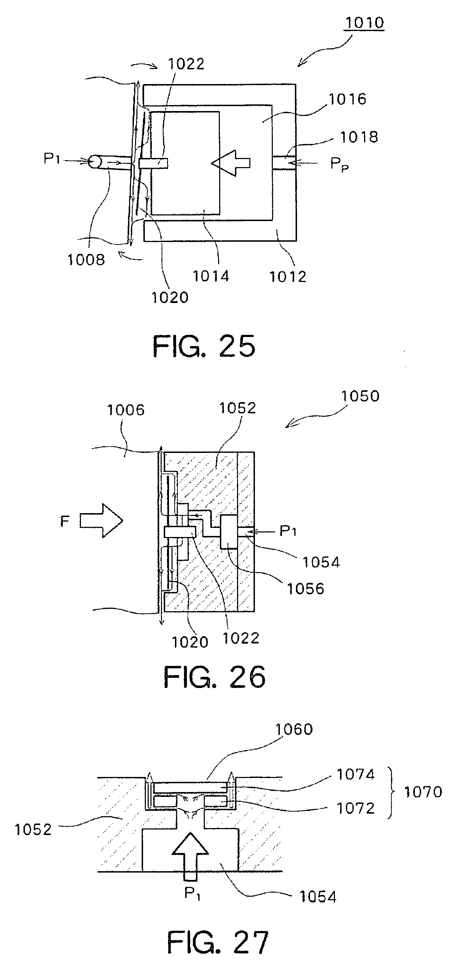

Fig. 25 is a view for explaining action of the gas pressure control actuator 1010 described above. When the drive gas pressure P_{P} is supplied to the pressure chamber 1016 through the supply port 1018 of the guide portion 1012, by which the piston-type mover 1014 is guided, a driving force resulting from multiplying the bottom face area of the piston-type mover 1014 by Pp is given to the piston-type mover 1014 and transferred from the annular thin-plate mover 1020 via the air layer to the moving object 1006. Controlling the drive gas pressure P_{P} in this way makes it possible to control the drive of the moving object 1006. The action of the annular thin-plate mover 1020 appears most remarkably when the moving object 1006 is inclined with respect to the drive axis direction of the gas pressure control actuator 1010. In this case, the annular thin-plate mover 1020, having a characteristic of being large in degree of freedom in the thrust direction and largely restrained in the radial direction, follows inclinations of the moving object 1006 to change its inclination. That is, the flexible arms in this case have a function of lowering the inclination-angle rigidity of the thin plate with respect to the axial direction. In other words, the flexible arms are enabled to transfer the driving force to the moving object 1006 while following the inclination of the moving object 1006 as if a spherical seat mechanism were provided between the piston-type mover 1014 and the moving object 1006.

With the gas pressure control actuator 1010 using the piston-type mover 1014 as described above, a relatively large move amount can be given to the moving object 1006. For relatively small move amounts and more precision control, it is appropriately adoptable to control of the pressure of gas that flows through the clearance between the annular thin-plate mover 1020 and the gas-receiving surface of the moving object 1006. Fig. 26 is a view showing a structure of a gas pressure control actuator 1050 using the annular thin-plate mover 1020 alone as the mover.

In the gas pressure control actuator 1050 shown in Fig. 26, the support shaft 1022 is attached directly to the bottom face of a cylindrical guide portion 1052, and the annular thin-plate mover 1020 is so supported that its annular thin plate is attached to the support shaft 1022 via the flexible arms. The guide portion 1052 is provided with a supply port 1054 through which the control gas pressure P₁ is supplied, and the gas having the control gas pressure P₁ passes through a restrictor portion 1056 so as to be supplied from the bottom face of the guide portion 1052 to the annular thin-plate mover 1020.

The restrictor portion 1056 is a device or structure which is provided at some point on a gas passage between the supply port 1054 for supplying the control gas pressure P₁ and a gas outlet in the bottom face of the guide portion 1052 for supplying the gas to the annular thin-plate mover 1020, and which functions to increase the fluid resistance to rectify the flow of the gas.

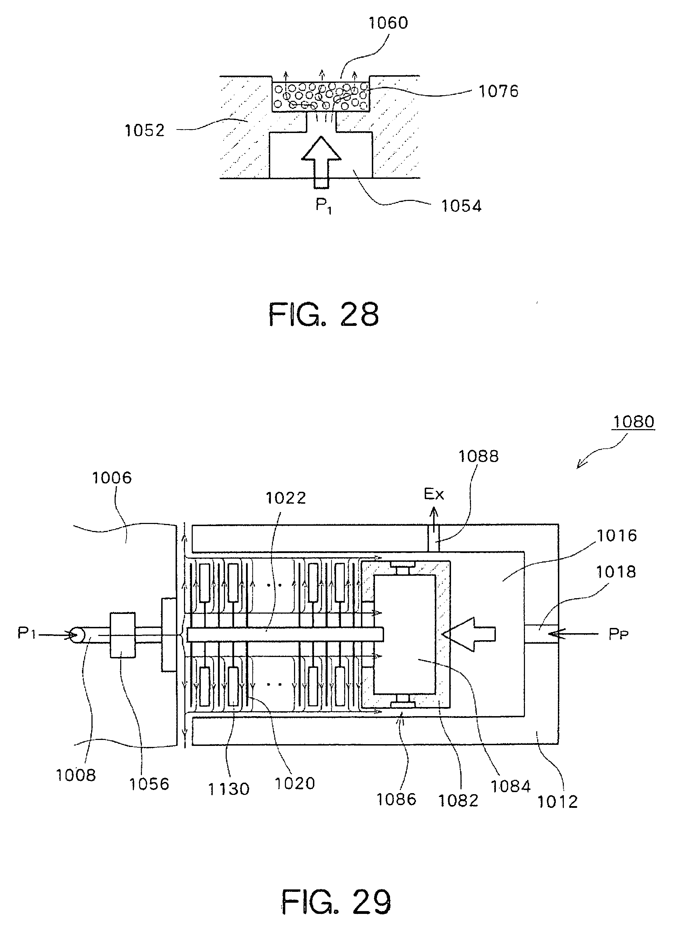

Figs. 27 and 28 are views showing two preferred examples as the restrictor portion. Fig. 27 shows a parallel clearance restrictor 1070 provided in a pocket opening 1060 of the guide portion 1052. The parallel clearance restrictor 1070 is so made up that an annular plate 1072 having a central hole in a toroidal shape and a circular plate 1074 equal in external shape to the annular plate 1072 are placed parallel to each other with a narrow parallel clearance therebetween so that the gas, while flowing through the parallel clearance, is rectified to form a flow without turbulence. The parallel clearance is set preferably to 50 µm, for example, given that the gas pressure supplied to the gas supply port 1054 is 0.5 MPa, with its flow velocity of 30 m/sec, which is to be changed into a laminar flow having a flow velocity of 300 m/sec by the throttling. The length of the parallel clearance between the annular plate 1072 and the circular plate 1074 in that case, desirably enough longer than 50 µm, may be set to about 5 - 10 mm as an example.

As a turbulence-free flow of the gas flowing through the restrictor portion is formed by the rectification effect of the parallel clearance restrictor as shown above, it becomes possible to suppress turbulent flows, whirlpools and the like which would occur when the gas is restricted by orifice restrictors or the like that are commonly used as restrictors. In particular, shock waves generated from the edge of an orifice or the like can also be suppressed when high-pressure, high-speed gas is involved. Thus, in the gas pressure control, effects of such noise can be reduced, so that the controllability of the gas pressure control actuator 1050 can be improved.

Fig. 28 is a view showing another preferred example of the restrictor portion, in which a porous material 1076 is placed in the pocket opening 1060. In this case also, a turbulence-free flow of the gas flowing through the restrictor portion can be formed by the rectification effect of porous minute holes. Needless to say, ordinary orifices or the like may be used for cases in which the controllability is less required.

Reverting again to Fig. 26, the gas supplied from the bottom face of the guide portion 1052 via the restrictor portion 1056 to the annular thin-plate mover 1020 flows through the clearance between the annular thin-plate mover 1020 and the gas-receiving surface of the moving object 1006 as well as through the clearance between the annular thin-plate mover 1020 and the bottom face of the guide portion 1052, being released to outside air. In this case, when a pushing force F acts from the moving object 1006 toward the gas pressure control actuator 1050, flows of the gas flowing through these clearances exhibit a function as a so-called gas bearing. That is, amounts of these clearances can be adjusted by controlling the control gas pressure P₁ while balancing with the pushing force, so that the annular thin-plate mover 1020 can be minutely moved axially, i.e., in the axial direction of the support shaft 1022.

In this case also, as in the case explained in Fig. 25, the annular thin-plate mover 1020, having a characteristic of being large in degree of freedom in the thrust direction and largely restrained in the radial direction, can be changed in its inclination by following inclinations of the moving object 1006. That is, while following minute angle changes of the moving object 1006, the annular thin-plate mover 1020 can transfer to the moving object 1006 the driving force necessary for its minute movement.

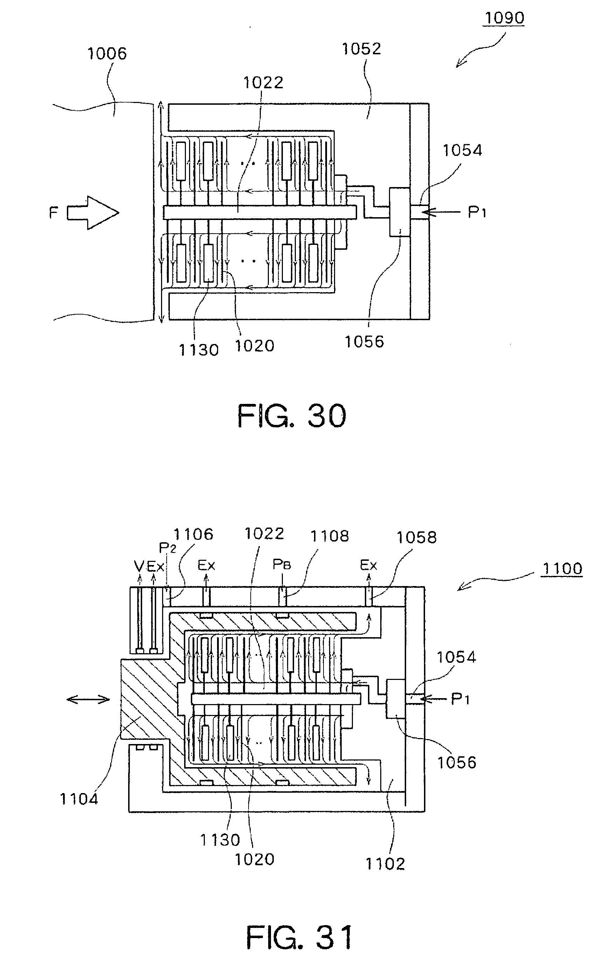

Next described is a structure of a gas pressure control actuator in which a plurality of annular thin-plate movers 1020 are placed in array in the axial direction of the support shaft 1022. Fig. 29 shows a gas pressure control actuator 1080 in which a plurality of annular thin-plate movers are placed in a fore end of a piston-type mover. Fig. 30 shows a gas pressure control actuator 1090 in which a plurality of annular thin-plate movers 1020 are placed on a support shaft attached to a bottom face of a guide portion. These gas pressure control actuators correspond to the gas pressure control actuators 1010, 1050, respectively, described in Figs. 21 and 26, modified so that the number of annular thin-plate movers 1020 is changed from one to a plurality and later-described annular flat-plate movers 1130 are placed before or after the annular thin-plate movers 1020, respectively. Fig. 31 shows a gas pressure control actuator 1100 in which an output mover 1104 is provided, independently of the moving object 1006, to serve for transfer of the driving force for the annular thin-plate movers 1020 in the structure of Fig. 30. Details of these structural components are described below, where like component members in conjunction with Figs. 21 to 26 are designated by the same reference numerals and their detailed description is omitted.

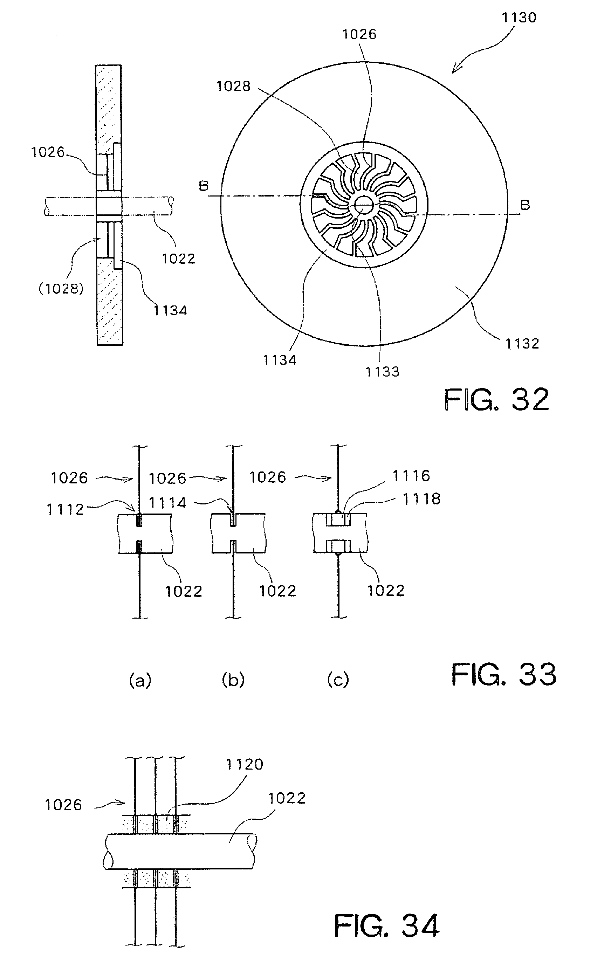

In this case, the annular flat-plate movers 1130 are movers to be used for the placement that a plurality of the annular thin-plate movers 1020 are arrayed along the axial direction of the support shaft 1022. Fig. 32 includes a plan view of the annular flat-plate mover 1130 and a sectional view taken along the line B - B of the plan view. The annular flat-plate mover 1130, which is a mover supported by the support shaft 1022, includes an annular flat plate 1132 and a plurality of wavy- or curved-shaped flexible arms 1026. Apertures 1028 between adjacent flexible arms 1026 are spaces through which the gas flows up. Further, the annular flat plate 1132 is supported with its flat plate surface vertical to the axial direction of the support shaft 1022. The flexible arms 1026 are thin-plate springs similar in structure to the flexible arms 1026 included in the annular thin-plate movers 1020, and apertures 1028 are openings between adjacent flexible arms 1026 also as in the apertures 1028 of the annular thin-plate movers 1020.

The annular flat plate 1132 is a toroidal member having a concentric circular opening 1133 at a central portion of the circular flat plate. The support shaft 1022 is fitted to the opening 1133 in the central portion. The flexible arms 1026 are provided on the outer circumferential side of the opening 1133. Further on the outer peripheral side of the flexible arms 1026, an annular depression 1134 is provided. The depression 1134 is so provided as to produce a throttling effect when the gas flows from the apertures 1028 on the inner circumference side of the annular flat plate 1132 radially along the surface of the annular flat plate 1132. By providing this depression 1134, flows through the clearances between adjacent annular flat plates and annular thin plates are stabilized, making amounts of those clearance stabilized, so that the bearing rigidity suggesting the power of resistance on action of external force is improved, with the so-called positionability improved. The depression 1134 has a function as a gas-introducing portion serving for the gas to flow from the apertures 1028 toward the outer peripheral side. This gas-introducing portion may be formed into a stepped shape thinner in plate thickness than the outer peripheral portion or a tapered shape that increases in plate thickness from the inlet portion of the apertures 1028 toward the outer peripheral portion. In addition, the depression 1134 does not need to be provided depending on the specifications of the gas pressure control actuator.

Planar dimensions of such an annular flat plate 1132 may differ from those of the annular thin-plate movers 1020 in terms of outer diameter, flexible arms, and support-shaft dedicated opening, but preferably those planar dimensions are desirably the same as those of the annular thin-plate movers 1020. That is, preferably, the outer diameter is about 30 mm to about 40 mm, and the diameter of the boundary against the flexible arms 1026 is about 10 mm to 15 mm. No narrow grooves of the annular thin-plate movers 1020 are provided in the annular flat plate 1132. The annular flat plate 1132 needs to have such a plate thickness, as a plate material, as not to be flexed even upon reception of the gas pressure. In the above planar dimensions, for example, the plate thickness may be about 0.1 mm or so. Of course, the plate thickness may be other than that. Such an annular flat plate 1132 as shown above can be obtained by press working or machining on a metal material of SUS or the like into a specified shape as an example.

Assuming that the thin-plate spring portion including the plurality of flexible arms 1026 in the annular flat-plate mover 1130 is the same as in the annular thin-plate movers 1020, the plate thickness t is about 0.01 mm to about 0.05 mm as described above. Therefore, the annular flat plate 1132, and the thin-plate spring portion including the plurality of flexible arms 1026, can be manufactured independently of each other, and integrated together by some proper bonding technique to make up the annular flat-plate mover 1130. Needless to say, with a metal material such as SUS, the annular flat plate 1132 and the flexible arm 1026 portion can be machined integrally by using etching technique or the like to obtain the annular flat-plate mover 1130.

As shown above, the annular flat-plate mover 1130 is a flat-plate mover which is supported by the support shaft with its flat surface vertical to the support shaft and by means of a support member which is smaller in displacement rigidity in the axial direction of the support shaft 1022 than in the radial direction, the annular flat-plate mover 1130 having apertures provided on its inner circumferential side so that gas is allowed to flow therethrough. With the use of this structure, a plurality of the thin-plate movers can be placed along the axial direction of the support shaft, so that adjustment widths of the minute clearances can be increased in response to the number of the thin-plate movers.

More specifically, clearance adjustment with the use of ended grooves in the thin-plate movers involves a wall surface for forming clearances, i.e. gas-receiving surface, on both front and rear sides of each thin-plate mover. Accordingly, the annular thin-plate mover 1020 and the annular flat-plate mover 1130 are alternately placed along the axial direction of the support shaft 1022, where flat-plate movers are provided on necessary sides of the annular thin-plate movers 1020, respectively. Since the annular flat-plate movers 1130 each have a flat-plate surface, combining this flat-plate surface and each annular thin-plate mover 1020 allows a gas-receiving surface for formation of clearances to be placed on both front and rear sides of each annular thin-plate mover 1020. As a result of this, a minute clearance amount that can be controlled by gas pressure can be set for each of the annular thin-plate movers 1020, so that the move amount as a whole can be increased in response to the number of annular thin-plate movers 1020 placed in array on the support shaft 1022.

Reverting again to Fig. 29, the gas pressure control actuator 1080 shown in Fig. 29 corresponds to the gas pressure control actuator 1010, explained in Fig. 21, which is so modified that a plurality of annular thin-plate movers 1020 are included as described above and annular flat-plate movers 1130 are placed between adjacent annular thin-plate movers 1020. In this case, a gas having the drive gas pressure P_{P} is supplied from the supply port 1018 in the bottom face of the guide portion 1012 to the pressure chamber 1016 to drive a piston-type mover 1082. On the other hand, a gas having the control gas pressure P₁ is supplied from the supply port 1008 of the moving object 1006 toward the plurality of annular thin-plate movers 1020 and the plurality of annular flat-plate movers 1130. Preferably, a restrictor portion 1056 such as described in Fig. 26 is provided between the supply port 1008 and the gas outlet of the gas-receiving surface of the moving object 1006, i.e., the gas outlet of the surface confronting the annular thin-plate movers 1020 on the fore end side of the support shaft 1022.

The piston-type mover 1082 is so-to-speak a mover having a built-in tank, i.e., a mover having a gas chamber 1084 in its interior. The gas having the control gas pressure P₁ passes from the gas-receiving surface of the moving object 1006 through gas-passing-through apertures of the individual flexible arms of the plurality of annular thin-plate movers 1020 and the plurality of annular flat-plate movers 1130, then flowing through the narrow grooves of the individual annular thin-plate movers 1020 top-and-bottom symmetrically so as to be thereafter released to the atmospheric air. Part of the gas flows into the gas chamber 1084 inside the piston-type mover 1082, being once stored there and then flowing out through a bearing-use opening 1086 into clearances between the outer circumference of the piston-type mover 1082 and the inner wall of the guide portion 1012. The gas that has flowed out acts to levitate the piston-type mover 1082 relative to the inner wall of the guide portion 1012 by a so-called gas bearing action. Thus, friction due to the axial movement of the piston-type mover 1082 can be reduced.

The gases flowing along the narrow grooves of the annular thin-plate movers 1020 top-and-bottom symmetrically exhibit actions as so-called gas bearings to one gas-receiving surface to which the front side of each annular thin-plate mover 1020 is opposed and another gas-receiving surface to which its rear side is opposed, respectively. In the case of Fig. 29, the gas flowing through the clearance between the annular thin-plate mover 1020 located on the most root side of the support shaft 1022 and the gas-receiving surface of the piston-type mover 1082 is enabled to minutely change the clearance by controlling its supply gas pressure. Similarly, the gas flowing through the clearance between the annular thin-plate mover 1020 located on the most fore end side of the support shaft 1022 and the gas-receiving surface of the moving object 1006 is enabled to minutely change the clearance by controlling its supply gas pressure. Further, the gas flowing through a clearance between an annular thin-plate mover 1020 located midway on the support shaft 1022 and the flat-plate surface of its adjacent annular flat-plate movers 1130 is enabled to minutely change the clearance by controlling its supply gas pressure.

More specifically, the pushing force by the drive gas pressure P_{P} acts from the piston-type mover 1082 toward the moving object 1006, those clearance amounts can be adjusted by controlling the control gas pressure P₁ while balancing with the pushing force. For example, changing the control gas pressure P₁ by +ΔP allows each clearance amount to be changed by +As, where a factor of Δs/ΔP can be empirically determined by giving a configuration of the annular thin plate, a clearance between the annular thin plate and the gas-receiving surface confronting thereto, a control gas pressure P₁, a pushing force and the like. In this case, the factor Δs/ΔP is determined for each clearance, and given a clearance count N, the axial move amount of the plural annular thin-plate movers 1020 as a whole results in NxΔs, so that the move amount can be adjusted by increasing or decreasing the number of annular thin-plate movers 1020. It is noted that since the clearances are present on both sides of each annular thin-plate mover 1020, the clearance count N is a double of the number of annular thin-plate movers 1020.

Referring to one example, with the above-described size of the annular thin-plate movers 1020, given a nominal standard value of about 10 µm of the clearance in adjacency and a value P₁ of about 0.2 MPa, then it can be attained that (clearance variation / gas pressure variation) = (5 µm / 0.1 MPa) or so. Since the thickness of each annular thin plate is about 0.01 mm to about 0.05 mm and the thickness of each annular flat plate is about 0.1 mm or so as described above, it follows that even with the clearance count N = 100, the entire length of 50 annular thin-plate movers 1020 and 49 annular flat-plate movers 1130 in the axial direction is about 5 mm to about 7.5 mm. Then, given a value of ΔP of 0.1 MPa, a move amount of about 500 µm can be given to the moving object 1006 by the 100 clearances.

Still, the move amount depends on Δs/ΔP and the controllability for gas pressure is quite high, the accuracy for the move amount can be maintained quite high over the full stroke. It is noted that in the above description, a movement of the piston-type mover 1082 due to the drive gas pressure P_{P} is excluded. Actually, in the driving of the piston-type mover 1082 for movement by the drive gas pressure P_{P}, a high-accuracy movement by the plural annular thin-plate movers 1020 is added to the relatively large move amount by the drive gas pressure P_{P}.

In this case also, as described in Fig. 25, the annular thin-plate movers 1020 and the annular flat-plate movers 1130, each having a characteristic of being large in degree of freedom in the thrust direction and largely restrained in the radial direction, can be changed in their inclinations by following an inclination of the moving object 1006. That is, while following angle changes of the moving object 1006, the annular thin-plate movers 1020 can transfer to the moving object 1006 the driving force necessary for its high-precision minute movement.

The gas pressure control actuator 1090 shown in Fig. 30 corresponds to the gas pressure control actuator 1050 explained in Fig. 26 in which the annular thin-plate mover 1020 is provided in a plural number and the annular flat-plate mover 1130 is placed between each adjacent annular thin-plate movers 1020 as described above. In this case, the gas having the control gas pressure P₁ passes from the bottom face of the guide portion 1052 through gas-passing-through apertures between the individual flexible arms of the plurality of annular thin-plate movers 1020 and the plurality of annular flat-plate movers 1130, then flowing through the narrow grooves of the individual annular thin-plate movers 1020 top-and-bottom symmetrically so as to be thereafter released to the atmospheric air. Then, as described in conjunction with Fig. 29, the gases flowing through the narrow grooves of the annular thin-plate movers 1020 top-and-bottom symmetrically exhibit actions as so-called gas bearings to one gas-receiving surface to which the front side of each annular thin-plate mover 1020 is opposed and another gas-receiving surface to which its rear side is opposed, respectively. Since the pushing force F from the moving object 1006 acts toward the plurality of annular thin-plate movers 1020 in this case, amounts of those clearances can be adjusted by controlling the control gas pressure P₁ while balancing with the pushing force.

Then, if 100 clearances are used with 50 annular thin-plate movers 1020 and 49 annular flat-plate movers 1130 under the conditions including the above-mentioned size of the annular thin-plate movers 1020 and the like as explained in Fig. 29, a move amount of about 1 mm can be given to the moving object 1006 by an entire length of about 5 mm to about 7.5 mm of the annular thin-plate movers 1020 and the annular flat-plate movers 1130.

Further, the accuracy for the move amount can be maintained quite high over the full stroke, and the annular thin-plate movers 1020 can be changed in their inclinations while following inclinations of the moving object 1006, also as explained in relation to Fig. 29.

Whereas the structure of Fig. 30 involves the pushing force F from the moving object 1006 as an assumption, the gas pressure control actuator 1100 shown in Fig. 31 is so structured that the pushing force is produced inside the gas pressure control actuator. In this case, an output mover 1104 is provided between a guide portion 1102 and a plurality of annular thin-plate movers 1020. As the output mover 1104 is a mover which receives driving force by the plurality of annular thin-plate movers 1020, a gas pressure P₂ for pushing force is supplied thereto at its fore-end side shoulder portion through a supply port 1106, by which the output mover 1104 imparts the pushing force to the plurality of annular thin-plate movers 1020.

Accordingly, the gas having the control gas pressure P₁ passes from the bottom face of the guide portion 1102 through gas-passing-through apertures between the individual flexible arms of the plurality of annular thin-plate movers 1020 and the plurality of annular flat-plate movers 1130, then flowing through the narrow grooves of the individual annular thin-plate movers 1020 top-and-bottom symmetrically so as to be thereafter released to the atmospheric air. Then, as described in conjunction with Fig. 29, the gases flowing through the narrow grooves of the annular thin-plate movers 1020 top-and-bottom symmetrically exhibit actions as so-called gas bearings to one gas-receiving surface to which the front side of each annular thin-plate mover 1020 is opposed and another gas-receiving surface to which its rear side is opposed, respectively. Since the pushing force F from the output mover 1104 acts toward the plurality of annular thin-plate movers 1020 in this case, amounts of those clearances can be adjusted by controlling the control gas pressure P₁ while balancing with the pushing force.

Then, if 100 clearances are used with 50 annular thin-plate movers 1020 and 49 annular flat-plate movers 1130 under the conditions including the above-mentioned size of the annular thin-plate movers 1020 and the like as explained in Fig. 29, a move amount of about 1 mm can be given to the moving object 1006 by an entire length of about 5 mm to about 7.5 mm of the annular thin-plate movers 1020 and the annular flat-plate movers 1130.

Further, the accuracy for the move amount can be maintained quite high over the full stroke, and the annular thin-plate movers 1020 can be changed in their inclinations while following inclinations of the moving object 1006, also as explained in relation to Fig. 9.

In the structure of Fig. 31, the output mover 1104 is guided by the inner wall of the guide portion 1102, while a bearing gas pressure P_{B} flows through a clearance between the outer circumference of the output mover 1104 and the inner wall of the guide portion 1102. The gas flowing through this clearance acts to levitate the output mover 1104 relative to the inner wall of the guide portion 1102 by a so-called gas bearing action. Thus, friction due to the axial movement of the output mover 1104 can be reduced. In Fig. 31, indicated by reference character 'Ex' is exhaust gas. Also, 'V' denotes evacuation, which means to expel unexhausted gas by the evacuation, where the gas pressure control actuator 1100 can be made usable even under a reduced-pressure environment or under a vacuum.

Fig. 33 is a view for explaining a connection method between a flexible arm 1026 and a support shaft 1022. The connection between the flexible arms 1026 and the support shaft 1022 can be fulfilled by adhesion, welding, caulking or other fixing means 1112 as shown in Fig. 33(a). For use of the plurality of annular thin-plate movers 1020 and the plurality of annular flat-plate movers 1130, since the whole move amount becomes considerably large so that the annular thin-plate mover 1020 located at an end portion of the support shaft 1022 moves to a considerably large extend in the axial direction relative to the support shaft 1022 as described above, it is preferable to adopt not fixed connection but sliding support. Fig. 33(b) is a view showing a structure that a groove 1114 having a groove width enough larger than the plate thickness of each flexible arm 1026 is provided in the support shaft 1022, and an end portion of the flexible arm 1026 is inserted into the groove 1114 so as to make the flexible arm 1026 itself slidable in the axial direction. Fig. 33(c) is a view showing a structure that a slide portion 1116 is connected to an end portion of the flexible arm 1026, and a slide groove 1118 having a groove width enough larger than the width of the slide portion 1116 is provided in the support shaft 1022. The material of the slide portion 1116 is preferably one which allows the sliding resistance to be reduced, e.g., Teflon (registered trademark) or the like. Also, with a previous setting that the flexible arms 1026 move to quite a large extent in the axial direction relative to the support shaft 1022, it is appropriately allowed to preliminarily give a bias move amount or biasing force to the flexible arms 1026.

Fig. 34 is a view showing a structure in which spacers 1120 or some other proper shims are provided so that a plurality of annular thin-plate movers 1020 and a plurality of annular flat-plate movers 1130 are placed in array at specified intervals in the axial direction relative to the support shaft 1022. The spacers 1120 are preferably placed with proper clearances therebetween so that the flexible arms 1026 are allowed to slide in the axial direction as explained in Fig. 33.

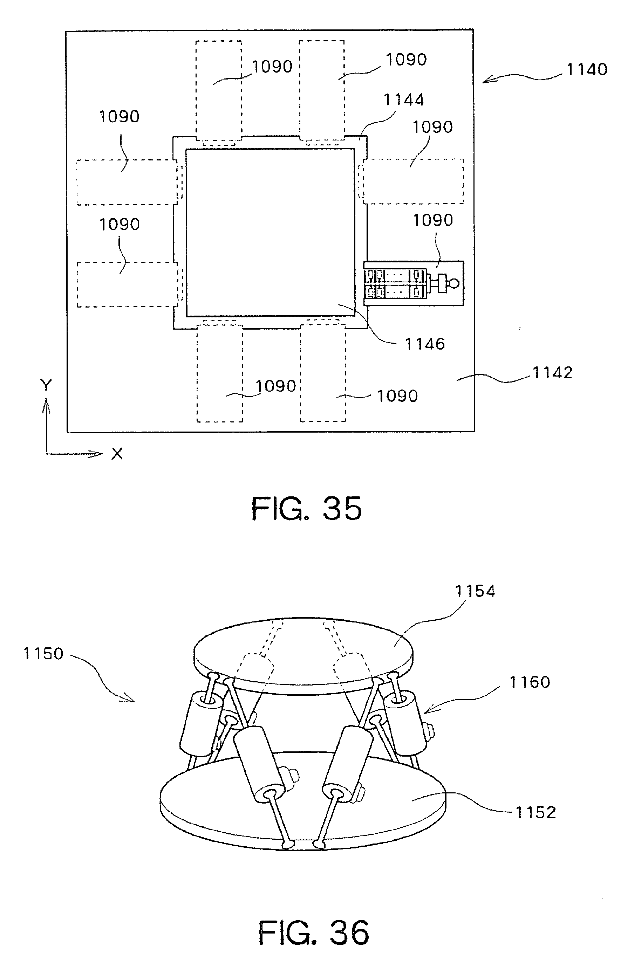

The gas pressure control actuator using the annular thin-plate movers can be utilized as an actuator for tables of XYθ moving mechanisms. Fig. 35 is a plan view of an XYθ moving mechanism 1140, showing a structure in which a rectangular table 1146 to be set in a rectangular guide hole 1144 provided in a center of a casing 1142 is moved within an XY plane and θ-rotated about a Z axis vertical to the XY plane as shown in Fig. 35 by using eight gas pressure control actuators 1090. In this case, the eight gas pressure control actuators 1090 are of the structure described in Fig. 30. Of course, gas pressure control actuators including annular thin-plate movers of other structures may also be used. Among the eight gas pressure control actuators 1090, four ones which are placed on the left and right sides of the rectangular table 1146 as in the drawing sheet of Fig. 35 and whose moving axis directions are parallel to the X direction are X-axis actuators, while four ones which are placed on the upper and lower sides of the rectangular table 1146 as in the drawing sheet and whose moving axis directions are parallel to the Y direction are Y-axis actuators. These plural gas pressure control actuators 1090 are combined to fulfill drive control so that, by their cooperation, the rectangular table 1146 can be moved in XYθ directions.

As to operations in the X-axis direction as an example, operations of only the four X actuators have to be discussed. For further simplification, it is enough to discuss a case in which with these four actuators divided into two groups of left-two and right-two actuators, the left-half two actuators operate in the same way while the right-half two actuators operate in the sam way. In this case, the operation of movement in the X-axis direction can be controlled. Similarly, with regard to the four Y actuators, with the assumption that the upper-half two and the lower-half two actuators operate in the same way, respectively, movement in the Y-axis direction can be controlled. Thus, the rectangular table 1146 can be moved to an arbitrary position within the X-Y plane.

Further, among the four X actuators, the right upper one and the left lower one are combined into one group, while the right lower one and the left upper one are combined into another group, where making those groups different in move amount from each other allows the rectangular table 1146 to be rotated about the Z axis. The four Y actuators may also be used. In this way, the rectangular table 1146 can be rotated by θ about the Z axis. Besides, combining movements within the X-Y plane and θ rotation allows any arbitrary XYθ movement to be performed.

In addition, these X actuators and Y actuators do not need to be each four in quantity, and may be provided in some number other than four for both or either one of them as an example. Also, the actuators do not necessarily need to be provided in left-and-right symmetry, and may be in other proper placements suited to the configuration of the rectangular table 1146, required performance and the like. The actuators may be so provided as not to be each two in number on right and left with respect to the X-axis direction but to be different in number of placement between right and left, for example, one on one side and two on the other side. The actuators may be asymmetrical in the number of placement also with respect to the Y-axis direction. Furthermore, the total number of X actuators and the total number of Y actuators may be different from each other. For example, it is allowable to provide a total of four X actuators and a total of two Y actuators.

As shown above, for driving the rectangular table 1146, using a gas pressure control actuator including an annular thin-plate mover allows high-accuracy minute movement to be ensured over wide ranges, and also allows driving force to be transferred to the rectangular table 1146 while following inclinations of the rectangular table 1146 without requiring any spherical seat mechanism.

The gas pressure control actuator using the annular thin-plate movers can be utilized as an actuator for six-degree-of-freedom parallel link mechanisms. Fig. 36 is a view showing an example of making up a six-degree-of-freedom parallel link mechanism 1150 by using six gas pressure control actuators. The six-degree-of-freedom parallel link mechanism 1150 is formed by fitting six gas pressure control actuators 1160 in a specified angular placement between a base 1152 and a movable stage 1154. In this case, the six gas pressure control actuators 1160 each contain an annular thin-plate mover in its inside. This structure corresponds to a modification of a common structure for the six-degree-of-freedom parallel link mechanism in which its six actuators are replaced with the gas pressure control actuators 1160. In this case, displacements of the six gas pressure control actuators 1160 are controlled independently of one another by a known control method, so that the movable stage 1154 can be moved relative to the base 1152 with six degrees of freedom for X, Y, Z, ϕ, θ and ψ.

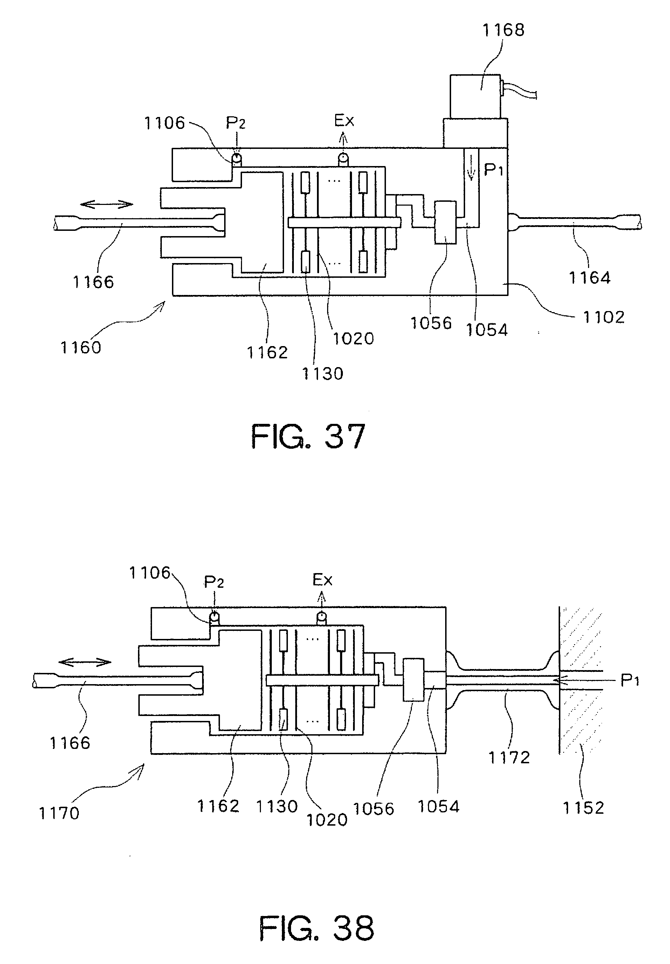

Fig. 37 is a view showing a structure of and around a gas pressure control actuator 1160 to be used for the six-degree-of-freedom parallel link mechanism 1150 of Fig. 36. The gas pressure control actuator 1160, although slightly different in the shape of an output mover 1162, yet may be given by a structure generally identical to that of the gas pressure control actuator 1100 described in Fig. 31 including a plurality of annular thin-plate movers 1020 and a plurality of annular flat-plate movers 1130, and therefore like component members are designated by the same reference numerals and their detailed description is omitted. Of course, other-structure gas pressure control actuators including annular flat-plate movers may also be used. One end of a base-side flexible joint 1164 is attached to a guide portion 1102 of the gas pressure control actuator 1160, while the other end of the base-side flexible joint 1164 is attached to a specified position in the base 1152 of the six-degree-of-freedom parallel link mechanism 1150 of Fig. 36. Also, one end of a movable-stage side flexible joint 1166 is attached to the output mover 1162, while the other end of the movable-stage side flexible joint 1166 is attached to a specified position of the movable stage 1154 of the six-degree-of-freedom parallel link mechanism 1150 of Fig. 36. A control section 1168 of each gas pressure control actuator 1160 is attached to the guide portion 102 provided therefor.

Fig. 38 is a view showing another gas pressure control actuator 1170 for use with the six-degree-of-freedom parallel link mechanism 1150, where like component members in conjunction with Fig. 37 are designated by the same reference numerals and their detailed description is omitted. This case is characterized in that a base-side flexible joint 1172 is implemented by a flexible pipe, through which the control gas pressure P₁ is supplied from the base 1152 side. Thus, without the need for providing the control section for each actuator, the gas pressure control actuator can be reduced in weight and size.

As shown above, in the six-degree-of-freedom parallel link mechanism 1150 of Fig. 36, for driving the movable stage 1154 relative to the base 1152, using a gas pressure control actuator including annular flat-plate movers allows high-accuracy minute movement to be ensured over wide ranges, and also allows driving force to be transferred to the movable stage 1154 while following relative inclinations of the movable stage 1154 without requiring any spherical seat mechanism.

### 3. Gas bearing mechanism for gas pressure control actuator

Embodiments will be described in detail below with reference to the accompanying drawings. In the following description, the thrust bearing mechanism is assumed in mode as an intermediate bearing mechanism for transferring a thrust output of an actuator to a base of a moving table or the like. However, this is one embodiment for use of high-accuracy implementation of clearance amounts, and without being limited to this, it may naturally be carried out for thrust bearing mechanisms of common rotating shafts as well. Further, the gas supply port, although provided in a bottom face portion of the intermediate bearing member in the following description, yet may also be provided in a gas-receiving wall of the base. Similarly, decelerating depressions and gas-passage shallow grooves, although provided in the bottom face portion of the intermediate bearing member, yet may also be provided in the gas-receiving wall of the base. Also, configurations, dimensions, placement of shallow grooves, their numbers and the like described below are given by way of example only, and may be modified depending on applications for practical use.

### [Example 1]

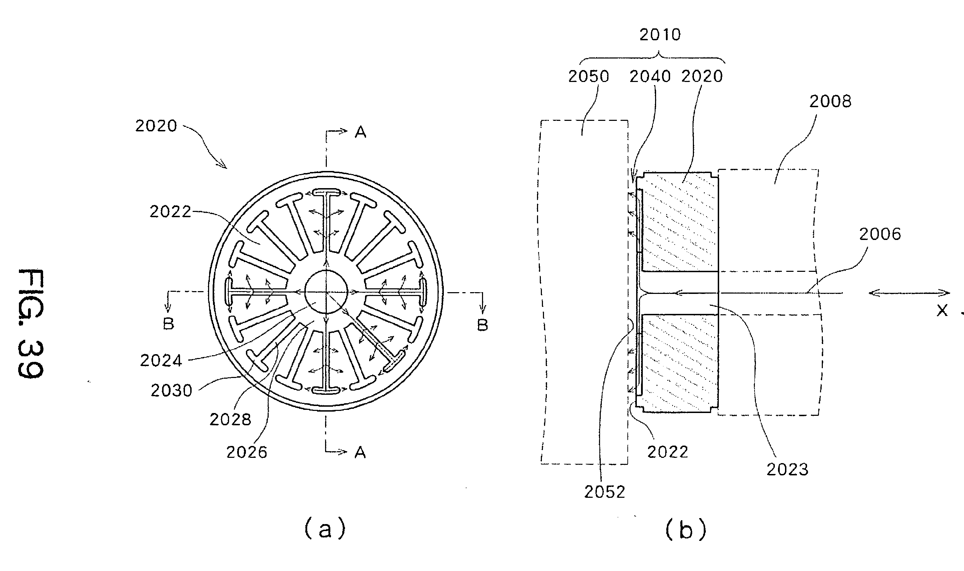

Fig. 39 is a view for explaining a structure of a thrust gas bearing mechanism 2010. This thrust gas bearing mechanism 2010 is for use in a thrust force transfer mechanism that transfers an X-axis direction output of an actuator 2008 via an intermediate bearing member 2020 to a base 2050 of a moving table. For example, high-accuracy movement of the moving table in the X-axis direction requires enhancement toward high-accuracy movement of the actuator 2008 as well as enhancement toward high-accuracy clearance amounts of bearing clearances of the thrust gas bearing mechanism. In this case, the intermediate bearing member 2020 and the base 2050, as well as bearing clearances via which those are opposed to each other, constitute the thrust gas bearing mechanism 2010.

Fig. 39(a) shows a bottom face portion of the intermediate bearing member 2020 with the base 2050 removed, while Fig. 39(b) is a sectional view taken along the line A - A of Fig. 39(a) with respect to the thrust force transfer mechanism including the thrust gas bearing mechanism 2010.

The thrust gas bearing mechanism 2010 is so structured that a gas-receiving wall 2052, which is the thrust-receiving surface of the base 2050, and a gas-receiving surface 2022, which is the bottom face portion of the intermediate bearing member 2020, are opposed to each other to form a bearing clearance 2040 between the gas-receiving wall 2052 and the gas-receiving surface 2022. The intermediate bearing member 2020 is a columnar member in which a through hole 2023 is provided along the center axis. The through hole 2023 is opened as a gas supply port 2024 in the gas-receiving surface 2022. In the gas-receiving surface 2022 of the intermediate bearing member 2020, as shown in Fig. 39(a), a decelerating depression 2026 and a plurality of gas-passage shallow grooves 2028 are provided in addition to the gas supply port 2024 opened therein.

The gas-passage shallow grooves 2028 extend radially from a center given by the gas supply port 2024 along the radial direction toward the outer circumference, and each has a terminal end portion 2030. In the case of Fig. 39, sixteen gas-passage shallow grooves 2028 are provided, i.e., the gas-passage shallow grooves are provided radially at intervals of a circumferential-direction angle of 22.5° about the gas supply port 2024. However, the number may be increased or decreased depending on the application and required performance. It is noted that in Figs. 39(a) and 39(b), part of the gas 2006 flowing from the gas supply port 2024 to the bearing clearance 2040 is indicated by arrow-added flow lines.

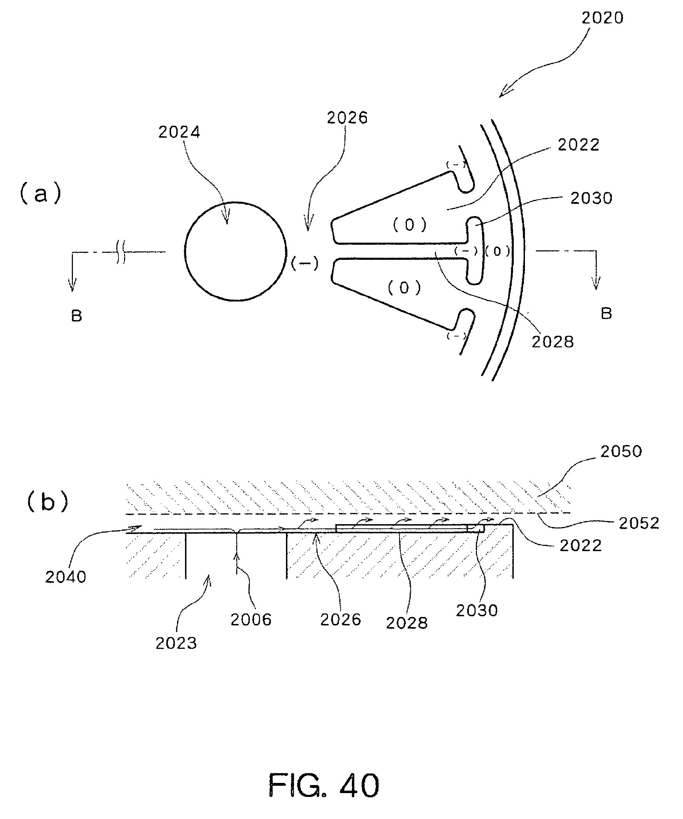

Fig. 40 includes enlarged views of and around one gas-passage shallow groove 2028. The gas-passage shallow groove 2028 shown in this case is positioned along the line B - B of Fig. 39(a). Fig. 40(a) shows a bottom face portion of the intermediate bearing member 2020, while Fig. 40(b) is a sectional view taken along the line B - B, showing the base 2050, the gas-receiving wall 2052 and the bearing clearance 2040.

The gas supply port 2024, which is a circular opening provided at the center of the bottom face portion of the intermediate bearing member 2020 as described above, has a function of supplying the bearing support gas from the through hole 2023 to the bearing clearance 2040. As an example of their sizes, the diameter of the intermediate bearing member may be set to about 30 mm while the diameter of the gas supply port 2024 may be set to about 5 mm or so.

The decelerating depression 2026 is a shallow depression which has a diameter larger than that of the gas supply port 2024 and which is formed into a circular shape concentric with the gas supply port 2024. In Fig. 40(a), the height of the plane of the gas-receiving surface 2022 is expressed as (0) and the height of the decelerating depression 2026 is expressed as (-), showing that the decelerating depression 2026 is sunk lower than the gas-receiving surface 2022. The decelerating depression 2026 has a function of once broadening the flow-passage cross section of the gas 2006 flowing out from the gas supply port 2024, actually jetting-out gas 2006, to a flow-passage cross section wider than that of the gas supply port 2024, before guiding the gas to the plurality of gas-passage shallow grooves 2028 and leading the gas flow along the radial direction so that the flow velocity of the gas flow is decelerated. The degree of deceleration is determined by the size of the diameter of the decelerating depression 2026 relative to the diameter of the gas supply port 2024, the depression depth of the decelerating depression 2026, and the like. As an example of the dimensions, the diameter of the gas supply port 2024 may be set to about 5 mm while the diameter of the decelerating depression 2026 may be set to about 10 mm. Preferably, the depression depth of the decelerating depression 2026 is set to 10 µm to 20 µm or so, preferably, 12 µm to 15 µm or so.

Each of the gas-passage shallow grooves 2028 is a narrow, shallow groove which extends from the decelerating depression 2026 toward the outer circumference of the intermediate bearing member 2020 and which has a terminal end portion 2030. In Fig. 40(a), the height of the gas-passage shallow grooves 2028 is expressed as (-), showing that the decelerating depression 2026 is sunk lower than the gas-receiving surface 2022. The terminal end portion 2030 is so shaped that in succession to the gas-passage shallow groove 2028 that extends along the radial direction toward the outer circumference, the terminal end portion 2030 extends along the circumferential direction, coming to an end, as shown in Fig. 40(a). That is, the gas-passage shallow groove 2028 extends to a specified length along the radial direction, then changes its extension direction so as to go along the circumferential direction, further extending a little more to come to an end. From another point of view, the terminal end portion 2030 has a shape that the gas-passage shallow groove 2028 extends toward the circumference while broadening its width with which it extends in the radial direction.

The gas-passage shallow groove 2028 and its terminal end portion 2030 function as a so-called radial slit restrictor. That is, the gas jetting out from the gas supply port 2024 is decelerated by the decelerating depression 2026, thereafter being led by the individual plural gas-passage shallow grooves 2028 so as to be guided by their narrow, shallow grooves to flow along the radial direction. In this case, since the gas-passage shallow grooves 2028 have terminal end portions 2030, the flowing gas comes to a dead end there. The gas having come to a dead end leaks out while being restricted between the gas-receiving surface 2022 and the gas-receiving wall 2052 opposed thereto, broadening the clearance between the gas-receiving surface 2022 and the gas-receiving wall 2052 to form a bearing clearance 2040, so that the intermediate bearing member 2020 is levitated relative to the base 2050.

The formation of the bearing clearance 2040 may be determined depending on the pushing force of the intermediate bearing member to the base 2050, i.e., depending on a relationship between a thrust force given to the base 2050 via the intermediate bearing member 2020 by the actuator 2008 and the gas supply pressure supplied to the bearing clearance 2040 and the like. That is, controlling the gas supply pressure makes it possible to control the bearing clearance, and controlling the gas supply pressure responsive to the thrust force makes it possible to control the bearing clearance so that its clearance amount becomes constant. Otherwise, it is also possible to freely control the clearance so that its clearance amount becomes a specified one.

In an example of dimensions of the gas-passage shallow grooves 2028, given a diameter of about 30 mm of the intermediate bearing member 2020 and a diameter of about 10 mm of the decelerating depression 2026, the width of the gas-passage shallow grooves 2028 extending along the radial direction toward the outer circumference may be set to about 0.6 mm, and the distance from the center of the gas supply port 2024 to the outermost circumferential side of the terminal end portions 2030 along the radial direction may be set to 12 mm. In this case, the length starting from the outermost circumferential side of the decelerating depression 2026 to the outermost circumferential side of the terminal end portions 2030 of the gas-passage shallow grooves 2028 along the radial direction becomes (12 mm - 10 mm/2) = 7 mm. Each of the terminal end portions 2030 can be made to have a circumferential breadth of about 16° as a circumferential angle about the gas supply port 2024 for the above case where 16 gas-passage shallow grooves 2028 are provided at intervals of 22.5° as a circumferential angle about the gas supply port 2024. The groove depth of the gas-passage shallow grooves 2028 can be made equal to the depression depth of the decelerating depression 2026. Of course, in terms of applications and performance, the groove depth may be even shallower or even deeper than the depression depth of the decelerating depression 2026 to modify the throttling effect.

Functions of the thrust gas bearing mechanism 2010 of the above structure are now described. In the thrust gas bearing mechanism 2010 included in the thrust force transfer mechanism, the actuator 2008 moves the intermediate bearing member 2020 in the X-axis direction toward the base 2050 of the moving table. A gas 2006 having a controlled supply gas pressure is supplied from an unshown gas supply port to the through hole 2023 provided at an axial center of the intermediate bearing member 2020. Since the through hole 2023 is opened as the gas supply port 2024 in the gas-receiving surface 2022 that is a bottom face portion of the intermediate bearing member 2020, the gas 2006 jets out into and flows through the bearing clearance 2040 between the gas-receiving wall 2052 of the base 2050 and the gas-receiving surface 2022 of the intermediate bearing member 2020. The magnitude of the supply gas pressure is, preferably, controlled responsive to the thrust force of the actuator 2008 so that the clearance amount of the bearing clearance 2040 is maintained constant. In addition, with the thrust force less changed, maintaining the supply gas pressure constant will do instead.

The gas 2006 jetting out from the gas supply port 2024 stretches over the circular-shaped decelerating depression 2026 having a diameter larger than the diameter of the gas supply port 2024, where the gas is decelerated. Thereafter, the decelerated gas is led to the gas-passage shallow grooves 2028 that extend from the decelerating depression 2026 along the radial direction toward the outer circumference. Since the gas-passage shallow grooves 2028 come to a dead end at the terminal end portions 2030, the gas having flowed up over the gas-passage shallow grooves 2028 leaks out there toward the bearing clearance 2040. In this leakage, the gas is restricted by the clearance between the gas-receiving wall 2052 and the gas-receiving surface 2022. By this throttling, the flow is rectified, flow turbulences are suppressed, and the stability of maintaining the clearance amount of the bearing clearance 2040 is improved.

The cross-sectional area of the flow-passage surface of each gas-passage shallow groove 2028 is 0.6 mm x (10 µm to 20 µm) in the above example, so that even a total result of the sixteen gas-passage shallow grooves is considerably smaller than the flow passage cross-sectional area of the gas supply port 2024. Therefore, as the high-pressure, high-speed gas is supplied to the gas-passage shallow grooves 2028, there occurs a vena contracta on the gas input side, which may in some cases lead to occurrence of vibrations that cause the clearance amount to vary. The decelerating depression 2026 provided between the gas supply port 2024 and the gas-passage shallow grooves 2028 is larger in diameter than the gas supply port 2024, and relaxes any abrupt changes in flow passage cross-sectional area to reduce the flow velocity of the gas 2006 derived from the gas supply port 2024, thus suppressing the vibrations of the clearance amount of the bearing clearance 2040. Accordingly, the clearance amount of the bearing clearance 2040 can be maintained with high accuracy, so that the drive for movement of the moving table in the X-axis direction of the base 2050 via the intermediate bearing member 2020 by the actuator 2008 can be fulfilled with fhigh accuracy.

It has been described above that the decelerating depression 2026 and the gas-passage shallow grooves 2028 having the terminal end portions 2030 are integrally formed in the bottom face portion of the intermediate bearing member 2020. Such a structure can be implemented at the bottom face portion of the intermediate bearing member 2020 by precision etching process, or such other process as coining process and shot peening process. Alternatively, portions including the decelerating depression 2026 and the gas-passage shallow grooves 2028 having the terminal end portions 2030 may be integrally formed in another member by using the aforementioned process techniques, and the resulting member may be fixedly attached to the intermediate bearing member 2020 having a flat bottom face portion.

### [Example 2]

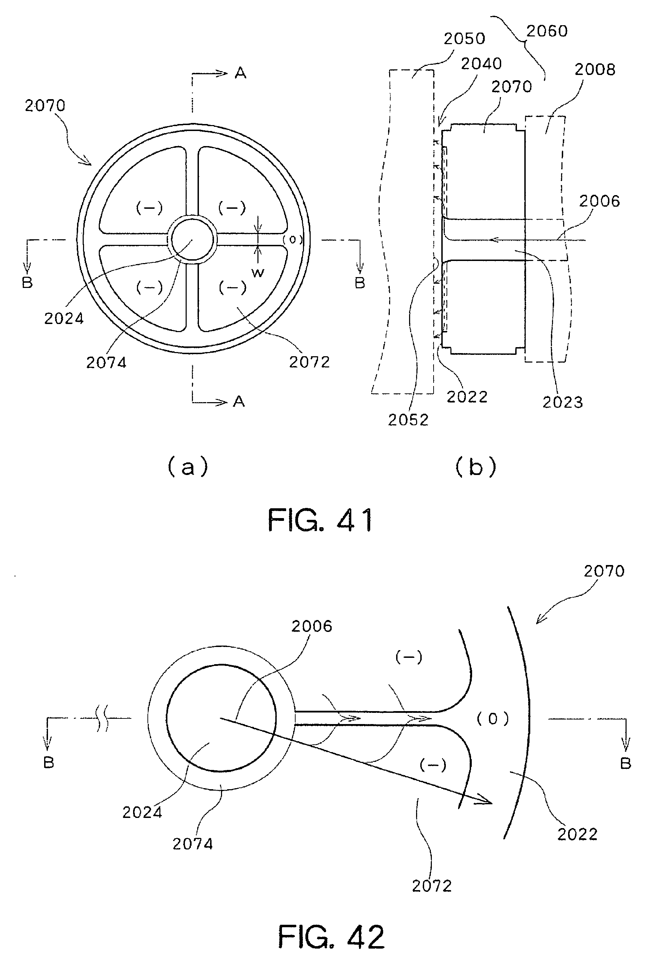

A structure of another thrust gas bearing mechanism 2060 for suppressing vibrations of the bearing clearance 2040 is shown in Figs. 41 and 42, where like component members in conjunction with Figs. 39 and 40 are designated by the same reference numerals and their detailed description is omitted below. Fig. 41 (a) and 41 (b) are views for explaining the structure of the thrust gas bearing mechanism 2060 in correspondence to Fig. 39(a) and 39(b). In this case, an intermediate bearing member 2070 and a base 2050, as well as a bearing clearance 2040 over which those are opposed to each other, constitute the thrust gas bearing mechanism 2060. Thus, the thrust gas bearing mechanism 2060 in this case differs in the structure of the intermediate bearing member 2070 from the thrust gas bearing mechanism 2010 described in Figs. 39 and 40.

As shown in Fig. 41(a), in the gas-receiving surface 2022 of the intermediate bearing member 2070, a plurality of fan-shaped depressions 2072 and an R portion 2074 surrounding the gas supply port 2024 are provided in addition to the gas supply port 2024 opened therein. In Fig. 41(a), the height of the plane of the gas-receiving surface 2022 is expressed as (0) and the height of the fan-shaped depressions 2072 is expressed as (-), showing that the fan-shaped depressions 2072 are sunk lower than the gas-receiving surface 2022.

The fan-shaped depressions 2072 are depressions each of which is broadened in a fan shape while radially extending toward the outer circumference with the gas supply port 2024 taken as a center. In the case of Fig. 41, the fan-shaped depressions 2072 are provided four in number, but the number may naturally be increased or decreased depending on applications and required performance. The depression depth of the fan-shaped depressions 2072 is appropriately set to about 10 µm to 20 µm, preferably 12 µm to 15 µm, as in the decelerating depression 2026 explained in conjunction with Figs. 39 and 40.

Between adjacent fan-shaped depressions 2072 are left narrow, strip portions of the gas-receiving surface 2022. A width W of each of the narrow, strip portions may be set to W = 1 mm to 2 mm or so for cases where the diameter of the intermediate bearing member is about 30 mm and the diameter of the gas supply port is about 5 mm as described in Fig. 39.

The R portion 2074 is a round portion that smooths the circumferential edge of the circular opening of the gas supply port 2024. The R portion may be appropriately sized so as not to disturb the gas flow. Also, instead of the R portion, a recessed portion having a depression (--) which is further lower than the fan-shaped depressions (-) may be formed around the circular opening of the gas supply port 2024 so that the flow is decelerated at the recessed portion.

Fig. 42 is an enlarged view of a portion of the gas-receiving surface 2022 in a vicinity of a strip portion between two fan-shaped depressions 2072. The gas-receiving surface 2022 in the strip portion shown in this case is taken along the line B - B of Fig. 41(a).

It is noted that in Figs. 41 (b) and 42, part of the flow of the gas 2006 flowing from the gas supply port 2024 to the bearing clearance 2040 is indicated by arrow-added flow lines. Thus, the gas 2006 flowing out from the gas supply port 2024 is guided by the fan-shaped depressions 2072 so as to go flowing while spreading toward the outer circumference. Then, the flowing gas comes to a dead end at the edge of the planar shape of the fan-shaped depressions 2072. The gas having come to a dead end leaks out while being restricted between the gas-receiving surface 2022 and the gas-receiving wall 2052 opposed thereto, broadening the clearance between the gas-receiving surface 2022 and the gas-receiving wall 2052 to form a bearing clearance 2040, so that the intermediate bearing member 2070 is levitated relative to the base 2050.

In this case, the flowing gas is guided by the fan-shaped depressions 2072, which are depressions being shallow but having a large area. Accordingly, as compared with the gas-passage shallow grooves 2028 explained in Fig. 39, the fan-shaped depressions 2072 have a large flow passage cross-sectional area so as to relax, to some extent, any abrupt changes in the cross-sectional area of the flow passage derived from the gas supply port 2024. Therefore, vibrations of the clearance amount of the bearing clearance 2040 direction abrupt changes in the flow passage cross-sectional area can be suppressed, so that the clearance amount of the bearing clearance 2040 can be maintained with high accuracy.

### [Example 3]

It has been described above that the gas-passage shallow grooves 2028, as shown in Fig. 39 as an example, extend radially from a center given by the gas supply port 2024 along the radial direction toward the outer circumference, and each has a terminal end portion 2030, i.e., the terminal end portions 2030 are independent from one another without being connected to any other one. Other than this case, those terminal end portions may be connected to one another. For example, all the terminal end portions 2030 may be connected to one another on the circumference so as to form one annular narrow groove on the outer circumference side. Besides, without connecting all the terminal end portions 2030, but with a plurality of terminal end portions 2030 set as one group, a plurality of terminal end portions 2030 may be connected to one another on the circumference on such a group basis. For example, in Fig. 39(a), where sixteen terminal end portions 2030 are shown, those terminal end portions are divided into four groups, and four terminal end portions 2030 are connected to one another, respectively. In this case, four terminal end portions are formed on the outer circumference side.

### [Example 4]

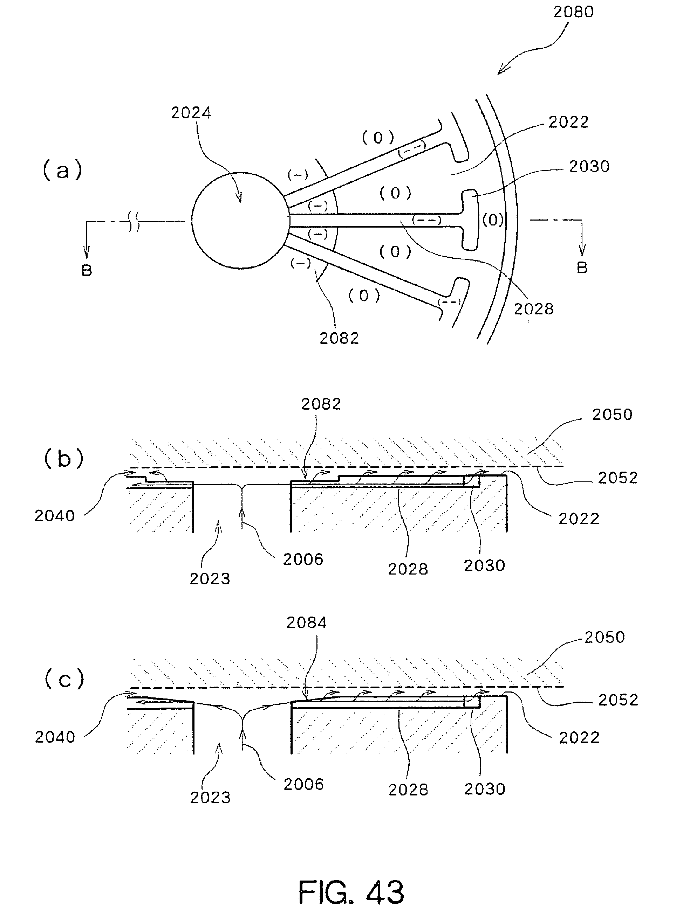

The thrust gas bearing mechanism 2010 in Figs. 39 and 40 has been described as one in which the gas-passage shallow grooves 2028 extend from the decelerating depression 2026 toward the outer circumference of the intermediate bearing member 2020. That is, the gas-passage shallow grooves 2028 and the decelerating depression 2026 are equal to each other in the extent to which they are sunk from the gas-receiving surface 2022. In terms of this extent of sinking from the gas-receiving surface 2022, the decelerating depression 2026 and the gas-passage shallow grooves 2028 can be made different therebetween. Fig. 43 is a view showing a structure of an intermediate bearing member 2080 in which the decelerating depression 2026 is shallower than the gas-passage shallow grooves 2028 as viewed from the gas-receiving surface 2022, where like component members in conjunction with Figs. 39 to 40 are designated by the same reference numerals and their detailed description is omitted in the following description. Figs. 43(a) and 43(b) are views for explaining a structure of the intermediate bearing member 2080 in correspondence to Figs. 40(a) and 40(b).

A decelerating depression 2082 is a depression has a diameter larger than that of the gas supply port 2024 and which is formed into a circular shape concentric with the gas supply port 2024. The extent to which the decelerating depression 2082 is sunk from the gas-receiving surface 2022 is smaller than that of the gas-passage shallow grooves 2028, i.e., shallower than the depth of the gas-passage shallow grooves 2028. In Fig. 43(a), the height of the plane of the gas-receiving surface 2022 is expressed as (0), the height of the decelerating depression 2026 is expressed as (-), and the height of the gas-passage shallow grooves 2028 is expressed as (--), showing that the decelerating depression 2026 is sunk from the gas-receiving surface 2022 and shallower than the gas-passage shallow grooves 2028. The decelerating depression 2026 has a function of once broadening the flow-passage cross section of the gas 2006 flowing out from the gas supply port 2024, actually jetting-out gas 2006, to a flow-passage cross section wider than that of the bearing clearance, before the gas flows into the plurality of gas-passage shallow grooves 2028 and flows out therefrom into the bearing clearance 2040, so that the flow velocity of the gas flow is decelerated. The degree of deceleration is determined by the size of the diameter of the decelerating depression 2026 relative to the diameter of the gas supply port 2024 and the depression depth of the decelerating depression 2026, as well as by the groove depth of the gas-passage shallow grooves 2028, intervals of neighboring gas-passage shallow grooves, and the like. As an example of the dimensions, the diameter of the gas supply port 2024 may be set to about 5 mm, the groove depth of the gas-passage shallow grooves 2028 may be set to 10 µm to 40 µm, the diameter of the decelerating depression 2026 may be set to about 10 mm, and the depression depth of the decelerating depression 2026 may be set to 3 µm to 10 µm or so, preferably about 5 µm or so.

The decelerating depression shallower than the gas-passage shallow grooves 2028 may be a tapered depression. Fig. 43(c) is a view showing an example of the tapered depression which is shallower at the through hole 2023 serving as the gas supply port than the gas-passage shallow grooves 2028 and which goes further and further shallower toward the outer circumference. Thus, forming a tapered decelerating depression 2084 makes it possible to provide a smoother gas flow.

### [Example 5]

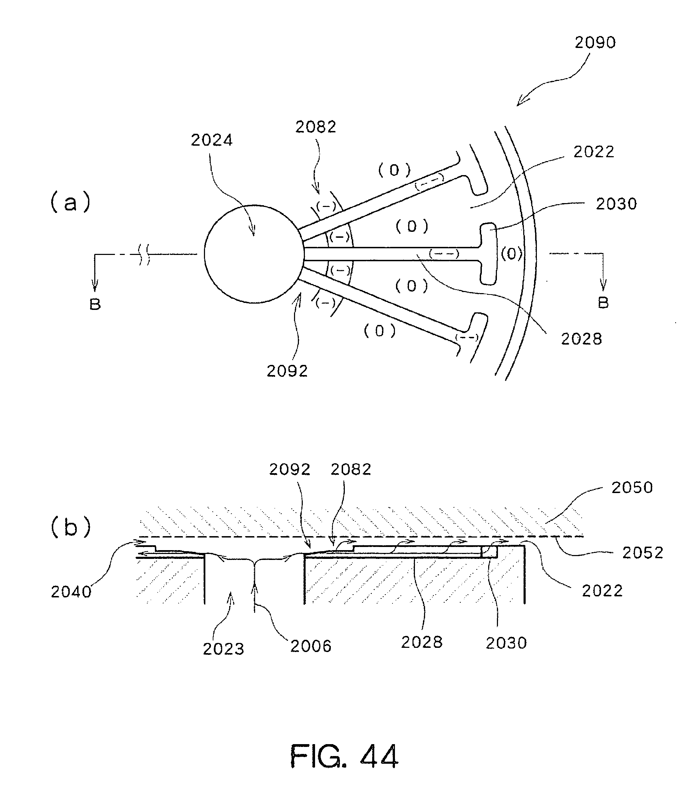

With combinational use of a stepped decelerating depression and a tapered decelerating depression, the flow of gas flowing from the gas supply port to the bearing clearance can be relaxed in its degree of vena contracta, so that vibrations in the flow into the bearing clearance can be suppressed. Fig. 44 is a view showing an example of the combinational use of the stepped decelerating depression 2082 and the tapered decelerating depression 2092, where like component members in conjunction with Figs. 39 and 40 are designated by the same reference numerals and their detailed description is omitted in the following description. Figs. 44(a) and 44(b) are views for explaining a structure of an intermediate bearing member 2090 in correspondence to Figs. 40(a) and 40(b). In this case, it is shown that the extent to which the tapered decelerating depression 2092 is sunk at the through hole 2023 from the gas-receiving surface 2022 is shallower than the gas-passage shallow grooves 2028 and deeper than the stepped decelerating depression 2082, while the radius of the tapered decelerating depression 2092 is shorter than the radius of the stepped decelerating depression 2082.

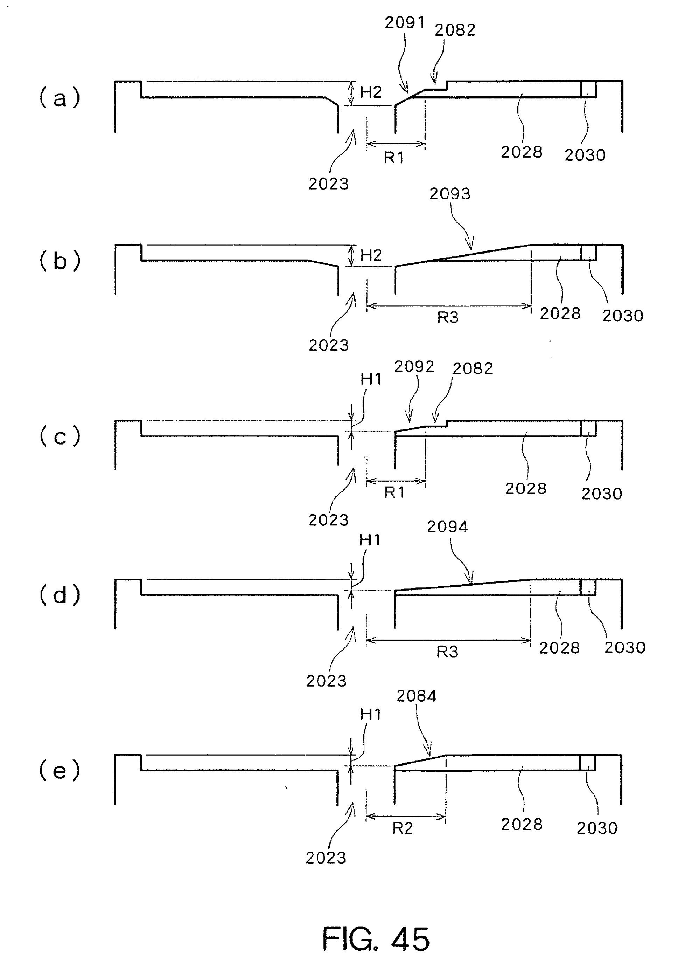

The stepped decelerating depression and the tapered decelerating depression may be selectively combined in their placement depending on applications of the thrust gas bearing mechanism. Fig. 45 includes views showing examples for changing a sink amount H and a radius R of the tapered decelerating depression relative to the stepped decelerating depression 2082. These figures are sectional views taken along a gas-passage shallow groove in the intermediate bearing member. In each figure, the right-hand side of the through hole 2023 is a general sectional view showing an aspect of the farther-side wall in the cross section, while the left-hand side shows a cross-sectional shape of the gas-passage shallow groove with the farther-side wall omitted in the cross section. In these figures also, it is shown that the sink amount of the stepped decelerating depression 2082 is set shallower than the sink amount of the gas-passage shallow grooves 2028 as in the case described in Fig. 43. Of course, with the sink amount of the stepped decelerating depression and the sink amount of the gas-passage shallow grooves set equal to each other, the tapered decelerating depression may be combined with this setting.

Fig. 45(a) and 45(b) show examples in which the sink amount H2 of the tapered decelerating depression at the through hole 2023 is set deeper than the sink amount of the gas-passage shallow grooves 2028. Fig. 45(a) shows an example in which a radius R1 of a tapered decelerating depression 2091 is smaller than the radius of the stepped decelerating depression 2082. Fig. 45(b) shows an example in which a radius R3 of a tapered decelerating depression 2093 is larger than the radius of the stepped decelerating depression, in which case the stepped decelerating depression is eliminated as a result.

Figs. 45(c) and 45(d) show examples in which the sink amount H1 of the tapered decelerating depression at the through hole 2023 is set deeper than the sink amount of the stepped decelerating depression 2082 and shallower than the sink amount of the gas-passage shallow grooves 2028. Fig. 45(c) shows an example in which a radius R1 of the tapered decelerating depression 2092 is smaller than the radius of the stepped decelerating depression 2082, corresponding to the above-described case of Fig. 44. Fig. 45 (d) shows an example in which a radius R3 of a tapered decelerating depression 2094 is larger than the radius of the stepped decelerating depression, in which case the stepped decelerating depression is eliminated as a result. In addition, Fig. 45 (e) shows a case in which a radius R2 of the tapered decelerating depression 2084 is just equal to the radius of the stepped decelerating depression, corresponding to the above-described case of Fig. 43(c).

In these bearing mechanisms, adopting the above-described structures makes it possible to fulfill high-accuracy clearance amounts even for the function as an actuator implemented by controlling the supply pressure to thereby control the clearance amount between gas-receiving wall and gas-receiving surface, hence high usefulness. Further, placing the bearing mechanisms of the above structure in series makes it possible to achieve larger strokes as an actuator as well.

### 4. Minute displacement output device using gas pressure control actuator

Embodiments will be described in detail below with reference to the accompanying drawings. Dimensions, materials, numbers and the like described below are given by way of example only, and may be changed conditionally depending on applications for practical use.

First described is a case in which a plurality of flat-plate movers are used as movers for generating minute displacements, as well as its application examples. After that, a case in which thin-plate movers and flat-plate movers alternately placed are used is described.

### [Example 6]

Described below as the flat-plate mover is an annular flat-plate mover using an annular flat plate which has a circular external shape and in which a hole fitting to a support shaft is provided at a center. However, the flat-plate mover has only to be a flat plate thinner in plate thickness in comparison to its planar size, and may be other than circular-shaped in its external shape. For example, the flat-plate mover may also be a flat plate having a polygonal external shape or an elliptical external shape or a curved-surface external shape. The support structure between the flat-plate mover and the support shaft, although explained below as a relation between a circular hole and a round bar, yet may also be other than that. It is possible, for example, that while the support shaft is a round bar, the external shape of the support shaft is formed into a polygonal shape and the support hole for the flat-plate mover is formed into a polygonal hole corresponding thereto as the support structure. Doing so makes it easier to suppress the rotation around the support shaft. Of course, the axial cross-sectional shape of the support shaft may be formed into a shape other than polygonal shapes, e.g., an elliptical shape.

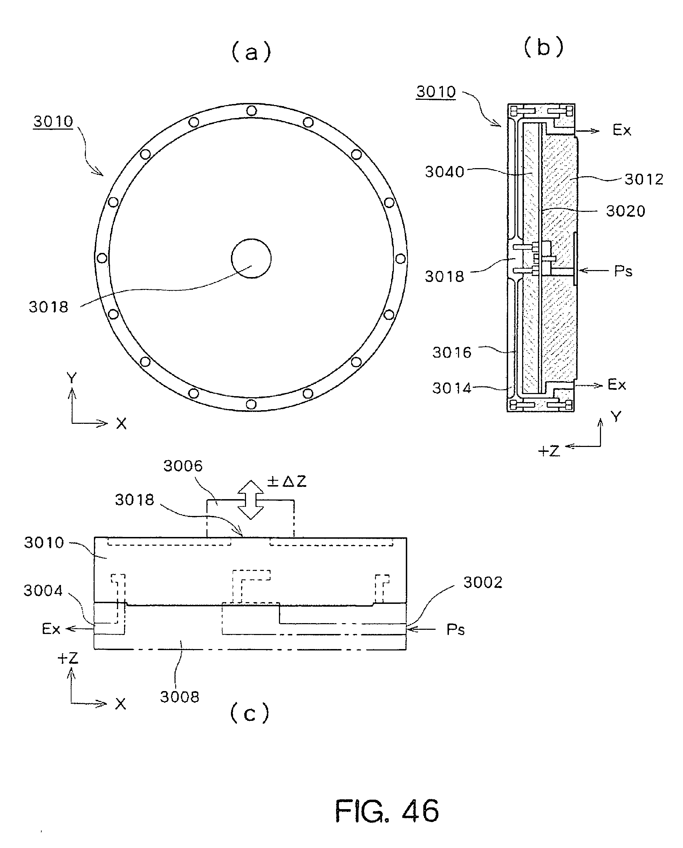

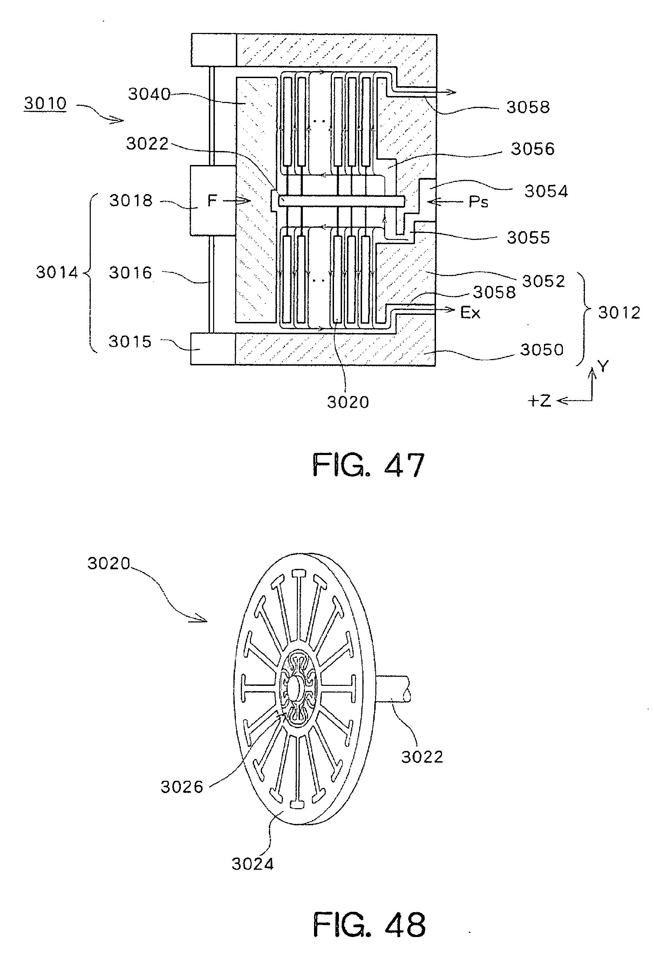

Fig. 46 includes views showing a minute displacement output device 3010 using a plurality of flat-plate movers, where Fig. 46(a) is a plan view, 46(b) is a sectional view and 46(c) is a front view. It is noted that an X direction, a Y direction and a Z direction are shown in the figures. Fig. 47 is an enlarged sectional view of the minute displacement output device 3010, where the enlargement ratio is larger in the Z direction than in the Y direction for an easier understanding of relationship as to the clearance along the Z direction or the like. Further, in Fig. 46(c), an object 3006 to be subject to minute displacements and a base 3008 for placing the minute displacement output device 3010 thereon are shown, though not being component elements of the minute displacement output device 3010. The object 3006 may be, for example, a table which is minutely movable in the Z direction, or a test article of weight to be minutely moved in the Z direction. The base 3008 preferably has a supply port 3002 for supplying a gas having a controlled gas pressure P_{S} to the minute displacement output device 3010, and an exhaust port 3004 for exhausting the gas from the minute displacement output device 3010, and a preferred mode thereof is shown in Fig. 46(c).

The minute displacement output device 3010 is a device having a function of, upon receiving an input of a controlled gas pressure, producing an output of a minute displacement along the Z direction from its transfer portion 3018 to the outside. In this case, the terms "minute displacement to be outputted" refers to a displacement in a range of several µm to several tens of µm with an accuracy on the order of nanometers (nm) to several tens of nanometers or so.

The minute displacement output device 3010 is a device which includes a casing portion 3012 and a cover portion 3014 covering a top face of the casing portion 3012 and which has a flat cylindrical external shape. A plurality of flat-plate movers 3020 which are attached in an array placement in the axial direction of a support shaft 3022, and an output mover 3040 confronting the most fore-end side flat-plate mover out of the plurality of flat-plate movers 3020 are contained in an internal space surrounded by the casing portion 3012 and the cover portion 3014.

The casing portion 3012 is a cylindrical component which has a cylindrical portion 3050 and a bottom portion 3052 and which is opened upward as viewed from the bottom portion 3052, i.e., on the +Z direction side. In the bottom portion 3052 are provided an intake port 3054 which is provided in the outer wall to receive a gas having a control gas pressure P_{S}, a gas supply port 3056 provided in the inner wall, i.e. bottom face, and a gas passage 3055 which connects the intake port 3054 and the gas supply port 3056 to each other. Preferably, a proper restrictor portion is provided at any one of the intake port 3054, the gas passage 3055 and the gas supply port 3056.

The restrictor portion is an element or structure having a function of increasing the fluid resistance to rectify the flow of the gas. Such a restrictor portion may be a parallel clearance restrictor. The parallel clearance restrictor is so made up that an annular plate having a central hole in a toroidal shape and a circular plate equal in external shape to the annular plate are juxtaposed with a narrow parallel clearance therebetween so that the gas, while flowing through the parallel clearance, is rectified to form a flow without turbulence. The restrictor portion may also be one in which a porous material is placed in a pocket opening. In this case also, a turbulence-free flow of the gas flowing through the restrictor portion can be formed by the rectification effect of porous minute holes. Needless to say, ordinary orifices or the like may be used as the restrictor portion for cases in which the controllability is less required.

The support shaft 3022 is attached to the bottom portion 3052 of the casing portion 3012 so as to be positioned with its fore end directed toward the +Z direction. The support shaft 3022 is a shaft component having a function of allowing a plurality of flat-plate movers 3020 to be attached and supported thereto in an arrayed placement in the axial direction, i.e., along the Z direction. The support shaft 3022 is so positioned that its fore end is kept from contact with the output mover 3040.

The cover portion 3014 is a member which covers a fore-end side opening of the casing portion 3012. The cover portion 3014 includes a ring portion 3015 that can be integrated with the cylindrical portion 3050 of the casing portion 3012, a disc-shaped transfer portion 3018 placed at a center, and a membrane-like thin plate 3016 formed of an elastic material for connecting the ring portion 3015 and the transfer portion 3018 to each other. The thin plate 3016 is so set in configuration that a proper biasing force is given to the output mover 3040 via the transfer portion 3018 when the cover portion 3014 and the casing portion 3012 are integrated together. As a result of this, the cover portion 3014 has a function as a pushing force generation means for giving a pushing force to the output mover 3040 as well as a function as a displacement output means for transferring a displacement output of the output mover to the outside from the top face side of the transfer portion 3018 which is effected by the bottom face side of the transfer portion 3018 coming into contact with the central portion of the output mover 3040. Also, when the membrane-like thin plate 3016 is supported by the transfer portion 3018 and the ring portion 3015 each without no clearance so that the ring portion 3015 and the casing portion 3012 are integrated without clearances, the cover portion 3014 has a function of keeping the internal space excluding the intake port 3054 and an exhaust port 3058 air tight in cooperation with the casing portion 3012.

Such a cover portion 3014 may be made up by using a stainless thin plate having a plate thickness of about 1 mm to about 2 mm as the thin plate 3016, given that the diameter of the transfer portion 3018, i.e. inside diameter of the thin plate 3016, is about 20 mm and the inner diameter of the ring portion 3015, i.e. outside diameter of the thin plate 3016, is about 150 mm. In this structure example, given a Z-direction output displacement ΔZ = 1 mm of the transfer portion 3018, the stress occurring to the thin plate 3016 can be made enough lower than a permissible value according to a membrane-model trial calculation.

The plurality of flat-plate movers 3020 are minute-movement movers having a function of moving and displacing the output mover 3040 to an extent corresponding to a variation of a clearance amount between adjacent flat-plate movers 3020 effected by changing the clearance amount. The flat-plate movers 3020 are placed in array in plurality along the axial direction of the support shaft 3022 between the bottom face of the bottom portion 3052 of the casing portion 3012 and the bottom face of the output mover 3040.

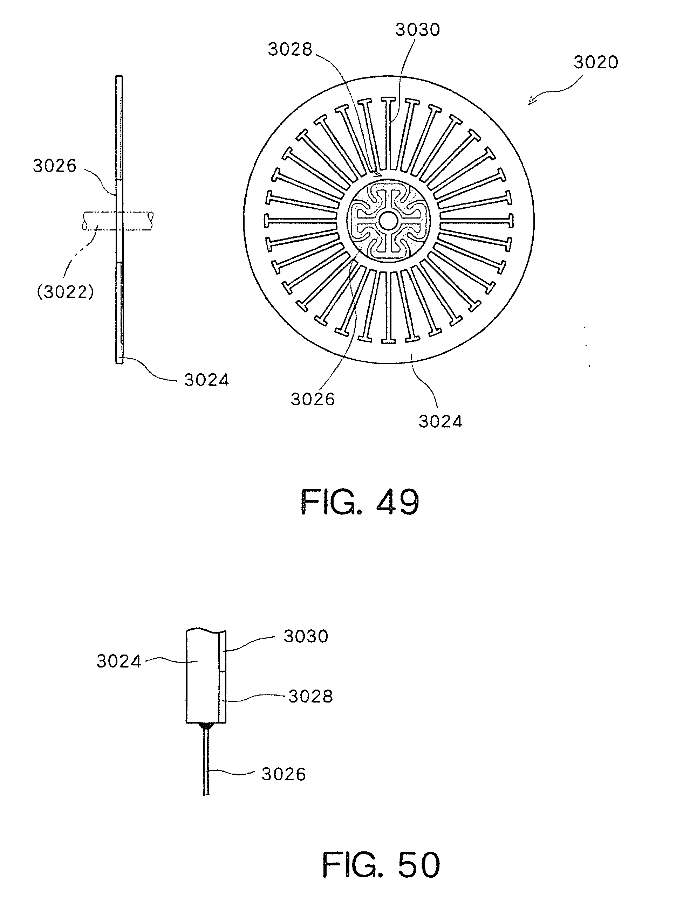

A detailed structure of the flat-plate mover 3020 is shown in the perspective view of Fig. 48 and the front view and the side view of Fig. 49. Each of the flat-plate movers 3020 is a mover which is supported by the support shaft 3022 and which includes an annular flat plate 3024 and a so-called curved spring 3026 formed of a thin plate having curved-shaped flexible arms. In this case, the annular flat plate 3024 is supported by the support shaft 3022 with its flat surface vertical to the axial direction of the support shaft 3022.

The annular flat plate 3024 is a toroidal member having a concentric circular opening at a central portion of the circular flat plate. In the annular flat plate 3024, a plurality of narrow grooves 3030 are provided on a one-side surface or both-side surfaces of the flat plate surfaces so as to extend radially from the center. The radially extending narrow grooves 3030 converge integrally on the inner-diameter side of the annular flat plate 3024 so as to form a depression. Fig. 50 is an enlarged sectional view of an inner-diameter side portion of the annular flat plate 3024. The inner-diameter side portion of the annular flat plate 3024 is so formed that a portion within a specified radius from the center decreases in thickness to form a depression 3028, the depression 3028 serving as a start point of each narrow groove 3030 that extends therefrom radially to a specified length. The radially extending narrow grooves 3030 are each broadened circumferentially on both sides at their fore ends until those broadened ends do not adjoin circumferential breadths of their neighboring narrow grooves 3030. The configuration of the surface restrictor using the depression 3028 and the narrow grooves 3030 is given as an example only, and surface restrictors having other appropriate configurations may be adopted.

Such a depression 3028 and narrow grooves 3030 are provided so as to produce a throttling effect when the gas flows radially along the surface of the annular flat plate 3024. That is, with the flat-plate surface of the annular flat plate 3024 opposed to some other surface, when a gas flows through the clearance between the two surfaces to come into a state that the gas flowing through the depression 3028 and narrow grooves 3030 overflows at terminal ends of the narrow grooves 3030 or the like onto the flat surface, the gas passageways are narrowed and restricted, resulting in a so-called surface throttling. By an effect of this surface throttling, flows between the two surfaces are stabilized, so that the distance between the two surfaces is also stabilized.

In an example of dimensions of such an annular flat plate 3024, the outer diameter is about 30 mm to about 40 mm, the inner diameter is about 10 mm to 15 mm, the plate thickness is about 0.1 mm to about 0.2 mm or so, the depth of the depression 3028 and the narrow grooves 3030 is about 13 µm to about 17 µm, the radial width of the depression 3028 is about 2 mm to 4 mm or so, and the width of each narrow groove 3030 is about 0.2 mm or so. It is noted that the depth of the narrow grooves 3030 and the like are exaggeratedly enlarged in Figs. 48 and 49. Such an annular flat plate 3024 as shown above can be obtained by manifacture processing a metal disc of SUS or the like as an example.

The curved spring 3026 is a thin plate member interposed for connection between an inner-diameter side portion of the annular flat plate 3024 and an outer profile of the support shaft 3022, the curved spring 3026 being also a support member for supporting the flat-plate mover 3020 to the support shaft 3022. The curved spring 3026 has patterns of complicatedly sinuately curved configurations to form aperture-like openings among the patterns, allowing the gas to flow through the opening apertures. Also, the curved spring 3026 is so formed in its whole configuration that configurations of its radially extending portions and configurations of its circumferentially extending portions are combined so properly that the rigidity against displacement in the axial direction of the support shaft 3022 is smaller than the rigidity against displacement in the radial direction. Such a curved spring 3026 can be obtained by etching process of a metal thin plate into specified patterns. For example, the curved spring 3026 can be obtained by etching or electric discharge machining or the like of about 0.1 mm-thick SUS plate. In addition, the term 'curved spring' is only a designation coming from its configurational pattern being sinuately curved, similar to cloud shapes, and springs of other designations may be adopted if their rigidity in the axial direction is small while the rigidity in the radial direction is large.

More specifically, the annular flat-plate mover 3020, having the structure that the annular flat plate 3024 is supported to the support shaft 3022 via the curved spring 3026, is relatively easily movable in the axial direction of the support shaft 3022, but relatively less easily movable in the radial direction of the flat plate, i.e., in moving in directions vertical to the axial direction of the support shaft 3022, as a characteristic thereof. In other words, the flat-plate mover 3020 has a characteristic that with the axial direction of the support shaft 3022 assumed as a thrust direction, the flat-plate mover 3020 has a large degree of freedom in the thrust direction, its motions in the radial direction vertical thereto being restrained.

Actions of the minute displacement output device 3010 of the above structure, particularly actions of the flat-plate movers 3020 placed in array in plurality, will be described in detail below. When the minute displacement output device 3010 is put into operation, the minute displacement output device 3010 is placed on top of the base 3008 as shown in Fig. 46(c), and an unshown gas supply source is connected to the supply port 3002 of the base 3008, with the exhaust port opened to the atmospheric air. Preferably, the unshown gas supply source has a function of outputting a gas pressure controlled to an arbitrary value. Then, the gas having a controlled control gas pressure P_{S} to the supply port 3002 of the base 3008. The supplied gas having the gas pressure P_{S} passes through the intake port 3054, the gas passage 3055 and the gas supply port 3056, as well as a restrictor portion, in the bottom portion 3052 of the casing portion 3012 of the minute displacement output device 3010, so as to be supplied toward a plurality of flat-plate movers 3020.

Means for supplying gas to a plurality of flat-plate movers 3020 include the gas supply source provided outside the minute displacement output device 3010, the supply port in the minute displacement output device 3010, the restrictor portion, and flow passages associated with those members and the like. Thus, differentiated from the gas supply source provided outside the minute displacement output device 3010, the supply port in the minute displacement output device 3010, the restrictor portion, the flow passages associated with these, and the like can be called gas supply means in the minute displacement output device 3010.

As described above, the flat-plate movers 3020 are placed in array in plurality along the axial direction of the support shaft 3022 between the bottom face of the bottom portion 3052 of the casing portion 3012 and the bottom face of the output mover 3040. Accordingly, as the gas having the control gas pressure P_{S} is supplied from the gas supply port 3056 of the casing portion 3012 toward the plurality of flat-plate movers 3020, the gas flows through a clearance between the most fore-end side flat-plate mover 3020 and the gas-receiving surface of the output mover 3040, through clearances between adjacent flat-plate movers 3020, and through the most rear-end side flat-plate mover 3020 and the bottom face of the casing portion 3012.

In this case, the gas having the control gas pressure P_{S} passes from the bottom face of the casing portion 3012 through gas-passing-through apertures of the individual curved springs 3026 of the plurality of annular thin-plate movers 3020, then flowing through the individual clearances and thereafter flowing along the inner wall of the cylindrical portion 3050 of the casing portion 3012, so as to be released to the outside air from the exhaust port 3058 of the casing portion 3012. Since the curved springs 3026 are placed on the inner-diameter side of the flat-plate movers 3020, the gas having passed through the gas-passing-through apertures of the curved springs 3026 flows through the clearances from the inner-diameter side toward the outer-diameter side of the annular flat plate 3024. In this case, when the pushing force F acts toward the output mover 1104 by the thin plate 3016 of the cover portion 3014, flows of the gas flowing through these clearances exhibit actions as so-called gas bearings. That is, amounts of those clearances can be adjusted by controlling the control gas pressure P_{S} while balancing with the pushing force F, by which the flat-plate movers 3020 can be minutely moved in the axial direction of the support shaft 3022, i.e., in the Z direction.

For example, changing the control gas pressure P_{S} by +ΔP allows each clearance amount to be changed by +Δs, where a factor of Δs/ΔP can be empirically determined by giving a configuration of the annular flat plates, a clearance between adjacent annular flat plates, a control gas pressure P_{S}, a pushing force F and the like. In this case, the factor Δs/AP is determined for each clearance, and given a clearance count N, the axial move amount of the plural annular flat-plate movers 3020 as a whole results in NxΔs, so that the move amount can be adjusted by increasing or decreasing the number of annular flat-plate movers 3020.

Referring to one example, with the above-described size of the annular flat-plate movers 3020, given a nominal standard value of about 10 µm of the clearance in adjacency and a value P_{S} of about 0.2 MPa, then it can be attained that (clearance variation / gas pressure variation) = (5 µm / 0.1 MPa) or so. Since the thickness of each annular flat plate is about 0.1 mm to about 0.2 mm as described above, it follows that even with N = 30, the entire length of 29 flat-plate movers 3020 in the axial direction is about 2.9 mm to about 5.8 mm. Then, given a value of ΔP of 0.15 MPa, a move amount of about 220 µm can be given to the output mover 3040 and the transfer portion 3018 by the 29 flat-plate movers 3020. That is, a move amount of about 220 µm can be given to an entire length of several millimeters. Still, the move amount depends on Δs/ΔP and the controllability for gas pressure is quite high, so that the accuracy for the move amount can be maintained quite high over the full stroke.

In this case, the flat-plate movers 3020, each having a characteristic of being large in degree of freedom in the thrust direction and largely restrained in the radial direction, can be changed in their inclinations by following inclinations of the transfer portion 3018 and the output mover 3040 from the Y direction. That is, while following angle changes of the transfer portion 3018 and the output mover 3040, the flat-plate movers 3020 can transfer high-accuracy minute displacement ±Z, or the driving force necessary for the movement, via the transfer portion 3018 to the object 3006.

### [Example 7]

In the above case, the gas having the control gas pressure P_{S} is supplied by passing through gas-passing-through apertures of the individual curved springs 3026 of the flat-plate movers 3020, then flowing through the individual clearances from the inner-diameter side toward the outer-diameter side of the individual annular flat plates 3024. That is, the gas having the control gas pressure P_{S} is supplied from the inner-diameter side of the flat-plate movers 3020 so as to flow toward the outer-diameter side.

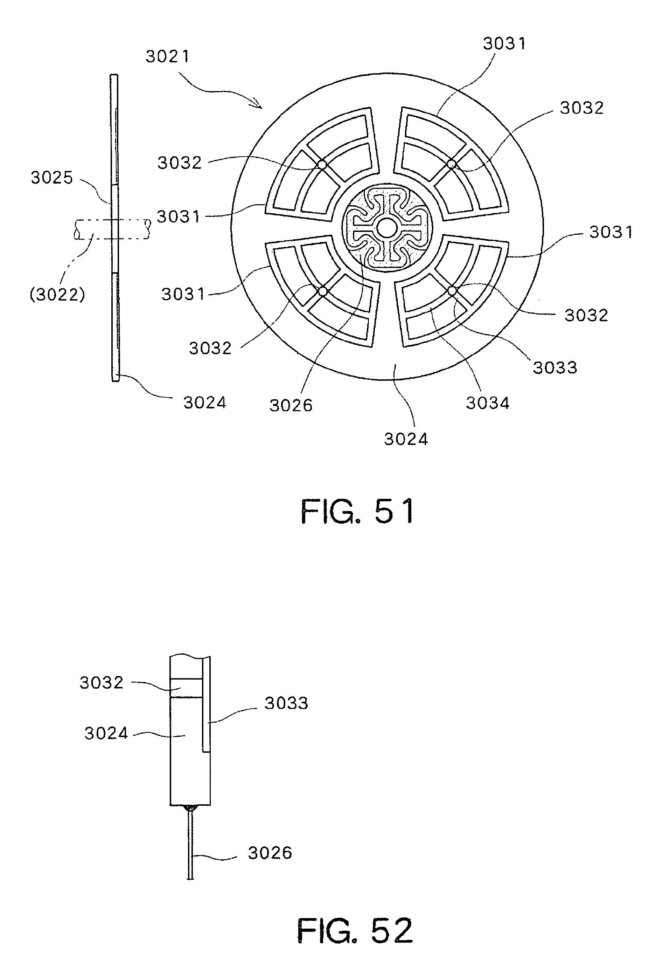

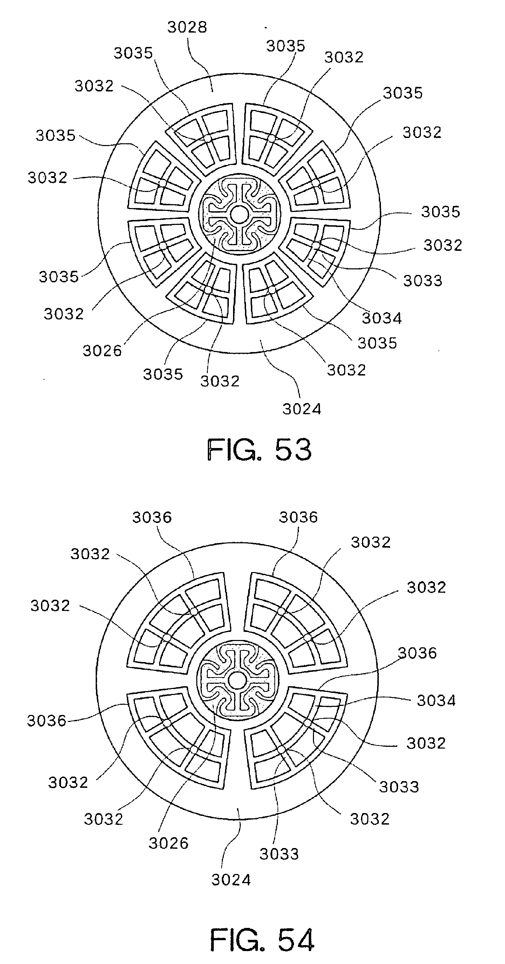

In addition to the above structure, supply of the gas having the control gas pressure P_{S} can also be fulfilled from an intermediate portion between the inner diameter and the outer diameter of the annular flat plate 3024 of each flat-plate mover. A front view and a side view of flat-plate mover 3021 of such a structure are shown in Fig. 51, and an enlarged sectional view of its inner-diameter side portion is shown in Fig. 52. Figs. 53 and 54 are modifications of the structure of Fig. 51. Like component members in conjunction with Figs. 49 and 50 are designated by the same reference numerals and their detailed description is omitted.

In the flat-plate mover 3021 shown in this case, gas-passing-through apertures 3032 to which the gas is supplied are provided in plurality not at the curved springs 3026 but in an intermediate region between the inner diameter and the outer diameter of the annular flat plates 3024. More specifically, in a region between the inner diameter and the outer diameter of the annular flat plate 3024, narrow-groove patterns 3031 each having a generally four-adjoining-quadrilateral planar shape are provided by combining together a plurality of radially extending narrow grooves 3030 and a plurality of circumferentially extending narrow grooves 3034, and a gas-passing-through aperture 3032 is placed at a central portion of each of the narrow-groove patterns 3031. That is, referring to Fig. 51, each of the four-adjoining-quadrilateral narrow-groove patterns 3031 is so formed that radially extending two narrow grooves 3033 and circumferentially extending two narrow grooves 3034 are connected together to form one closed narrow-groove loop, while radially extending one narrow groove 3033 and circumferentially extending one narrow groove 3034 are intersected crisscross by each other so as to be placed within the narrow-groove loop. Then, a gas-passing-through aperture 3032 is placed at the crisscross-intersecting point.

In the case of Fig. 51, the four-adjoining-quadrilateral narrow-groove patterns 3031 are provided four in number in an intermediate region between the inner diameter and the outer diameter of the annular flat plate 3024 so as to be equidistantly spaced from one another along the circumferential direction. Then, the gas-passing-through apertures 3032 are provided in one-to-one correspondence to the narrow-groove patterns 3031, respectively. The depth and width of each narrow groove 3033, 3034 constituting the narrow-groove patterns 3031 can be made equal to those of the narrow grooves 3030 described in Figs. 49 and 50. The configuration and size of each gas-passing-through aperture 3032 can be determined as appropriate, where a through hole having a diameter of several millimeters may be adopted as an example.

Desirably, the placement of the gas-passing-through apertures 3032 in each of the flat-plate movers 3021 is such that when each flat-plate mover 3021 is attached to the support shaft 3022, adjacent flat-plate movers 3021 have their corresponding gas-passing-through apertures 3032 generally coincident in position therebetween. Doing so the gas having the control gas pressure P_{S} to pass from the gas supply port 3056 of the casing portion 3012 through the individual gas-passing-through apertures 3032 so as to be supplied to the individual clearances. The gas supplied to the clearances flows from the gas-passing-through apertures 3032 along the narrow grooves 3033, 3034, at which the gas flow is diverged into one flow that runs through the clearance between adjacent flat-plate movers 3021 toward the inner-diameter side of the flat-plate mover 3021 and another flow that runs through the clearance between adjacent flat-plate movers 3021 toward the outer-diameter side. The former one is exhausted through the gas-passing-through apertures of the curved springs 3026, while the latter is exhausted from the outer circumference of the flat-plate movers 3021.

The number of placement of the four-adjoining-quadrilateral narrow-groove patterns having the gas-passing-through apertures 3032 is not limited to four. For example, Fig. 53 shows an example in which eight four-adjoining-quadrilateral narrow-groove patterns 3035 are placed in an intermediate region between the inner diameter and the outer diameter of the annular flat plate 3024. Also, a plurality of gas-passing-through apertures 3032 may be provided in each narrow-groove pattern. For example, Fig. 54 shows an example in which crisscross intersecting two narrow grooves are provided in one narrow-groove loop to form a multiple-quadrilateral-shaped narrow-groove pattern 3036, where two gas-passing-through apertures 3032 are provided in each one narrow-groove pattern 3036.

As the gas-passing-through apertures 3032, to which the gas is supplied, are provided in the intermediate region between the inner diameter and the outer diameter of the annular flat plate 3024, the structure of the casing portion 3012 of the minute displacement output device 3010 is changed. That is, the gas supply port 3056 provided in the bottom face of the bottom portion 3052 of the casing portion 3012 is placed in correspondence to the position of the gas-passing-through apertures 3032. Then, as to the exhaust port 3058, in addition to the one opened toward the inner wall of the cylindrical portion 3050 of the casing portion 3012, those which are opened in correspondence to the positions of the gas-passing-through apertures of the curved springs 3026 are provided, in which case these are connected inside to one another to form one or two or more exhaust ports 3058.

Also with the use of the flat-plate mover 3021 of the above structure, functions and effects similar to those of the minute displacement output device 3010 described in Fig. 46 and the like can be obtained. That is, by adjusting the control gas pressure P_{S}, high-accuracy minute displacement ±Z, or the driving force necessary for the movement, can be transferred via the transfer portion 3018 to the object 3006.

### [Example 8]

Next, a case in which thin-plate movers and flat-plate moveres alternately placed are used as the movers for generating minute displacements is described.

Described below as the thin-plate mover is an annular thin-plate mover using an annular thin plate which has a circular external shape and in which a hole fitting to a support shaft is provided at its center. However, the thin-plate mover has only to be a thin plate having such a thickness as to allow narrow, elongate grooves to be machined through in the plate-thickness direction, and may be other than circular-shaped in its external shape. That is, the thin-plate mover has only to be a thin plate enough thinner in plate thickness than the groove width and may be a thin plate having, for example, a polygonal external shape or an elliptical external shape or a curved-surface external shape. The support structure between the thin-plate mover and the support shaft, although explained below as a relation between a circular hole and a round bar, yet may also be other than that. It is possible, for example, that while the support shaft is a round bar, the external shape of the support shaft is formed into a polygonal shape and the support hole for the thin-plate mover is formed into a polygonal hole corresponding thereto as the support structure. Doing so makes it easier to suppress the rotation around the support shaft. Of course, the axial cross-sectional shape of the support shaft may be formed into a shape other than polygonal shapes, e.g., an elliptical shape.

The same applies also to a flat-plate mover to be used in combination with the thin-plate mover. That is, described below as the flat-plate mover is an annular flat-plate mover using an annular flat plate which has a circular external shape and in which a hole fitting to a support shaft is provided at its center. However, the flat-plate mover has only to be similar in external shape to the thin-plate mover without being limited to circular external shapes. The flat-plate mover may be a flat plate having, for example, a polygonal external shape or an elliptical external shape or a curved-surface external shape. The support structure between the flat-plate mover and the support shaft, although explained below as a relation between a circular hole and a round bar, yet has only to be similar to the support structure between the thin-plate mover and the support shaft and so may be other than that. It is possible, for example, that while the support shaft is a round bar, the external shape of the support shaft is formed into a polygonal shape and the support hole for the flat-plate mover is formed into a polygonal hole corresponding thereto as the support structure. Doing so makes it easier to suppress the rotation around the support shaft. Of course, the axial cross-sectional shape of the support shaft may be formed into a shape other than polygonal shapes, e.g., an elliptical shape.

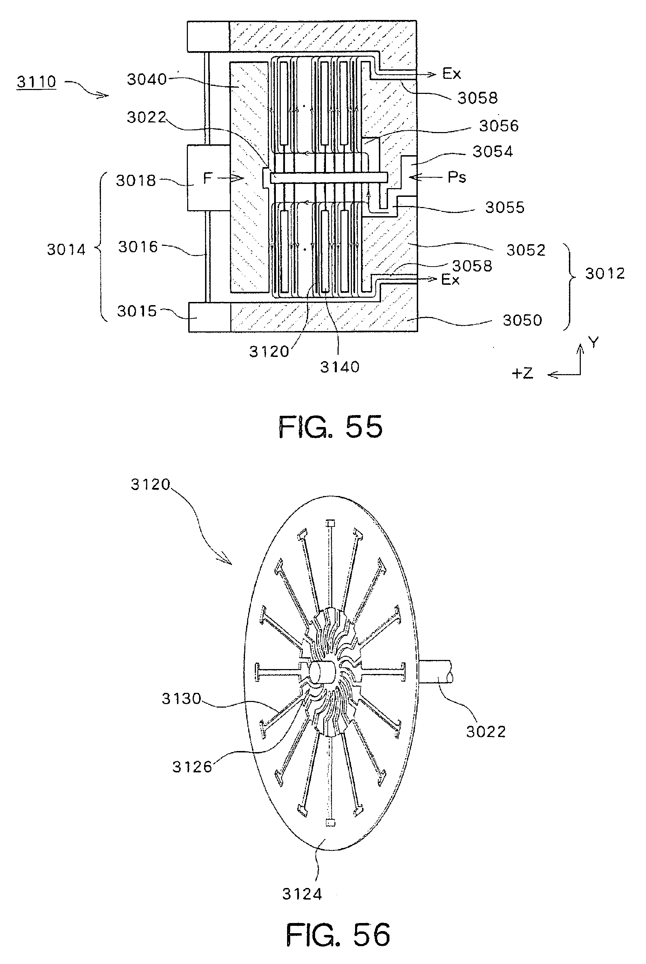

Fig. 55 is an enlarged sectional view of a minute displacement output device 3110 in which thin-plate movers and flat-plate movers alternately placed are used. Like component members in conjunction with Figs. 46 and 47 are designated by the same reference numerals and their detailed description is omitted. As can be seen from a comparison of Fig. 55 with Fig. 46, the minute displacement output device 3110 includes thin-plate movers 3120 and flat-plate movers 3140 alternately placed instead of the plurality of flat-plate movers 3020 of the minute displacement output device 3010 of Fig. 46. The rest of component members of the minute displacement output device 3110 are unchanged. Therefore, the following description will be focused mainly on contents of the thin-plate movers 3120 and the flat-plate movers 3140.

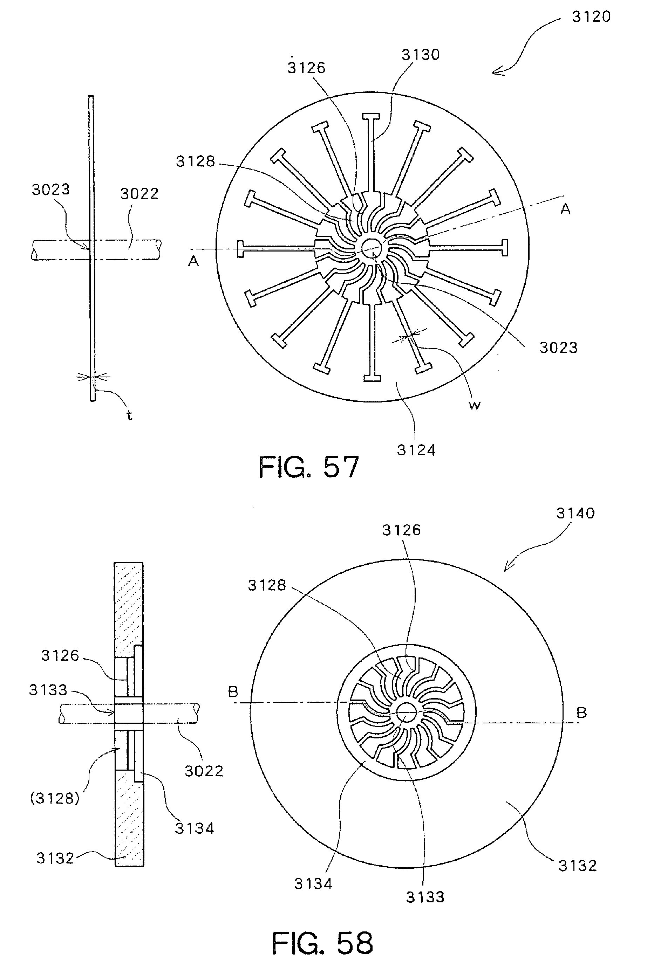

A detailed structure of the thin-plate mover 3120 is shown in the perspective view of Fig. 56 as well as in the front view and the side view of Fig. 57. The thin-plate mover 3120, being a mover to be supported by the support shaft 3022, includes an annular thin plate 3124 and a plurality of wavy- or curved-shaped flexible arms 3126. Apertures 3128 between adjacent flexible arms 3126 are spaces through which the gas flows up. Further, the annular thin plate 3124 is supported with its thin plate surface vertical to the axial direction of the support shaft 3022.

The annular thin plate 3124 is a toroidal member having a concentric circular opening 3023 at a central portion of the circular thin plate. The support shaft 3022 is fitted to the opening 3023 in the central portion. In the annular thin plate 3124, a plurality of narrow grooves 3130 are provided so as to extend radially from the center. The radially extending narrow grooves 3130 start from the apertures 3128, each extending therefrom in the radial direction to a specified length. The radially extending narrow grooves 3130 are each broadened circumferentially on both sides at their fore ends until those broadened ends do not adjoin circumferential breadths of their neighboring narrow grooves 3130. Thus, the narrow grooves 3130 are ended grooves formed through the annular thin plate 3124 in its plate-thickness direction, i.e., to pass through the thin plate from its top to bottom. These narrow grooves 3130 are not merely openings but flow passages having proper flow resistance to the gas while the gas flows therethrough.

In an example of dimensions of such an annular thin plate 3124, the outer diameter is about 30 mm to about 40 mm, the diameter of its boundary with the flexible arms 3126 is about 10 mm to 15 mm, the plate thickness t is about 0.01 mm to about 0.05 mm or so, and the width w of each narrow groove 3130 is about 0.01 mm to about 0.3 mm or so. In addition, the diameter of the support shaft 3022 may be set to several millimeters or so. Such an annular thin plate 3124 as shown above can be obtained by press working or etching on a metal disc of SUS or the like as an example. The plate thickness t of the annular thin plate 3124 can be determined depending on bearing characteristics such as clearances of surfaces to both sides of the annular thin plate 3124.

The plurality of flexible arms 3126 are thin plate members each interposed for connection between an inner-diameter side portion of the annular thin plate 3124 and an outer profile of the support shaft 3022, each of the flexible arms 3126 being also a thin-plate spring member for supporting the annular thin-plate mover 3120 to the support shaft 3022. The flexible arms 3126 have patterns of wavily curved configurations to form aperture-like openings among the patterns, allowing the gas to flow through the apertures 3128. Also, the flexible arms 3126 are so formed in their wavy-shaped width and configuration or the like that the rigidity against displacement in the axial direction of the support shaft 3022 is smaller than the rigidity against displacement in the radial direction. Such flexible arms 3126 can be obtained by etching process of a metal thin plate into specified patterns. For example, the flexible arms 3126 can be obtained by etching or electric discharge machining or the like on about 0.01 to 0.05 mm-thick SUS plate. In addition, the flexible arms 3126 may be formed into a shape other than wavy shapes, whatever shape it is, if the flexible arms have such a spring characteristic of being smaller in rigidity in the axial direction and larger in rigidity in the radial direction. For example, so-called curved-spring shapes may be used. The term 'curved spring' means a sinuately curved shape similar to cloud shapes, and contriving sinuately curved shapes can give a shape having a spring characteristic that the rigidity is small in the axial direction and large in the radial direction.

More specifically, the thin-plate mover 3120, having the structure that the annular thin plate 3124 is supported to the support shaft 3022 via a thin-plate spring that is the plurality of flexible arms 3126, is relatively easily movable in the axial direction of the support shaft 3022, but relatively less easily movable in moving in the radial direction of the thin plate, i.e., in moving in directions vertical to the axial direction of the support shaft 3022, as a characteristic thereof. In other words, the thin-plate mover 3120 has a characteristic that with the axial direction of the support shaft 3022 assumed as a thrust direction, the thin-plate mover 3120 has a large degree of freedom in the thrust direction, its motions in the radial direction vertical thereto being restrained.

The flat-plate movers 3140 are movers having a function of serving as gas-receiving surfaces for receiving flows of the gas flowing on both sides of the thin-plate mover 3120 in the placement that a plurality of the thin-plate movers 3120 are arrayed along the axial direction of the support shaft 3022. Fig. 58 includes a plan view of the flat-plate mover 3140 and a sectional view taken along the line B - B of the plan view. The flat-plate mover 3140, which is a mover supported by the support shaft 3022, includes an annular flat plate 3132 and a plurality of wavy- or curved-shaped flexible arms 3126. Apertures 3128 between adjacent flexible arms 3126 are spaces through which the gas flows up. Further, the annular flat plate 3132 is supported with its flat plate surface vertical to the axial direction of the support shaft 3022. The flexible arms 3126 are thin-plate springs similar in structure to the flexible arms 3126 included in the thin-plate movers 3120, and apertures 3128 are openings between adjacent flexible arms 3126 also as in the apertures 3128 of the thin-plate movers 3120.

The annular flat plate 3132 is a toroidal member having a concentric circular opening 3133 at a central portion of the circular flat plate. The support shaft 3022 is fitted to the opening 3133 in the central portion. The flexible arms 3126 are provided on the outer circumferential side of the opening 3133. Further on the outer peripheral side of the flexible arms 3126, an annular depression 3134 is provided. The depression 3134 is so provided as to produce a throttling effect when the gas flows from the apertures 3128 on the inner circumference side of the annular flat plate 3132 radially along the surface of the annular flat plate 3132. By providing this depression 3134, flows through the clearances between adjacent annular flat plates and annular thin plates are stabilized, making amounts of those clearance stabilized, so that the bearing rigidity suggesting the power of resistance on action of external force is improved, with the so-called positionability improved. The depression 3134 has a function as a gas-introducing portion serving for the gas to flow from the apertures 3128 toward the outer peripheral side. This gas-introducing portion may be formed into a stepped shape thinner in plate thickness than the outer peripheral portion or a tapered shape that increases in plate thickness from the inlet portion of the apertures 3128 toward the outer peripheral portion. In addition, the depression 3134 does not need to be provided depending on the specifications of the gas pressure control actuator.

Planar dimensions of such an annular flat plate 3132 may differ from those of the thin-plate movers 3120 in terms of outer diameter, flexible arms, and support shaft dedicated opening, but preferably those planar dimensions are desirably the same as those of the thin-plate movers 3120. That is, preferably, the outer diameter is about 30 mm to about 40 mm, and the diameter of the boundary against the flexible arms 3126 is about 10 mm to 15 mm. No narrow grooves of the thin-plate movers 3120 are provided in the annular flat plate 3132. The annular flat plate 3132 needs to have such a plate thickness, as a plate material, as not to be flexed even upon reception of the gas pressure. In the above planar dimensions, for example, the plate thickness may be about 0.1 mm or so. Of course, the plate thickness may be other than that. Such an annular flat plate 3132 as shown above can be obtained by press working or machining on a metal material of SUS or the like into a specified shape as an example.

Assuming that the thin-plate spring portion including the plurality of flexible arms 3126 in the flat-plate mover 3140 is the same as in the thin-plate movers 3120, the plate thickness t is about 0.01 mm to about 0.05 mm as described above. Therefore, the annular flat plate 3132, and the thin-plate spring portion including the plurality of flexible arms 3126, can be manufactured independently of each other, and integrated together by some proper bonding technique to make up the flat-plate mover 3140. Needless to say, with a metal material such as SUS, the annular flat plate 3132 and the flexible arm 3126 portion can be machined integrally by using etching technique or the like to obtain the flat-plate mover 3140.

As shown above, the flat-plate mover 3140 is a flat-plate mover which is supported by the support shaft 3022 with its flat surface vertical to the support shaft 3022 and via the flexible arms 3126 which are support members smaller in displacement rigidity in the axial direction of the support shaft 3022 than in the radial direction, the flat-plate mover 3140 having apertures 3128 provided on its inner circumferential side so that gas is allowed to flow therethrough. With the use of this structure, a plurality of the thin-plate movers 3120 can be placed along the axial direction of the support shaft 3022, so that adjustment widths of the minute clearances can be increased in response to the number of the thin-plate movers 3120.

More specifically, clearance adjustment with the use of ended narrow grooves 3130 in the thin-plate movers 3120 involves a wall surface for forming clearances, i.e. gas-receiving surface, on both front and rear sides of each thin-plate mover 3120. Accordingly, the thin-plate mover 3120 and the flat-plate mover 3140 are alternately placed along the axial direction of the support shaft 3022, where flat-plate movers 3140 are provided on necessary sides of the thin-plate movers 3120, respectively. Since the flat-plate movers 3140 each have a flat-plate surface, combining this flat-plate surface and each thin-plate mover 3120 allows a gas-receiving surface for formation of clearances to be placed on both front and rear sides of each thin-plate mover 3120. As a result of this, a minute clearance amount that can be controlled by gas pressure can be set for each of the thin-plate movers 3120, so that the move amount as a whole can be increased in response to the number of thin-plate movers 3120 placed in array on the support shaft 3022.

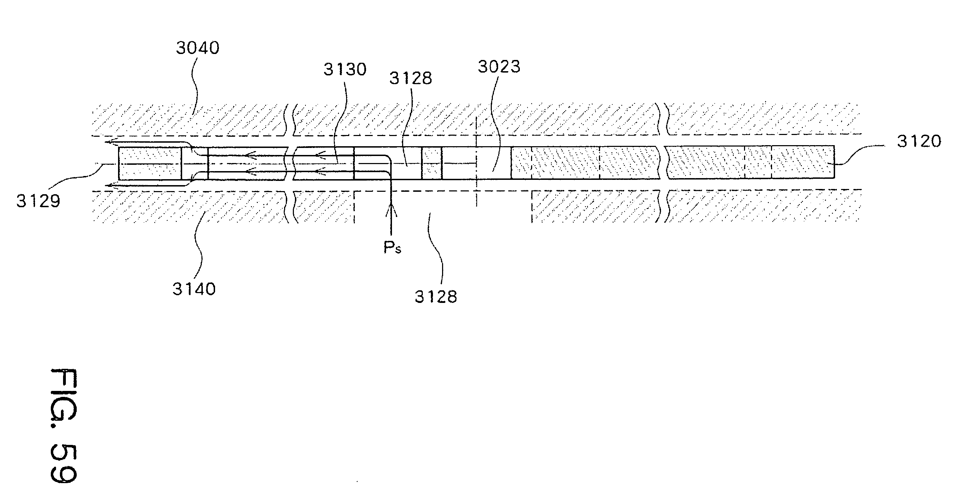

Fig. 59 is a view for explaining a flow of gas associated with the thin-plate mover 3120, being a sectional view taken along the line A - A of Fig. 57. In Fig. 59, the thin-plate mover 3120 is positioned lateral, while the flat-plate movers 3140 is depicted below, and the output mover 3040 above, as viewed in the drawing sheet. This placement is an example of explanation, and of course, flat-plate movers 3140 may be placed on both sides of the thin-plate mover 3120, or the bottom portion 3052 of the casing portion 3012 may be placed below the thin-plate mover 3120, to either of which cases the following description similarly applies.

Referring to Fig. 59, the gas having the control gas pressure P_{S} supplied from the aperture 3128 of the flat-plate mover 3140 toward the thin-plate mover 3120 enters into the aperture 3128 of the thin-plate mover 3120, passing along the narrow groove 3130 therefrom, coming up against an outer-circumferential end portion, going out of the thin-plate mover 3120 thereat, and flowing outside through a clearance between the front side of the thin-plate mover 3120 and the output mover 3040 as well as a clearance between the rear side of the thin-plate mover 3120 and the flat-plate mover 3140.

It is noted that the clearance between the thin-plate mover 3120 and the output mover 3040, as well as the clearance between the thin-plate mover 3120 and the flat-plate mover 3140, although actually within a range of about several µm to several tens of µm, are shown exaggeratedly broadened. In the above example, since the plate thickness of the thin-plate mover 3120 is about 0.01 mm to about 0.05 mm or so, a surface throttling effect is produced between the narrow groove 3130 and the clearance, so that the thin-plate mover acts as a bearing.

In more detail for this function, assuming a virtual boundary 3129 at an intermediate position in the depthwise direction of the narrow groove 3130, gases flow on both the output mover 3040 side and the flat-plate mover 3140 side respectively and symmetrically with the virtual boundary 3129 interposed therebetween. On the output mover 3040 side, which is on one side of the virtual boundary 3129, the gas flows through a clearance between the virtual boundary 3129 and the output mover 3040, i.e., through a narrow clearance that is actually an upper half of the narrow groove 3130 having a thickness corresponding to 1/2 of the plate thickness of the thin-plate mover 3120. Similarly, the gas flows through a clearance on one side of the virtual boundary 3129 against the flat-plate mover 3140, i.e., through a narrow clearance that is actually a lower half of the narrow groove 3130 having a thickness corresponding to 1/2 of the plate thickness of the thin-plate mover. In other words, with the virtual boundary 3129 taken as a mirror image plane, two flows flow symmetrically. Since the virtual boundary 3129 does not change from a fluidic point of view, gas bearing actions are fulfilled by the gas flowing through the clearance between the virtual boundary 3129 and the output mover 3040, as well as the gas flowing through the clearance between the virtual boundary 3129 and the flat-plate mover 3140, respectively.

The gas bearing action allows the clearance amount to be controlled by the gas pressure of the supplied gas, so that minute movement can be fulfilled. Therefore, with gas-receiving surfaces provided on both front and rear sides of the thin-plate mover 3120 having the narrow grooves 3130 that run top to bottom through the thin plate, and by controlling the gas pressure P_{S} of the gas flowing through the clearances between the gas-receiving surfaces and the thin-plate mover 3120, those clearance amounts can be adjusted. Accordingly, with the thin-plate mover 3120 and the flat-plate mover 3140 alternately placed and by controlling control gas pressures P_{S} of the gas flowing through a plurality of clearances, displacements corresponding to the number of clearances can be obtained.

In this case, changing the control gas pressure P_{S} by +ΔP allows each clearance amount to be changed by +As, where given a clearance count N, the axial move amount as a whole becomes NxΔs. These circumstances, including the relation of Δs/ΔP and the like, are the same as described in conjunction with the minute displacement output device 3010 of Figs. 46 and 47.

### [Example 9]

As described in conjunction with Fig. 47, the cover portion 3014 includes a ring portion 3015 that can be integrated with the cylindrical portion 3050 of the casing portion 3012, a disc-shaped transfer portion 3018 placed at a center, and a membrane-like thin plate 3016 formed of an elastic material for connecting the ring portion 3015 and the transfer portion 3018 to each other. Therefore, combining the casing portion 3012 and the cover portion 3014 together allows the internal space maintained air tightness except the intake port 3054 and the exhaust port 3058. In this case, since the exhaust port 3058 is opened to the outside air as it is, gas pressures applied to both sides of the membrane-like thin plate 3016 are of nearly the same level, so that the membrane-like thin plate 3016, free from any initial displacement due to a difference in gas pressure between the two sides of the thin plate, is normally in a neutral position. In this case, providing a proper exhaust valve at the exhaust port 3058 allows an initial displacement to the membrane-like thin plate 3016.

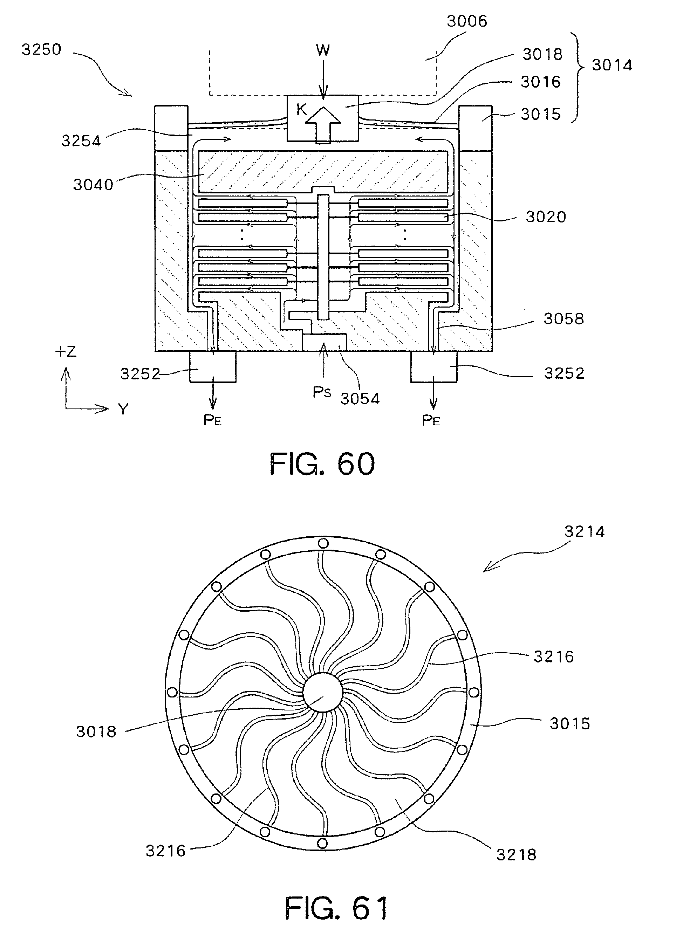

Fig. 60 is a view showing a state of a minute displacement output device 3250 with an exhaust valve 3252 provided at the exhaust port 3058. In Fig. 60, the minute displacement output device 3250 is shown under the condition that the Z direction, i.e., a direction in which a load of the object 3006 is applied, is assumed as an up-and-down direction of the drawing sheet, where this placement method differs from Figs. 47 and 55 by an angle of 90 degrees. Like component members in conjunction with Fig. 47 are designated by the same reference numerals and their detailed description is omitted. Compared with the minute displacement output device 3010 described in Fig. 47, this minute displacement output device 3250 differs in that the exhaust valve 3252 is provided at the exhaust port 3058.

The exhaust valve 3252 is a gas valve for regulating an exhaust gas pressure P_{E} of an exhausted gas. The exhaust gas pressure P_{E} is set to a gas pressure higher than an outside gas pressure. For example, when a gas pressure P_{O} outside the membrane-like thin plate 3016 is the atmospheric pressure, the exhaust gas pressure P_{E} is set to a gas pressure higher than the atmospheric pressure. Also, with the minute displacement output device 3250 used under a reduced present or vacuum, when the gas pressure outside the membrane-like thin plate 3016 is lower than the atmospheric pressure, the exhaust gas pressure P_{E} is set to a gas pressure higher than the reduced gas pressure. By setting the exhaust gas pressure P_{E} of the exhaust valve 3252 higher than the outside gas pressure P_{O}, the gas pressure of a space 3254 inside the membrane-like thin plate 3016 becomes nearly equal to the exhaust gas pressure P_{E}, where because of the outside gas pressure P_{O} outside the membrane-like thin plate 3016, there occurs a differential pressure between inside and outside of the membrane-like thin plate 3016. By this differential pressure ΔP = P_{E}-P_{O}, the membrane-like thin plate 3016 undergoes a force K for outward expansion and deformation, being initially displaced. The force K can be calculated as K = A×ΔP, where A represents the pressure receiving area of the membrane-like thin plate 3016.

As shown above, setting the exhaust gas pressure P_{E} causes the membrane-like thin plate 3016 to be subjected to the outward force K so as to be initially displaced. That is, without the load 3006 applied to the transfer portion 3018, the bottom face side of the transfer portion 3018 is separate from the top face side of the output mover 3040. In other words, this state is a state in which the membrane-like thin plate 3016 is outwardly biased by the force K corresponding to an initial deformation. Then, when the load 3006 is applied to the transfer portion 3018, a magnitude W of the load 3006 is received by the biasing force K. Thereafter, by a difference between the magnitude W of the load 3006 and the biasing force K, the membrane-like thin plate 3016 is deformed, causing the transfer portion 3018 to sink in the -Z direction into contact with the top face of the output mover 3040, being further pressed toward the -Z direction. As a result, a pushing force can be imparted to clearances between adjacent flat-plate movers 3020 and the like.

Thus, since an initial displacement or biasing force K is preliminarily imparted to the transfer portion 3018 that receives the object 3006, which is the load, in the cover portion 3014, the object 3006, which is the load, can be prevented from being abruptly applied to the output mover 3040. Therefore, the flat-plate movers 3020 can be prevented from damage that can occur due to any abrupt load.

In Fig. 60, the above description has been made on the assumption that a plurality of flat-plate movers 3020 are used. However, instead of the plurality of flat-plate movers 3020, the structure in which thin-plate movers 3120 and flat-plate movers 3140 are combined together, as has been described in Fig. 55, may also be adopted.

### [Example 10]

The above description has been given on the assumption that the cover portion 3014 includes the ring portion 3015 that can be integrated with the cylindrical portion 3050 of the casing portion 3012, the disc-shaped transfer portion 3018 placed at a center, and the membrane-like thin plate 3016 formed of an elastic material for connecting the ring portion 3015 and the transfer portion 3018 to each other. Instead, as the member for connection between the ring portion 3015 and the transfer portion 3018, the membrane-like thin plate may be replaced with an elastic member which is smaller in rigidity against displacement in the moving axis direction of the transfer portion 3018 than in the radial direction. Fig. 61 is a view showing a cover portion 3214 in which the connection between the ring portion 3015 and the transfer portion 3018 is implemented by a plurality of flexible arms 3216.

In this case, the cover portion 3214, even if integrated with the casing portion, has no air tightnesss. That is, the gas is released outside by passing through the spaces 3218 between a plurality of flexible arms 3126. Thus, there is no need for providing the exhaust portion in the casing portion 3012.

### 5. Gas pressure control actuator including magnetic-field generation coil and others

In the foregoing description, flat-plate movers, thin-plate movers and the like, when used in plurality, are attached to the support shaft in their array placement. If the flat-plate movers, the thin-plate movers and the like are formed of magnetic material and placed in the magnetic field, these members, when going to be out of the magnetic field, are pulled back by the magnetic field, so that these members can be placed in array without using the support shaft.

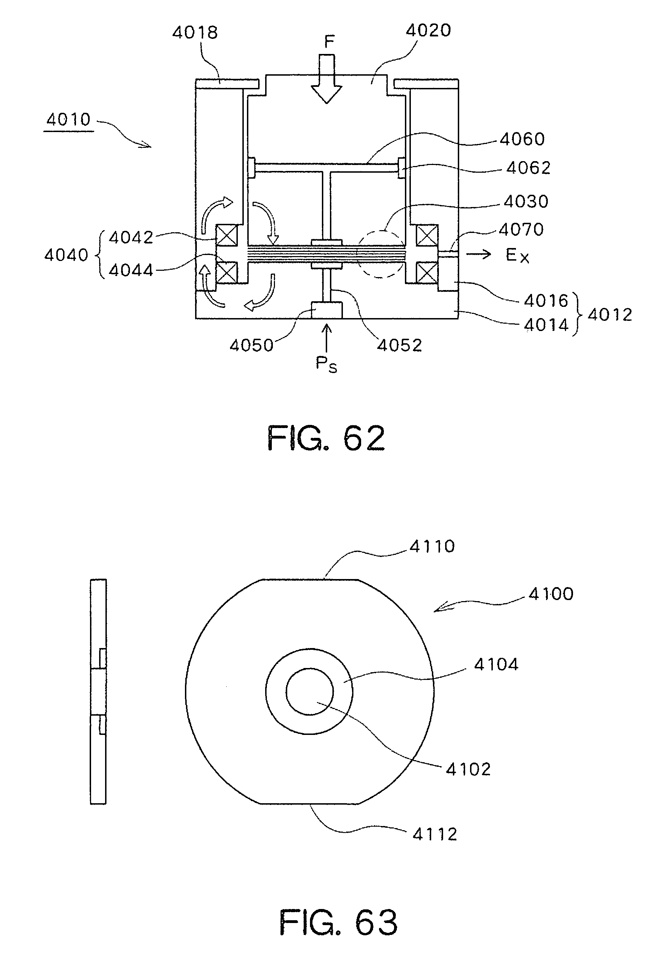

Fig. 62 is a view showing a structure of a gas pressure control actuator 4010 in which a plurality of flat-plate movers are set in a magnetic field and placed in array by restricting force of the magnetic field, with the support shaft omitted.

In this case, the gas pressure control actuator 4010 is so structured that a guide portion 4012, an output mover 4020, and a plurality of intermediate movers 4030 are each formed of magnetic material while a magnetic-field generation coil 4040 is provided at the guide portion 4012. As a result, a magnetic field is formed in a magnetic circuit indicated by blanked arrows in Fig. 62 together with the guide portion 4012, the output mover 4020 and a plurality of intermediate movers 4030, so that the intermediate movers are arrayed along the center axis of the guide portion 4012 by the restricting force of the magnetic field.

The guide portion 4012, including a bottom face portion 4014 and a cylindrical portion 4016 having a forward opening 4016, is formed of SUS (Stainless steel), which is a magnetic material. An inner wall portion of the cylindrical portion 4016 is bored in a cylindrical shape, but as described later, since the intermediate movers 4030 have an external shape for detent use, the inner wall portion of the cylindrical portion 4016 is provided with a detent-shape portion corresponding to the external shape of each intermediate mover 4030. The guide portion 4012 does not need to be entirely formed of magnetic material, but at least portions constituting the magnetic circuit is formed of magnetic material. It is noted here that the term, surface restrictor clearance, refers to a clearance that produces a surface throttling effect that the flow is stabilized as the clearance between confronting surfaces is restricted from wider to narrower one.

The output mover 4020 is a cylindrical member which is movably guided in the axial direction by the guide portion 4012 and which has a function of giving a propulsive force or the like to a moving object or the like by a protruding portion of the cylindrical member protruding from the guide portion 4012 to thereby minutely move the moving object. The output mover 4020 is formed also of SUS or the like, which is a magnetic material. The output mover 4020 does not need to be entirely formed of magnetic material, but at least portions constituting the magnetic circuit is formed of magnetic material. Magnetic materials other than SUS are of course usable.

Between the output mover 4020 and the bottom face portion 4014 of the guide portion 4012 are placed a plurality of intermediate movers 4030. Each of the intermediate movers 4030 has an aperture for allowing gas to pass therethrough. The intermediate movers 4030 are formed from SUS or the like, which is a magnetic material. Magnetic materials other than SUS are of course usable. Details of the intermediate movers 4030 will be described later.

Then, the magnetic-field generation coil 4040 is placed at the cylindrical portion 4016 of the guide portion 4012. The magnetic-field generation coil 4040, which is a conductor wire wound a plurality of times in a toroidal shape so as to surround the outer periphery of an intermediate mover 4030, has a function of generating a magnetic field of a proper magnitude by an unshown exciting circuit. The size of the magnetic-field generation coil 4040 is so set as to form a magnetic field in a direction along a center axis of the plurality of intermediate movers 4030. That is, the magnetic field generated by the magnetic-field generation coil 4040, as indicated by circulating hollow arrows in Fig. 62, circulates over the cylindrical portion 4016 of the guide portion 4012, the output mover 4020, the plurality of intermediate movers 4030, the bottom face portion 4014 of the guide portion 4012 and the cylindrical portion 4016 of the guide portion 4012, thus constituting a magnetic circuit.

As a result, a magnetic field flows through the intermediate movers 4030 along their center axis, so that when the intermediate movers 4030 tend to shift outward, a force acts to pull them back toward the center axis side by restricting force of the magnetic field. Therefore, it is implementable to array the intermediate movers 4030 along their center axis, i.e. the center axis of the guide portion 4012, without using any array means such as the support shaft.

A supply port 4050 to which supply gas pressure P_{S} is supplied is provided in the bottom face portion 4014 of the guide portion 4012, and gas having a controlled gas pressure P_{S} is supplied via a gas supply passage 4052 to the intermediate movers 4030. The supplied gas is discharged outside through an exhaust port 4070 provided in the cylindrical portion 4016 of the guide portion 4012.

As a result of this, the gas is supplied to a clearance between a fore-end face of the output mover 4020 and a one-side flat-plate surface of an intermediate mover 4030 confronting the fore-end face, to clearances between adjacent intermediate movers 4030, and to a clearance between the bottom face portion 4014 of the guide portion 4012 and the other-side flat-plate surface of an intermediate mover 4030 confronting the bottom face portion. That is, the supply port 4050, the gas supply passage 4052 and the exhaust port 4070 correspond to the gas supply means. Preferably, proper restrictor means are set at proper places on the supply port 4050 and the gas supply passage 4052.

In addition, the gas supplied from the gas supply passage 4052 to the intermediate movers 4030 goes toward the exhaust port 4070 while partly flowing via a flow passage 4060 provided inside the output mover 4020 so as to be partly jetted out through a jet opening 4062 provided in a cylindrical outer peripheral portion of the output mover 4020 toward an inner wall surface of the cylindrical portion 4016 of the guide portion 4012. As a result, a gas bearing action occurs between the cylindrical outer peripheral portion of the output mover 4020 and the inner wall surface of the cylindrical portion 4016 of the guide portion 4012, so that the output mover 4020 can be smoothly moved and supported in the axial direction.

A pushing force F as a reaction force is applied from a moving or drive object to the output mover 4020. The direction of the pushing force F is a direction toward the bottom face portion 4014 of the guide portion 4012. Accordingly, by this pushing force F, the intermediate movers 4030 and the output mover 4020 are pushed while the gas is compressed in the individual clearances so that the level of the supply gas pressure P_{S} is controlled, by which the clearance amounts are adjusted while being balanced with the pushing force F to achieve minute movement of the output mover 4020. Thus, the object confronting the output mover 4020, to which a propulsive force is given, can be minutely moved. In addition, a proper stopper 4018 is provided so as to prevent the output mover 4020 from being excessively moved.

The magnetic-field generation coil 4040 is connected to an unshown exciting circuit. The exciting circuit is subject to control of an exciting current by a control section that controls operations of the gas pressure control actuator 4010. With the exciting current varied, the intensity of the magnetic field flowing through the magnetic circuit is varied, by which individual clearance amounts to which the gas is supplied can be varied. That is, increasing the exciting current to intensify the magnetic field causes the individual clearance amounts to be narrowed, and conversely decreasing the exciting current causes the clearance amounts to be broadened.

The varying method for the exciting current may be either DC-method or AC-method variation. The DC-method variation means varying the level of a DC exciting current while the AC-method variation means varying the amplitude of AC current having an arbitrarily set specified frequency. The frequency may be set, for example, to several kHz or the like. Varying the exciting current in the DC method allows a center value of the clearance amounts to be varied. That is, the center value of the clearance amounts can be varied depending on the level of a DC exciting current. Varying the exciting current in the AC method allows the clearance amounts to be periodically increased or decreased about the center value of the clearance amounts while the center value is kept as it is. That is, the clearance amounts can be vibrated. It is also allowable to use both DC-method variation and AC-method variation in combination.

Meanwhile, the supply gas pressure P_{S} can be varied also in either the DC method or the AC method. It is noted here that DC-method variation with respect to the gas pressure P_{S} means varying the level of the gas pressure P_{S}, while the AC-method variation means varying the amplitude of the gas pressure with an arbitrarily set specified frequency. The frequency may be set, for example, to several Hz or the like. Varying the gas pressure P_{S} in the DC method allows a center value of the clearance amounts to be varied. That is, the center value of the clearance amounts can be varied depending on the level of a gas pressure P_{S}. Varying the gas pressure P_{S} in the AC method allows the clearance amounts to be periodically increased or decreased about the center value of the clearance amounts while the center value is kept as it is. That is, the clearance amounts can be vibrated. It is also allowable to use both DC-method variation and AC-method variation in combination.

In this case, variations in the clearance amounts by variations in the supply gas pressure P_{S} allows a large thrust force to be obtained while the response speed is low. That is, large variations in the thrust force can be obtained. On the other hand, varying the clearance amounts by varying the exciting current does not allow so large a thrust force to be obtained, while a higher-speed response speed can be obtained. it is also allowable to use the variation of the supply gas pressure P_{S} and the variation of the exciting current in combination.

Figs. 63 to 65 are views showing examples which allows the use as intermediate movers 4030 described in Fig. 62. The intermediate movers 4030 may be disc-shaped intermediate movers 4100 each having flat-plate both-side surfaces. Each of these disc-shaped intermediate movers 4100 has, at a central portion thereof, an aperture 4102 that allows a gas flow therethrough. This aperture 4102 can be formed as a through hole. A depression 4104 is provided around the aperture 4102. The depression 4104 can be formed as an annular dig having a shallow depth. This depression 4104 has a throttling function effected when the gas flows from the aperture 4102 along the flat-plate surface of the flat plate toward the outer circumferential side. As a result of this, the gas is allowed to smoothly flow from the aperture 4102 along the flat-plate surface of the flat plate toward the outer circumferential side.

The intermediate mover 4100, which has a disc-shaped external shape, has in its outer peripheral portion, detent portions 4110, 4112. In correspondence to these detent portions 4110, 4112, detent shapes are provided in the cylindrical portion 4016 of the guide portion 4012 described in Fig. 62. Then, by their cooperating actions, the intermediate mover 4100 is prevented from rotating about its center axis without using any means such as the support shaft.

In an example of dimensions of such an intermediate mover 4100, the outer diameter is about 30 mm to about 40 mm, the inner diameter forming the aperture 4102 that allows gas to flow therethrough is about 10 mm to 15 mm, the plate thickness is about 0.1 mm to about 0.2 mm or so, and the depth of the depression 4104 is about 13 µm to about 17 µm or so. In addition, whereas the detent portions 4110, 4112 are shown in Fig. 63 by shapes resulting from linearly cutting out two places on the outer circumference each by a proper length, the number of of detent portions may be other than two. Also, simply, the intermediate mover 4100 may be formed into a polygonal, square, rectangular, elliptical or other planar shape. In this case, the guide portion 4012 in Fig. 62 should also be formed so as to have corresponding detent shapes. It is noted that Fig. 63 gives a depiction exaggeratedly enlarged in the plate thickness direction. Such an annular flat plate 4100 can be obtained by manifacture processing a metal disc of SUS or the like as an example.

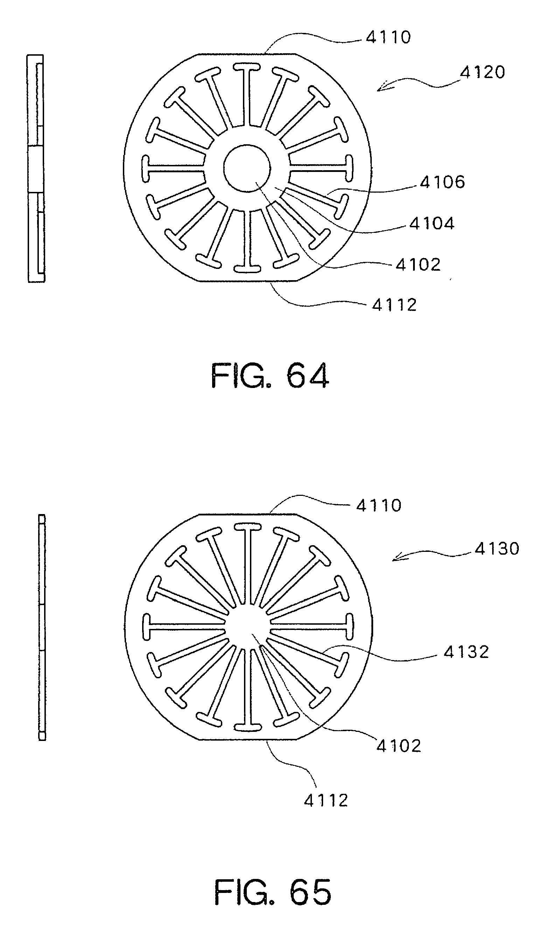

Fig. 64 is a view showing another embodiment of the intermediate mover 4030 in Fig. 62. This intermediate mover 4120 is an intermediate movers in which a plurality of narrow grooves radially extending from the center are additionally provided in the intermediate mover 4100 described in Fig. 63. Like component members in conjunction with Fig. 63 are designated by the same reference numerals and their detailed description is omitted. The narrow grooves 4106 may be provided on a one-side surface or both-side surfaces of the flat-plate plane of the intermediate mover 4120. Also, the narrow grooves 4106 each extend radially from the depression 4104 as a start point toward the outer circumferential side to a specified length, where a fore end portion of the narrow groove is broadened circumferentially on both sides to such an extent as not to adjoin the circumferential breadths of its neighboring narrow grooves 4106. The shape of the surface restrictor By the narrow grooves 4106 is only an example and may be a surface restrictor having other proper shapes.

Such narrow grooves 4106 are so provided as to produce a throttling effect when the gas flows radially along the flat-plate surface of the intermediate mover 4120. That is, with the flat-plate surface of the intermediate mover 4120 opposed to another surface, the gas flows through the clearance between the two surfaces, where when the gas flowing through the narrow grooves 4106 overflows on the flat-plate surface at terminal ends of the narrow grooves 4106 or the like, the flow passage is narrowed so as to make the gas restricted, thus serving as a so-called slit restrictor. By this surface throttling effect, the flow between the two surfaces is stabilized, so that the clearance amount between the two surfaces is also stabilized.

Example of dimensions of such an intermediate mover 4120 includes, in addition to the dimensional example of the intermediate mover 4100 described in Fig. 63, a case of narrow grooves 4106 having a width of about 0.2 mm and a depth equal to the depth of the depression 4104. It is noted that the depth of the narrow grooves 4106 may be different from that of the depression 4104. Also, detent portions 4110, 4112 similar to those of Fig. 63 are provided. As in the case described in Fig. 63, the number of the detent portions may be any arbitrary one, and the intermediate mover 4120 may simply be formed into a polygonal, square, rectangular, elliptical or other planar shape. In this case, of course, the guide portion 4012 in Fig. 62 should also be formed so as to have corresponding detent shapes. It is noted that Fig. 64 gives a depiction exaggeratedly enlarged in the plate thickness direction as in Fig. 63. Such an annular flat plate 4120 can be obtained by manifacture processing a metal disc of SUS or the like as an example.

In addition, also in the intermediate mover 4120, detent portions 4110, 4112 are provided on the outer peripheral portion as described in Fig. 63.

Fig. 65 is a view showing yet another example of an intermediate mover 4030 of Fig. 62. Hereinbelow, like component members in conjunction with Figs. 63 and 64 are designated by the same reference numerals and their detailed description is omitted. Although this intermediate mover 4130 is similar to the intermediate mover 4120 described in Fig. 64, yet the narrow grooves 4106 in Fig. 64 are bottomed grooves provided in a flat-plate surface whereas narrow grooves 4132 corresponding thereto in the intermediate mover 4130 are grooves that run from top to bottom of the flat plate, i.e. slit grooves, unlike the intermediate mover 4120. That is, the narrow grooves 4132, like the narrow grooves 4106 of Fig. 64, each extend radially from the aperture 4102 as a start point to a specified length, where a fore end portion of the narrow groove is broadened circumferentially on both sides to such an extent as not to adjoin the circumferential breadths of its neighboring narrow grooves 4132. Thus, the narrow grooves 4132 are ended grooves which are formed through the thin-plate intermediate mover 4030 in its plate thickness direction, i.e., to pass through the thin plate from its top to bottom. These narrow grooves 4132 are not merely openings but flow passages having proper flow resistance to the gas while the gas flows therethrough.

In an example of dimensions of such an intermediate mover 4130, the outer diameter and aperture size may be the same as those of the intermediate movers 4100, 4120 of Figs. 63 and 64, the plate thickness may be about 0.01 mm to about 0.05 mm or so, and the width of the narrow groove 4132 may be about 0.01 mm to about 0.3 mm or so. Further, detent portions 4110, 4112 similar to those of Fig. 63 are provided. As in the case described in Fig. 63, the number of the detent portions may be any arbitrary one, and the intermediate mover 4130 may simply be formed into a polygonal, square, rectangular, elliptical or other planar shape. In this case, of course, the guide portion 4012 in Fig. 62 should also be formed so as to have corresponding detent shapes. It is noted that Fig. 65 gives a depiction exaggeratedly enlarged in the plate thickness direction as in Figs. 63 and 64. Such an intermediate mover 4130 can be obtained by manifacture processing a metal disc of SUS or the like as an example.

The plurality of intermediate movers 4030 in Fig. 62 may be in the following three modes with the use of the above-described three types of intermediate movers 4100, 4120, 4130. A first mode is that the intermediate mover 4100 having no narrow groove is used for all the intermediate movers. A second mode is that the intermediate mover 4120 having the narrow grooves 4106 being bottomed to the flat plate is used for all the intermediate movers.

A third mode is that the intermediate mover 4130 having the narrow grooves 4132, which are through grooves running from top to bottom of the flat plate, and the intermediate mover 4100 having no narrow grooves, are alternately placed. In this case, the intermediate movers 4130 should be placed at both ends. The reason of this is that in Fig. 62, it is the fore end portion of the output mover 4020 having no narrow grooves and the bottom face portion 4014 of the guide portion 4012 which confront both-end intermediate movers out of the plurality of intermediate movers 4030, respectively. For example, given that the plurality of intermediate movers 4030 in Fig. 62 are composed of eleven intermediate movers, six intermediate movers 4130 and five intermediate movers 4100 are used, the placement being such that each one intermediate mover 4100 is interposed between two intermediate movers 4130.

Reverting again to Fig. 62, functions of the gas pressure control actuator 4010 structured as described above are explained. As described above, with a proper exciting current supplied to the magnetic-field generation coil 4040, a magnetic field is generated and a controlled supply gas pressure P_{S} is supplied. Then, by the pushing force F derived from the object, the gas is compressed in the clearances between adjacent intermediate movers 4030 and the like, while the intermediate movers 4030 and the output mover 4020 are pushed against the bottom face portion 4014. Then, controlling the level of the supply gas pressure P_{S} allows the amounts of the individual clearances to be adjusted while being balanced with the pushing force F, by which the output mover 4020 can be minutely moved.

During this process, the intermediate movers 4030 keep levitated in a so-to-speak contactless state with any other member by virtue of the gas flowing through the individual clearances. Accordingly, whereas the intermediate movers, as they are, might slide in the radial direction so as to be shifted in position, the intermediate movers 4030 are automatically aligned to their center axis by the restricting force of the magnetic field generated by the magnetic-field generation coil 4040. Furthermore, although the intermediate movers 4030, as they are, might rotate around the axial direction, their rotations about the axial direction are suppressed by cooperation of the detent portions 4110, 4112 of the intermediate movers 4030 and their corresponding detent shapes of the guide portion 4012. Thus, a plurality of intermediate movers 4030 can be arrayed and supported in a fluidic manner without using the support shaft.

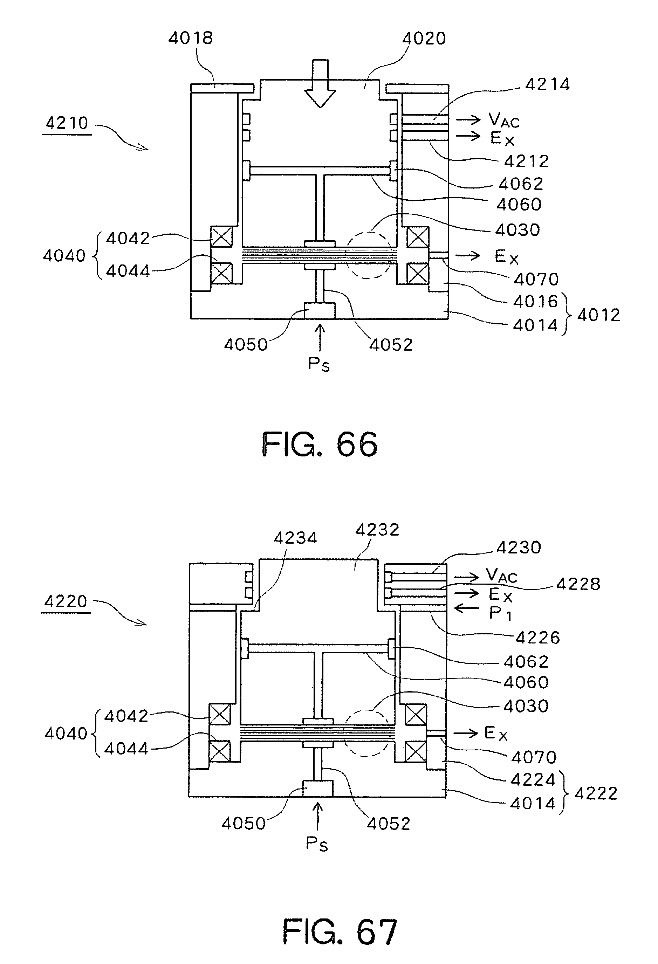

Figs. 66 to 68 are views showing examples of gas pressure control actuators having other structures. In these figures, like component members in conjunction with Fig. 62 are designated by the same reference numerals and their detailed description is omitted.

Fig. 66 is a view showing an example in which an exhaust port 4212 and a vacuum port 4214 as one pair are provided in the cylindrical portion 4016 of the guide portion 4012 for usability even in a vacuum or the like. These exhaust port 4212 and vacuum port 4214 are provided on one side closer to the forward opening of the guide portion 4012 than the jet opening 4062 provided at the cylindrical outer peripheral portion of the output mover 4020 described in Fig. 62. As a result, the gas flowing out from the jet opening 4062 is collected by the exhaust port 4212 and the vacuum port 4214, thus leakage of the gas to outside being suppressed. Thus, the gas pressure control actuator 4210 becomes usable even under a reduced-pressure atmosphere or vacuum atmosphere.

Fig. 67 shows a structure of a gas pressure control actuator 4220 in which the output mover is enabled to generate the pushing force by itself. Fig. 62 has been explained on the basis that a reaction force derived from the object is used as the pushing force generation means for pushing the intermediate movers 4030 and the output mover 4020 against the bottom face portion 4014 of the guide portion 4012. Other pushing force generation means may include the dead weight of the output mover 4020. In this case, however, there is a need for placing the output mover 4020 of the gas pressure control actuator 4010 upward of the bottom face portion 4014 along the gravitational direction, incurring restraints on the placement conditions or working posture.

In the gas pressure control actuator 4220 of Fig. 67, the output mover 4232 is provided with a shoulder portion 4234, to which portion the gas having a gas pressure P₁ is supplied from outside via a supply port 4226. Properly setting the control gas pressure P₁ allows the output mover 4232 to be pushed toward the bottom face portion 4014 with a proper pushing force. As a result, laminations on the placement conductions or working posture of the gas pressure control actuator 4220 can be eliminated. In addition, an exhaust port 4228 and a vacuum port 4230 are provided on one side closer to the opening of the guide portion 4012 than the supply port 4226, so that the gas having been used for the generation of pushing force is collected.

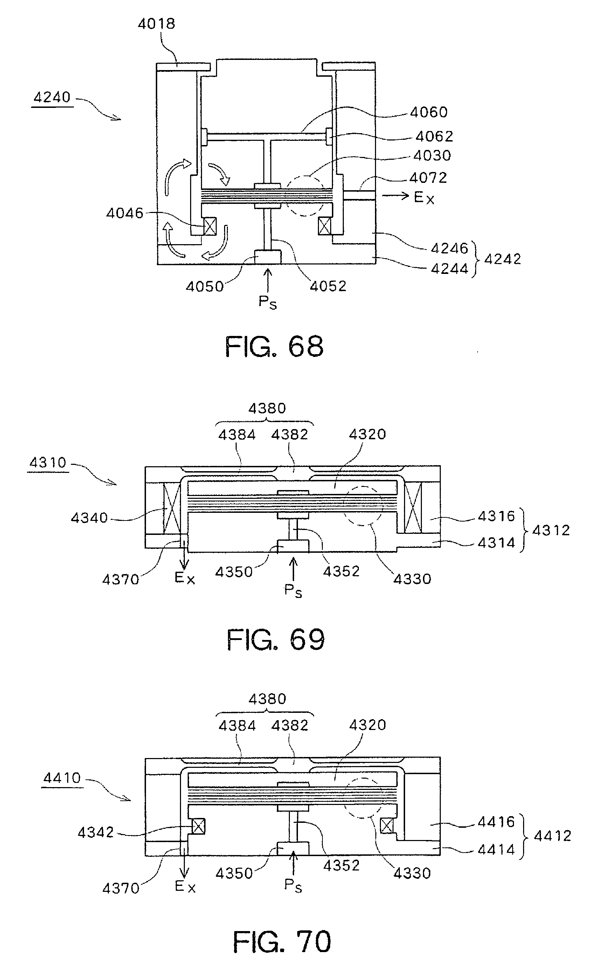

Fig. 68 shows an example of another placement of the magnetic-field generation coil. In the gas pressure control actuator 4240 of Fig. 68, a magnetic-field generation coil 4046 is provided at the bottom face portion 4244 of a guide portion 4242. In this case also, as indicated by circulating hollow arrows in Fig. 68, a magnetic field that makes the intermediate movers 4030 aligned along their center axis can be generated.

Figs. 69 to 71 are views showing several examples in which the structure of the gas pressure control actuator having the above-described magnetic-field generation coil is applied to a minute displacement output device. In the following description, like component members in conjunction with Fig. 62 are designated by the same reference numerals and their detailed description is omitted.

Referring to Fig. 69, the minute displacement output device 4310 is a device which includes a casing portion 4312 and a cover portion 4380 for covering a top face of the casing portion 4312, and which has a plano-cylindrical external shape. Contained in an internal space surrounded by the casing portion 4312 and the cover portion 4380 are a plurality of intermediate movers 4330 and an output mover 4320 confronting a fore-end side intermediate mover out of the plurality of intermediate movers 4330. Further, a magnetic-field generation coil 4340 is provided in the casing portion 4312.

Functions and contents of the output mover 4320, the plurality of intermediate movers 4330 and the magnetic-field generation coil 4340 are similar to those of the output mover 4020, the plurality of intermediate movers 4330 and the magnetic-field generation coil 4040 described in Fig. 62.

In this case, the casing portion 4312 includes a bottom face portion 4314 and a cylindrical portion 4316 having a forward opening, and is formed of SUS, which is a magnetic material. Further, the output mover 4320 and the plurality of intermediate movers 4330 are formed also of magnetic material. In addition, the magnetic-field generation coil 4340 is provided at the cylindrical portion 4316 of the casing portion 4312.

In the bottom face portion 4314 of the casing portion 4312, a supply port 4350 to which a controlled gas pressure PS is supplied is provided, and the gas is supplied preferably via a proper restrictor portion and through a gas supply passage 4352 to the plurality of intermediate movers 4330. The supplied gas flows through a clearance between the fore-end surface of the output mover 4320 and a one-side flat-plate surface of an intermediate mover 4330 confronting the fore-end surface, clearances between adjacent intermediate movers 4330, and a clearance between the bottom face portion 4314 of the casing portion 4312 and the other-side flat-plate surface of the intermediate mover 4330 confronting bottom face portion, so as to be discharged outside through an exhaust port 4370. Accordingly, the supply port 4350, the gas supply passage 4352 and the exhaust port 4370 correspond the gas supply means for supplying gas to those clearances.

The cover portion 4380 is a member that covers the forward opening of the casing portion 4312. The cover portion 4380 has a transfer portion 4382 in contact with a central portion of the output mover 4320, and an elastic member 4384 for connecting the cylindrical portion 4316 of the casing portion 4312 and the transfer portion 4382 to each other. As a result, the cover portion 4380 has functions of giving a pushing force to the output mover 4320 in integration with the casing portion 4312 and moreover transferring an output of the output mover 4320 to outside.

The minute displacement output device 4310 structured as described above corresponds to a device in which the cover portion 4380 having the elastic member 4384 an as a generation mechanism for the pushing force F is employed in the gas pressure control actuator 4010 described in Fig. 62. Therefore, as in the case described on the functions of the gas pressure control actuator 4010, controlling the level of the supply gas pressure P_{S} allows the amounts of the individual clearances between the intermediate movers 4030 and the like to be adjusted while being balanced with the pushing force given by the cover portion 4380, by which the output mover 4320 can be minutely moved.

Also, the intermediate movers 4330 are automatically aligned to their center axis by the restricting force of the magnetic field generated by the magnetic-field generation coil 4340. Furthermore, since detent portions are provided in the individual intermediate movers 4330 while detent portions are correspondingly provided also in the casing portion 4312, rotations of the intermediate movers 4030 about the axial direction are suppressed by cooperation of those detent portions. Thus, a plurality of intermediate movers 4330 can be arrayed and supported in a fluidic manner without using the support shaft.

Fig. 70 is a view showing another example of placement of the magnetic-field generation coil. In the following description, like component members in conjunction with Fig. 69 are designated by the same reference numerals and their detailed description is omitted. In the gas pressure control actuator 4410 of Fig. 70, a magnetic-field generation coil 4342 is provided in a bottom face portion 4414 of a guide portion 4412. In this case also, a magnetic field that causes the intermediate movers 4330 to be aligned with their center axis can be generated.

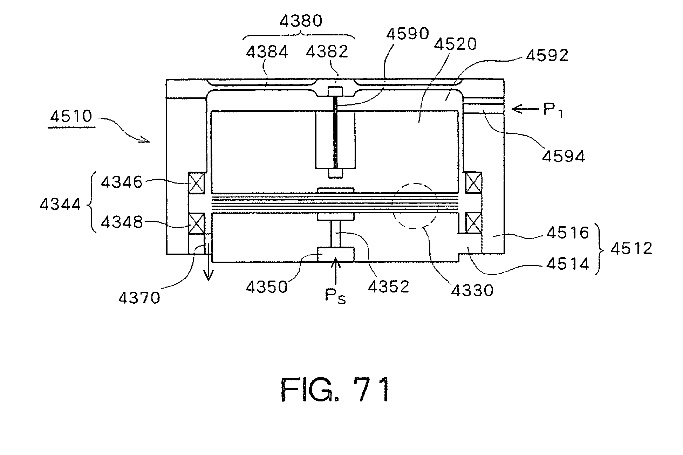

Fig. 71 is a view showing an example of a minute displacement output device 4510 which is so structured that contact of an object with the minute displacement output device does not cause any excessive shock on the device. In the following description, like component members in conjunction with Figs. 69 and 70 are designated by the same reference numerals and their detailed description is omitted.

In the minute displacement output device 4510 of Fig. 71, an output mover 4520 is connected to the transfer portion 4382 of the cover portion 4380 by means of a connecting bar 4590, instead of making direct plane contact therewith, so that a shock absorbing chamber 4592 is provided between the output mover 4520 and the cover portion 4380. A gas pressure P₁ is supplied to the shock absorbing chamber 4592 via a supply port 4594 from outside. The rest of the structure is the same with Fig. 69, including a magnetic-field generation coil 4344 and the like. By this shock absorbing chamber 4592, even if an object has come into contact with a transfer portion 3482, a resulting contact shock is not directly transferred to the output mover 4520 and a plurality of intermediate movers 4330 forward thereof, but absorbed and transferred thereto.

As described above, the intermediate movers 4330 are extremely thin in thickness, and the clearance amounts between adjacent intermediate movers 4330 are also extremely minute ones. Therefore, the intermediate movers 4330 might be subject to damage due to excessive shocks. Providing the shock absorbing chamber 4592 allows those excessive shocks to be relaxed. Even in the minute displacement output device 4510 having such a structure as described above, the intermediate movers 4330 can be automatically aligned to their center axis by the provision of the magnetic-field generation coil 4340.

### [INDUSTRIAL APPLICABILITY]

The gas pressure control actuator is usable as an actuator for tables of XYθ moving mechanisms as well as an actuator for six-degree-of-freedom parallel link mechanisms as described above, and moreover usable as an actuator for XYZ stages, an actuator for acceleration cancelers, an actuator for vibration isolators, an actuator for vibration-free devices, and the like. The minute displacement output device using the gas pressure control actuator is usable as a minute movement mechanism.

## Claims

1. A gas pressure control actuator (90) comprising:
a plurality of flat-plate movers (20) which are placed in an array along an axial direction of a support shaft (22), each of the plurality of flat-plate movers (20) being supported, with a flat-plate surface thereof vertical to the support shaft(22), by the support shaft (22) via a support member which has an aperture (54) that allows gas to flow therethrough and which is lower in displacement rigidity in the axial direction of the support shaft (22) than in its radial direction;
a cylindrical guide portion (52) to a bottom face of which the support shaft (22) is attached and which is opened on one side closer to a fore-end side of the support shaft (22), the guide portion (52) serving for guiding the plurality of flat-plate movers (20); and
gas supply means which is provided on a bottom face side of the guide portion (52),
**characterized in that**
said gas supply means supplies and guides gas to a clearance between a one-side flat-plate surface of a flat-plate mover (20) confronting the bottom face of the guide portion (52) and the bottom face of the guide portion (52), to clearances between adjacent flat-plate movers (20), and to a clearance between the other-side flat-plate surface of a fore-end side flat-plate mover (20) confronting a drive object (6) and a gas-receiving surface of the drive object (6) confronting the flat-plate surface, wherein the fore-end side flat-plate mover (20) exerts driving force on the drive object (6) via a gas layer.

2. The gas pressure control actuator (90) as claimed in Claim 1, wherein
the support member is
a thin-plate spring (26) having cloud-like-curved-shaped flexible arms for connecting an inner-diameter side portion of the flat-plate mover (20) and the support shaft (22) to each other.

3. The gas pressure control actuator as claimed in Claim 1 or 2, wherein
a support portion between the flat-plate mover (20) and the support shaft (22) is slidable in the axial direction.

4. The gas pressure control actuator as claimed in any one of Claims 1 to 3, wherein
the gas supply means has
a gas supply port (54) which is opened toward the flat-plate mover (20), and
a gas restrictor portion (56) which is provided at the gas supply port (54) and which rectifies the flow of supplied gas.

## Patentansprüche

1. Gasdrucksteuerstellglied (90), aufweisend:
- eine Vielzahl von Flachplattenbewegungselementen (20), die in einer Anordnung entlang einer axialen Richtung einer Tragwelle (22) angeordnet sind, wobei jeder der Vielzahl von Flachplattenbewegungselementen (20) mit einer Flachplattenfläche von diesem über ein Tragelement von der Tragwelle (22) vertikal zur Tragwelle (22) getragen wird, wobei das Tragelement eine Öffnung (54) aufweist, die den Durchfluss von Gas durch diese erlaubt und in der axialen Richtung der Tragwelle (22) eine geringere Verschiebungssteifheit aufweist als in deren radialer Richtung;
- einen zylindrischen Führungsabschnitt (52), wobei an einer Unterseite von diesem die Tragwelle (22) angebracht ist und der an einer einer Frontseite der Tragwelle (22) näher gelegenen Seite geöffnet ist, wobei der Führungsabschnitt (52) zum Führen der Vielzahl von Flachplattenbewegungselementen (20) dient; und
- ein Gaszufuhrmittel, das auf einer Unterseite des Führungsabschnitts (52) vorgesehen ist,
**dadurch gekennzeichnet, dass**
das Gaszufuhrmittel in einen Zwischenraum zwischen einer Seite der Flachplattenfläche eines Flachplattenbewegungselements (20), die der Unterseite des Führungsabschnitts (52) gegenüberliegt, und der Unterseite des Führungsabschnitts (52), in Zwischenräume zwischen angrenzenden Flachplattenbewegungselementen (20) und in einen Zwischenraum zwischen der anderen Seite der Flachplattenfläche einer Frontseite eines Flachplattenbewegungselements (20), die einem Antriebsobjekt (6) gegenüberliegt, und einer das Gas aufnehmenden Oberfläche des Antriebsobjekts (6), das der Flachplattenfläche gegenüberliegt, Gas zuführt und leitet, wobei die Frontseite des Flachplattenbewegungselements(20) über eine Gasschicht eine Antriebskraft auf das Antriebsobjekt (6) ausübt.

2. Gasdrucksteuerstellglied (90) nach Anspruch 1, wobei
das Tragelement
eine dünnplattige Feder (26) ist, die wolkenartig gebogene flexible Arme zur Verbindung eines Abschnitts des Flachplattenbewegungselements (20) auf der inneren Durchmesserseite und der Tragwelle (22) miteinander aufweist.

3. Gasdrucksteuerstellglied nach Anspruch 1 oder 2, wobei ein Tragabschnitt zwischen dem Flachplattenbewegungselement (20) und der Tragwelle (22) in axialer Richtung verschiebbar ist.

4. Gasdrucksteuerstellglied nach einem der Ansprüche 1 bis 3, wobei
das Gaszufuhrmittel
einen Gaszufuhranschluss (54), der zum Flachplattenbewegungselement (20) hin geöffnet ist, und
einen Gasbegrenzungsabschnitt (56) aufweist, der an dem Gaszufuhranschluss (54) vorgesehen ist und den Fluss des zugeführten Gases verbessert.

## Revendications

1. Actionneur de commande de pression de gaz (90) comprenant:
- une pluralité d'organes de déplacement à plaque plate (20) qui sont placés dans un arrangement le long d'une direction axiale d'un arbre de support (22), chacun de la pluralité d'organes de déplacement à plaque plate (20) étant supporté, avec une surface de plaque plate de ceux-ci vertical à l'arbre de support (22), par l'arbre de support (22) par l'intermédiaire d'un élément de support qui comporte une ouverture (54) qui permet à du gaz de s'écouler à travers celle-ci et qui a une rigidité de déplacement inférieure dans la direction axiale de l'arbre de support (22) que dans sa direction radiale;
- une partie de guidage cylindrique (52), à une face inférieure de laquelle l'arbre de support (22) est fixé, et qui est ouverte sur un côté plus proche d'un côté d'extrémité avant de l'arbre de support (22), la partie de guidage (52) servant à guider la pluralité d'organes de déplacement à plaque plate (20); et
- un moyen d'alimentation en gaz qui est prévu sur un côté de face inférieure de la partie de guidage (52),
**caractérisé en ce que**
ledit moyen d'alimentation en gaz fournit et guide un gaz dans un espace libre entre une surface de plaque plate d'un côté d'un organe de déplacement à plaque plate (20) face à la face inférieure de la partie de guidage (52) et la face inférieure de la partie de guidage (52), dans des espaces libres entre des organes de déplacement à plaque plate adjacents (20), et dans un espace libre entre la surface de plaque plate d'un autre côté d'un organe de déplacement à plaque plate de côté d'extrémité avant (20) face à un objet d'entraînement (6) et une surface de réception de gaz de l'objet d'entraînement (6) face à la surface de plaque plate, dans lequel l'organe de déplacement à plaque plate de côté d'extrémité avant (20) exerce une force d'entraînement sur l'objet d'entraînement (6) par l'intermédiaire d'une couche de gaz.

2. Actionneur de commande de pression de gaz (90) selon la revendication 1, dans lequel
l'élément de support est
un ressort à plaque mince (26) ayant des bras souples de forme incurvée de type nuage pour relier une partie de côté de diamètre intérieur de l'organe de déplacement à plaque plate (20) et l'arbre de support (22) l'un à l'autre.

3. Actionneur de commande de pression de gaz selon la revendication 1 ou 2, dans lequel
une partie de support entre l'organe de déplacement à plaque plate (20) et l'arbre de support (22) peut coulisser dans la direction axiale.

4. Actionneur de commande de pression de gaz selon l'une quelconque des revendications 1 à 3, dans lequel
le moyen d'alimentation en gaz comporte
un port d'alimentation en gaz (54) qui est ouvert vers l'organe de déplacement à plaque plate (20), et
une partie d'étranglement de gaz (56) qui est prévue au niveau du port d'alimentation en gaz (54) et qui rectifie le débit de gaz fourni.
